(19) Europäisches Patentamt
European Patent Office
Office européen des brevets

(11) **EP 4 210 089 A1**

(12) **EUROPEAN PATENT APPLICATION**
published in accordance with Art. 153(4) EPC


(43) Date of publication:
**12.07.2023 Bulletin 2023/28**

(21) Application number: **21864370.8**

(22) Date of filing: **01.09.2021**

(51) International Patent Classification (IPC):
***H01L 21/3065*** (2006.01) ***G03F 7/11*** (2006.01)
***G03F 7/40*** (2006.01) ***H01L 21/304*** (2006.01)
***H01L 51/48*** (2006.01) ***H01L 51/50*** (2006.01)
***H05B 33/10*** (2006.01)

(52) Cooperative Patent Classification (CPC):
**G03F 7/11; G03F 7/40; H01L 21/304; H01L 21/3065; H05B 33/10; H10K 50/00; H10K 71/00;** Y02E 10/549

(86) International application number:
**PCT/JP2021/032133**

(87) International publication number:
**WO 2022/050313 (10.03.2022 Gazette 2022/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **04.09.2020 JP 2020148769**



(71) Applicant: **FUJIFILM Corporation**
**Tokyo 106-8620 (JP)**

(72) Inventors:
- **TAKAKUWA, Hideki**
  **Haibara-gun, Shizuoka 421-0396 (JP)**
- **YOSHIBAYASHI, Mitsuji**
  **Haibara-gun, Shizuoka 421-0396 (JP)**

(74) Representative: **HGF**
**HGF Limited**
**1 City Walk**
**Leeds LS11 9DX (GB)**


(54) **METHOD FOR MANUFACTURING ORGANIC LAYER PATTERN, AND METHOD FOR MANUFACTURING SEMICONDUCTOR DEVICE**


(57) There is provided a manufacturing method for an organic layer pattern, including a step of forming an interlayer that dissolves in water or a water-soluble solvent and a resist layer in this order on an organic layer to obtain a laminate, a step of producing a pattern of the resist layer, a step of carrying out etching of the organic layer using the pattern of the resist layer as a mask, a step of carrying out insolubilization of a surface of the interlayer with respect to water or a water-soluble solvent, after the etching, and a step of carrying out washing of the laminate after the step of carrying out the insolubilization, with water or a water-soluble solvent. In addition, there is also provided a manufacturing method for a semiconductor device.


FIG. 1A

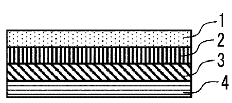


FIG. 1B

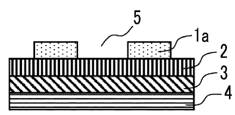


FIG. 1C

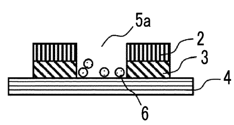


FIG. 1D

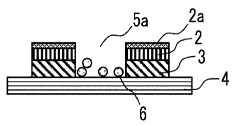


FIG. 1E

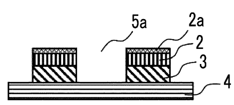


FIG. 1F

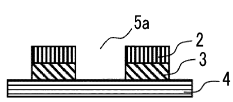


EP 4 210 089 A1

## Description

## BACKGROUND OF THE INVENTION

1. Field of the Invention

The present invention relates to a manufacturing method for an organic layer pattern and a manufacturing method for a semiconductor device.

2. Description of the Related Art

In recent years, a device using a patterned organic layer (an organic layer pattern), such as a semiconductor device using an organic semiconductor, has been widely used.

For example, an organic semiconductor device has the advantage that it can be manufactured by a simple process as compared with an electronic device in the related art using an inorganic semiconductor such as silicon. Furthermore, the material characteristics of the organic semiconductor can be easily changed by changing the molecular structure thereof. In addition, there are abundant variations in materials, and it is conceived that it is possible to realize functions and elements, which could not be achieved by an inorganic semiconductor. The organic semiconductor can be applied to electronic equipment, for example, an organic solar cell, an organic electroluminescence display, an organic optical detector, an organic electric field effect transistor, an organic electric field light emitting element, a gas sensor, an organic rectifying element, an organic inverter, and an information recording element.

It is known that an organic layer pattern of such an organic semiconductor or the like is manufactured by etching using a laminate including an organic layer and a layer such as a photosensitive layer (for example, a resist layer) and using a pattern consisting of a photosensitive layer as a mask.

For example, in WO2015/144930A discloses a method of manufacturing a device including a first pattern-formed device layer at a first position on a substrate and a second pattern-formed device layer at a second position on the substrate, the method characterized by including a step of laminating a first interlayer on the substrate, a step of subjecting the first interlayer to pattern formation in order to remove the first interlayer at the first position, a step of laminating a first device layer, a step of laminating a second interlayer, a step of subjecting the second interlayer and a lower layer thereof to pattern formation in order to remove the second interlayer and the lower layer thereof at the second position, a step of laminating the second device layer, and a step of subjecting the first device layer and the second device layer to pattern formation in order to form a first pattern-formed device layer at a first position and a second pattern-formed device layer at a second position.

## SUMMARY OF THE INVENTION

As described above, in a case where the organic layer pattern is manufactured by etching, an etching residue (for example, a residue of a resist layer, an interlayer, or an organic layer, which is a layer removed by etching, which is a residue having, for example, a particulate shape) may be generated.

An object of the present invention is to provide a manufacturing method for an organic layer pattern and a manufacturing method for an electronic device, in which the generation of an etching residue is suppressed.

Representative aspects according to the present invention are described below.

<1> A manufacturing method for an organic layer pattern, comprising:

- a step of forming an interlayer that dissolves in water or a water-soluble solvent and a resist layer in this order on an organic layer to obtain a laminate;
- a step of producing a pattern of the resist layer;
- a step of carrying out etching of the organic layer using the pattern of the resist layer as a mask;
- a step of carrying out insolubilization of a surface of the interlayer with respect to water or a water-soluble solvent, after the etching; and
- a step of carrying out washing of the laminate after the step of carrying out the insolubilization, with water or a water-soluble solvent.

<2> The manufacturing method for an organic layer pattern according to <1>, further comprising a step of removing the surface of the interlayer, which is insolubilized in the step of carrying out the insolubilization.

<3> The manufacturing method for an organic layer pattern according to <2>, in which the step of removing the surface of the interlayer is a step of carrying out dry etching with an etching gas having an oxygen partial pressure

of 50% to 100% with respect to a total pressure.

<4> The manufacturing method for an organic layer pattern according to any one of <1> to <3>, in which the interlayer contains polyvinyl alcohol.

<5> The manufacturing method for an organic layer pattern according to any one of <1> to <4>, in which the step of carrying out the insolubilization is a step of subjecting the surface of the interlayer to a plasma treatment.

<6> The manufacturing method for an organic layer pattern according to <5>, in which the plasma treatment is carried out with a gas containing Ar.

<7> The manufacturing method for an organic layer pattern according to <6>, in which the plasma treatment is carried out with a gas containing Ar and $N_2$.

<8> The manufacturing method for an organic layer pattern according to <7>, in which a partial pressure of $N_2$ in the gas containing Ar and $N_2$ is 10% to 50% with respect to a total pressure of the gas.

<9> The manufacturing method for an organic layer pattern according to <8>, further comprising a step of removing the interlayer.

<10> The manufacturing method for an organic layer pattern according to any one of <1> to <9>, further comprising:

a step of further forming a second organic layer, after the step of carrying out the washing;
a step of forming a second interlayer that dissolves in water or a water-soluble solvent and a second resist layer in this order on the second organic layer to obtain a laminate;
a step of forming a second pattern of the second resist layer;
a step of carrying out etching of the second organic layer using the second pattern as a mask;
a step of carrying out insolubilization of a surface of the second interlayer with respect to water or a water-soluble solvent, after the etching; and
a step of washing the laminate after the insolubilization, with water or a water-soluble solvent.

<11> A manufacturing method for a semiconductor device, comprising the manufacturing method for an organic layer pattern according to any one of <1> to <10>.

According to the present invention, there are provided a manufacturing method for an organic layer pattern and a manufacturing method for an electronic device, in which the generation of an etching residue is suppressed.

## BRIEF DESCRIPTION OF THE DRAWINGS

Figs. 1A to 1F are a schematic cross-sectional view illustrating an example of a manufacturing method for an organic layer pattern.

Fig. 2 is a schematic cross-sectional view illustrating an example of a base material on which an organic layer pattern of each of a first organic layer, a second organic layer, and a third organic layer is formed.

## DESCRIPTION OF THE PREFERRED EMBODIMENTS

Hereinafter, representative embodiments according to the present invention will be described. Each constitutional element will be described based on these representative embodiments for convenience, but the invention is not limited to such embodiments.

In the present specification, a numerical range described by using "to" means a range including numerical values described before and after the preposition "to" as a lower limit value and an upper limit value, respectively.

In the present specification, the term "step" means not only an independent step but also a step that cannot be clearly distinguished from other steps as long as the desired action of the step can be achieved.

In a case where substitution or non-substitution is not explicitly indicated in the description of a group (an atomic group) in the present specification, the group (the atomic group) is intended to include not only a group (an atomic group) having no substituent but also a group (an atomic group) having a substituent. For example, in a case of being simply described as an "alkyl group", this means the alkyl group includes both an alkyl group (an unsubstituted alkyl group) having no substituent and an alkyl group (a substituted alkyl group) having a substituent. In addition, in a case of simply being described as the "alkyl group", this means that the alkyl group may be chain-like or cyclic, and in the case of being chain-like, it may be linear or branched. The same applies to other groups such as an "alkenyl group", an "alkylene group", and an "alkenylene group".

In the present specification, "exposure" means not only lithography using light but also lithography with particle beams such as electron beams and ion beams, unless otherwise specified. Examples of the energy rays used for

lithography include emission line spectra of mercury lamps, far ultraviolet rays typified by excimer lasers, actinic rays such as extreme ultraviolet rays (EUV light) and X-rays, and particle beams such as electron beams and ion beams.

In the present specification, "light" includes not only light having wavelengths in the regions of ultraviolet, near-ultraviolet, far-ultraviolet, visible, infrared, and the like, and electromagnetic waves, but also radiation, unless otherwise specified. Examples of the radiation include microwaves, electron beams, extreme ultraviolet rays (EUV), and X-rays. In addition, laser light such as a 248 nm excimer laser, a 193 nm excimer laser, and a 172 nm excimer laser can also be used. As this light, monochrome light (single wavelength light) that has passed through an optical filter may be used, or light having a plurality of wavelengths (composite light) may be used.

In the present specification, "(meth)acrylate" means one or both of "acrylate" and "methacrylate", "(meth)acryl" means one or both of "acryl" and "methacryl", and "(meth)acryloyl" means one or both of "acryloyl" and "methacryloyl".

In the present specification, the solid content in a composition means other components excluding the solvent, and the content (the concentration) of the solid content in the composition is indicated by the mass percentage of the other components excluding the solvent with respect to the total mass of the composition, unless otherwise specified.

In the present specification, unless otherwise specified, the temperature is 23°C, the atmospheric pressure is 101,325 Pa (1 atm), and the relative humidity is 50%RH.

In the present specification, weight-average molecular weight (Mw) and number-average molecular weight (Mn) are indicated as polystyrene equivalent values according to gel permeation chromatography (GPC) measurement unless otherwise specified. These weight-average molecular weight (Mw) and number-average molecular weight (Mn) can be determined, for example, by using HLC-8220 (manufactured by Tosoh Corporation), and using a guard column HZ-L, TSKgel Super HZM-M, TSKgel Super HZ4000, TSKgel Super HZ3000, and TSKgel Super HZ2000 (all manufactured by Tosoh Corporation) as columns. In addition, unless otherwise described, measurement is carried out using tetrahydrofuran (THF) as an eluent. In addition, unless otherwise described, detection is carried out using a detector for a UV ray (an ultraviolet ray) of a wavelength 254 nm in GPC measurement.

In the present specification, in a case where the positional relationship of respective layers constituting the laminate is described as "upper" or "lower", another layer may be on the upper side or the lower side of the reference layer among the plurality of layers of interest. That is, a third layer or element may be further interposed between the reference layer and the other layer, and the reference layer and the other layer need not be in contact with each other. In addition, unless otherwise specified, the direction in which the layers are laminated on the base material is referred to as "upward", or in a case where a resist layer is present, the direction from the base material to the resist layer is referred to as "upper". The opposite direction thereof is referred to as "downward". It is noted that such a setting of the upward or downward direction is for convenience in the present specification, and in an actual aspect, the "upward" direction in the present specification may be different from the vertically upward direction.

(Manufacturing method for organic layer pattern)

A manufacturing method for an organic layer pattern according to the embodiment of the present invention includes a step of forming an interlayer that dissolves in water or a water-soluble solvent and a resist layer in this order on an organic layer to obtain a laminate; a step of producing a pattern of the resist layer; a step of carrying out etching of the organic layer using the pattern of the resist layer as a mask; a step of carrying out insolubilization of a surface of the interlayer with respect to water or a water-soluble solvent, after the etching; and a step of carrying out washing of the laminate after the step of carrying out the insolubilization, with water or a water-soluble solvent.

In the related art, it has been known that patterning of an organic layer such as an organic semiconductor is carried out using a laminate including an organic layer, an interlayer, and a resist layer.

Specifically, in the above patterning, a method in which a resist layer is patterned to form a pattern, and then etching is carried out using the pattern of the resist layer as a mask to remove an interlayer after the etching has been carried out in the related art.

By the way, it was found that due to the etching, an etching residue (for example, a residue of a resist layer, an interlayer, or an organic layer, which is a residue having, for example, a particulate shape) is generated.

As a result of diligent studies, the inventors of the present invention found that in a case of carrying out, after the etching, a step of carrying out insolubilization of a surface of the interlayer with respect to water or a water-soluble solvent and a step of washing the laminate after the step of carrying out the insolubilization, with water or a water-soluble solvent, the etching residue can be removed.

Although the mechanism by which the above effect is obtained is unknown, it is presumed that the etching residue is effectively removed by washing the laminate with water or a water-soluble solvent.

In addition, since an insolubilized interlayer remains in the laminate at the time of this washing, it is conceived that the damage to the organic layer due to the washing is also reduced.

However, WO2015/144930A does not describe the step of carrying out the insolubilization and the step of carrying out the washing.

<Step of obtaining laminate>

The manufacturing method for an organic layer pattern according to the embodiment of the present invention includes a step of forming an interlayer that dissolves in water or a water-soluble solvent and a resist layer in this order on an organic layer to obtain a laminate (simply, also referred to as "a step of obtaining a laminate").

[Organic layer]

The organic layer is a layer containing an organic material. A specific organic material is appropriately selected depending on the use application and the function of the organic layer. Examples of the assumable function of the organic layer include semiconductor characteristics, light emission characteristics, photoelectric conversion characteristics, light absorption characteristics, electrical insulating properties, ferroelectricity, transparency, and insulating properties. In a case where the laminate includes a base material, it suffices that in the laminate, the organic layer is included above the base material, where the base material may be in contact with the organic layer, or another layer may be further included between the organic layer and the base material.

The thickness of the organic layer is not particularly limited and varies depending on the kind or the like of the electronic device to be used; however, it is preferably 1 nm to 50 μm, more preferably 1 nm to 5 μm, and still more preferably 1 nm to 500 nm.

In particular, an example in which the organic layer is an organic semiconductor layer will be described in detail below. The organic semiconductor layer is a layer including an organic material exhibiting characteristics of a semiconductor.

The organic semiconductor layer is an organic layer containing an organic semiconductor, and the organic semiconductor is an organic compound exhibiting characteristics of a semiconductor. Similar to a case of a semiconductor consisting of an inorganic compound, the organic semiconductor includes a p-type semiconductor that conducts holes (positive holes) as carriers and an n-type semiconductor that conducts electrons as carriers. The ease of flow of carriers in the organic semiconductor layer is represented by the carrier mobility μ. Depending on the use application, it is generally better that the carrier mobility is higher, which is preferably $10^{-7}$ $cm^2/Vs$ or more, more preferably $10^{-6}$ $cm^2/Vs$ or more, and still more preferably $10^{-5}$ $cm^2/Vs$ or more. The carrier mobility can be determined based on the characteristics obtained in a case where an electric field effect transistor (FET) element is manufactured or the measured value by the time of flight (TOF) measurement method.

As the p-type organic semiconductor that can be used for the organic semiconductor layer, any material may be used as long as it is a material having a hole transport property. The p-type organic semiconductor is preferably any one of a p-type π-conjugated polymer, a fused polycyclic compound, a triarylamine compound, a hetero 5-membered ring compound, a phthalocyanine compound, a porphyrin compound, a carbon nanotube, or graphene. In addition, a plurality of kinds of compounds among these compounds may be used in combination as the p-type organic semiconductor. The p-type organic semiconductor is more preferably at least one kind of a p-type π-conjugated polymer, a fused polycyclic compound, a triarylamine compound, a hetero 5-membered ring compound, a phthalocyanine compound, or a porphyrin compound, and still more preferably at least one kind of a p-type π-conjugated polymer or a fused polycyclic compound.

The p-type π-conjugated polymer is, for example, a substituted or unsubstituted polythiophene (for example, poly(3-hexylthiophene) (P3HT, manufactured by Sigma-Aldrich Japan)), polyselenophene, polypyrrole, polyparaphenylene, polyparaphenylene vinylene, polythiophene vinylene, and polyaniline. The fused polycyclic compound is, for example, a substituted or unsubstituted anthracene, tetracene, pentacene, anthradithiophene, and hexab enzocoronene.

Examples of the triarylamine compound include m-MTDATA (4,4',4"-tris[(3-methylphenyl)phenylamino]triphenylamine), 2-TNATA (4,4',4"-tris[2-naphthyl(phenyl) amino]triphenylamine), NPD (N,N'-di(1-naphthyl)-N,N'-diphenyl-(1,1'-biphenyl)-4,4'-diamine), TPD (N,N'-diphenyl-N,N'-di(m-tolyl)benzidine), mCP (1,3-bis(9-carbazolyl)benzene), and CBP (4,4'-bis(9-carbazolyl)-2,2'-biphenyl).

The hetero 5-membered ring compound is, for example, a substituted or unsubstituted oligothiophene, TTF (tetrathiafulvalene).

Examples of the phthalocyanine compound are substituted or unsubstituted phthalocyanines having various central metals, naphthalocyanine, anthracyanine, and tetrapyrazinoporphyrazine. The porphyrin compounds are substituted or unsubstituted porphyrins having various central metals. In addition, the carbon nanotube may be a carbon nanotube of which the surface is modified with a semiconductor polymer.

As the n-type organic semiconductor that can be used for the organic semiconductor layer, any material may be used as long as it is a material having an electron transport property. The n-type organic semiconductor is preferably any one of a fullerene compound, an electron-deficient phthalocyanine compound, a fused polycyclic compound (such as a naphthalenetetracarbonyl compound or a perylenetetracarbonyl compound), a TCNQ compound (a tetracyanoquinodimethane compound), a polythiophene-based compound, a benzidine-based compound, a carbazole-based compound, a phenanthroline-based compound, a pyridinephenyl ligand iridium-based compound, a quinolinol ligand aluminum-based compound, an n-type $\pi$-conjugated polymer, or graphene. In addition, a plurality of kinds of compounds among these compounds may be used in combination as the n-type organic semiconductor. The n-type organic semiconductor is more preferably at least one kind of a fullerene compound, an electron-deficient phthalocyanine compound, a fused polycyclic compound, or an n-type $\pi$-conjugated polymer, and particularly preferably at least one kind of a fullerene compound, a fused polycyclic compound, or an n-type $\pi$-conjugated polymer.

The fullerene compound means a substituted or unsubstituted fullerene, and the fullerene may be any fullerene represented by $C_{60}$, $C_{70}$, $C_{76}$, $C_{78}$, $C_{80}$, $C_{82}$, $C_{84}$, $C_{86}$, $C_{88}$, $C_{90}$, $C_{96}$, $C_{116}$, $C_{180}$, $C_{240}$, $C_{540}$, or the like. The fullerene compound is preferably a substituted or unsubstituted $C_{60}$, $C_{70}$, or $C_{86}$ fullerene, and particularly preferably PCBM ([6,6]-phenyl-C61-butyric acid methyl ester, manufactured by Sigma-Aldrich Japan or the like) or an analogous substance thereof (for example, an analogous substance in which the $C_{60}$ moiety is substituted with $C_{70}$, $C_{86}$, or the like, an analogous substance in which the benzene ring of the substituent is substituted with another aromatic ring or a heterocyclic ring, methyl ester is substituted with n-butyl ester, i-butyl ester, or the like).

Examples of the electron-deficient phthalocyanine compound are substituted or unsubstituted phthalocyanines having four or more electron withdrawing groups bonded thereto and having various central metals, naphthalocyanine, anthracyanine, and tetrapyrazinoporphyrazine. The electron-deficient phthalocyanine compound is, for example, a fluorinated phthalocyanine (FieMPc) and a chlorinated phthalocyanine ($Cl_{16}$MPc). Here, M represents a central metal, and Pc represents phthalocyanine.

Although any naphthalenetetracarbonyl compound may be used, the preferred one is a naphthalenetetracarboxylic acid anhydride (NTCDA), a naphthalenebisimide compound (NTCDI), or a perinone pigment (Pigment Orange 43, Pigment Red 194, or the like).

Although any perylenetetracarbonyl compound may be used, the preferred one is a perylenetetracarboxylic acid anhydride (PTCDA), a perylenebisimide compound (PTCDI), or benzimidazole fused ring compound (PV).

The TCNQ compound is a substituted or unsubstituted TCNQ or a compound in which the benzene ring portion of the TCNQ is replaced with another aromatic ring or a heterocyclic ring. The TCNQ compound is, for example, TCNQ, TCNAQ (tetracyanoanthraquinodimethane), and TCN3T (2,2'-((2E,2"E)-3',4'-alkyl substituted-5H,5"H-[2,2': 5',2"-terthiophene]-5,5"-diylidene)dimalononitrile derivatives)

The polythiophene-based compound is a compound having a polythiophene structure such as poly(3,4-ethylenedioxythiophene). The polythiophene-based compound is, for example, PEDOT: PSS (a composite substance consisting of poly(3,4-ethylenedioxythiophene) (PEDOT) and polystyrene sulfonic acid (PSS)).

The benzidine-based compound is a compound having a benzidine structure in the molecule. The benzidine-based compound is, for example, N,N'-bis(3-methylphenyl)-N,N'-diphenylbenzidine (TPD) and N,N'-di-[(1-naphthyl)-N,N'-diphenyl]-1,1'-biphenyl)-4,4'-diamine (NPD).

The carbazole-based compound is a compound having a carbazole ring structure in the molecule. The carbazole-based compound is, for example, 4,4'-bis(N-carbazolyl)-1,1 '-biphenyl (CBP).

The phenanthroline-based compound is a compound having a phenanthroline ring structure in the molecule, and it is, for example, 2,9-dimethyl-4,7-diphenyl-1,10-phenanthroline (BCP).

The pyridinephenyl ligand iridium-based compound is a compound having an iridium complex structure that has a phenylpyridine structure as a ligand. The pyridinephenyl ligand iridium-based compound is, for example, bis(3,5-difluoro-2-(2-pyridylphenyl-(2-carboxypyridyl) iridium (III) (FIrpic) and tris(2-phenylpyridinato) iridium (III) ($Ir(ppy)_3$).

The quinolinol ligand aluminum-based compound is a compound having an aluminum complex structure that has a quinolinol structure as a ligand, and it is, for example, tris (8-quinolinolato) aluminum.

Particularly preferred examples of the n-type organic semiconductor material are shown below. Any R may be good as R in the formula, which is preferably any one of a hydrogen atom, a substituted or unsubstituted alkyl group (which preferably has 1 to 18 carbon atoms, more preferably 1 to 12 carbon atoms, and still more preferably 1 to 8 carbon atoms) which is branched or linear, or a substituted or unsubstituted aryl group (which preferably has 6 to 30, more preferably 6 to 20, and still more preferably 6 to 14 carbon atoms). In the structural formula, Me represents a methyl group, and M represents a metal atom.

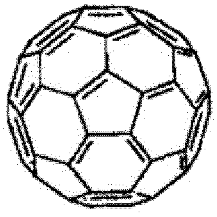

$C_{60}$

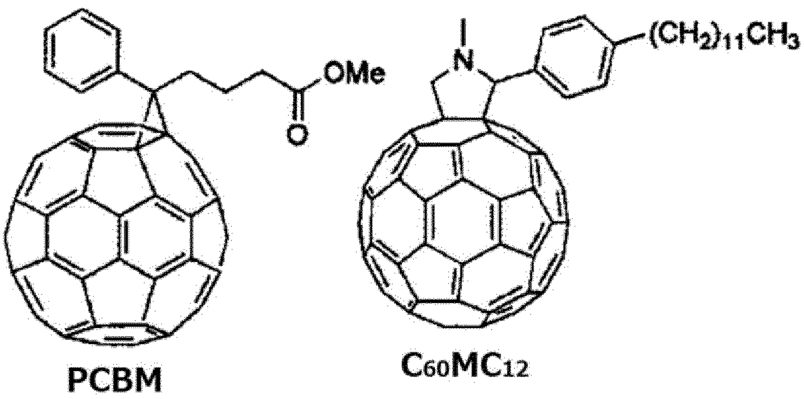

PCBM

$C_{60}MC_{12}$

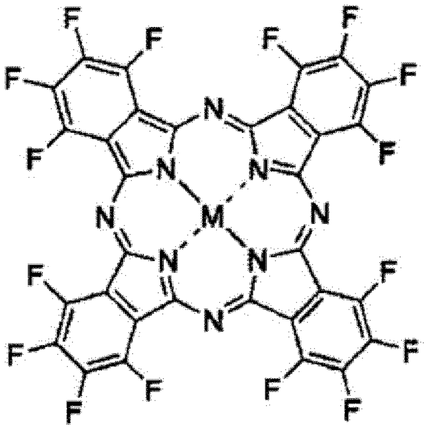

$F_{16}MPc$

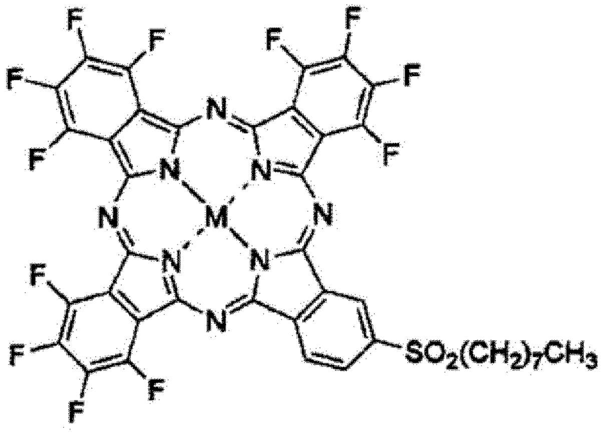

FPc-S8

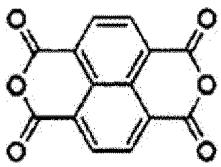

NTCDA

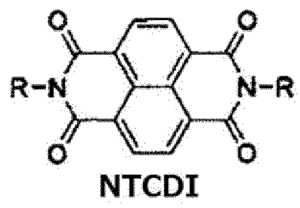

NTCDI

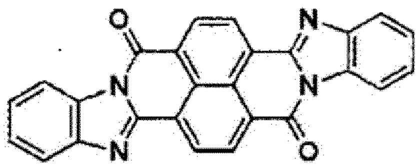

$PO_{43}$

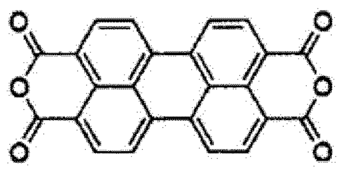

PTCDA

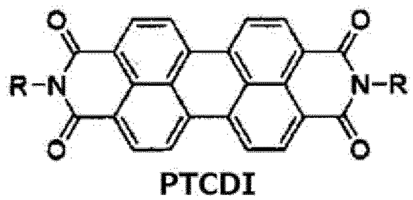

PTCDI

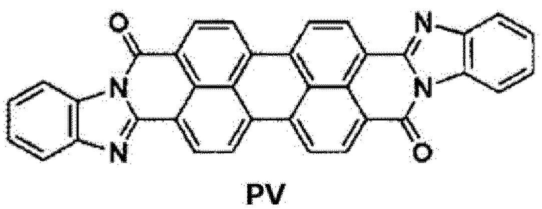

PV

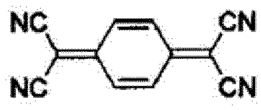

TCNQ

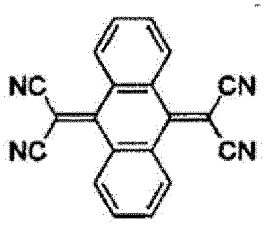

TCNAQ

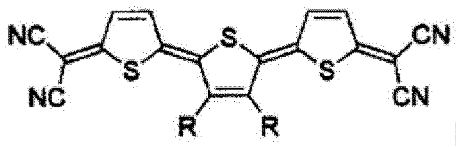

TCN3T

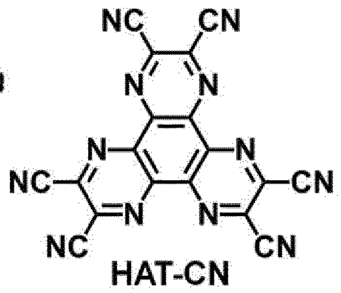

HAT-CN

The organic semiconductor layer may contain one kind or two or more kinds of organic semiconductors. In addition, the organic semiconductor layer may be a laminated or mixed layer of a p-type layer and an n-type layer.

The forming method for the organic layer may be a vapor phase method or a liquid phase method. In the case of the vapor phase method, a physical vapor phase deposition (PVD) method such as a vapor deposition method (a vacuum vapor deposition method, a molecular beam epitaxy method, or the like), a sputtering method, or an ion plating method, or a chemical vapor deposition (CVD) method such as a plasma polymerization method can be used, where a vapor deposition method is particularly preferable.

On the other hand, in the case of the liquid phase method, for example, the organic material is blended in a solvent to form a composition (a composition for forming an organic layer) that forms an organic layer. Then, this composition is supplied onto a base material and dried to form an organic layer. As a supply method, coating is preferable. Examples of the supply method include a slit coating method, a casting method, a blade coating method, a wire bar coating method, a spray coating method, a dipping (immersion) coating method, a bead coating method, an air knife coating method, a curtain coating method, an inkjet method, a spin coating method, a Langmuir-Blodgett (LB) method, and an edge cast method (for details, see JP6179930B). It is still more preferable to use a casting method, a spin coating method, or an ink jet method. Such a process makes it possible to produce an organic layer having a smooth surface and a large area at a low cost.

In addition, an organic solvent is preferable as a solvent to be used in the composition for forming an organic layer. Examples of the organic solvent include hydrocarbon-based solvents, for example, hexane, octane, decane, toluene, xylene, ethylbenzene, 1-methylnaphthalene, and 1,2-dichlorobenzene; ketone-based solvents, for example, acetone, methyl ethyl ketone, methyl isobutyl ketone, and cyclohexanone; halogenated hydrocarbon-based solvents, for example, dichloromethane, chloroform, tetrachloromethane, dichloroethane, trichloroethane, tetrachloroethane, chlorobenzene, dichlorobenzene, and chlorotoluene; ester-based solvents, for example, ethyl acetate, butyl acetate, and amyl acetate; alcohol-based solvents, for example, methanol, propanol, butanol, pentanol, hexanol, cyclohexanol, methyl cellosolve, ethyl cellosolve, and ethylene glycol; ether-based solvents, for example, dibutyl ether, tetrahydrofuran, dioxane, and anisole; and polar solvents, for example, N,N-dimethylformamide, N,N-dimethylacetamide, 1-methyl-2-pyrrolidone, 1-methyl-2-imidazolidinone, and dimethylsulfoxide. Only one kind of these solvents may be used, or two or more kinds thereof may be used. The proportion of the organic material in the composition for forming an organic layer is preferably 1% to 95% by mass and more preferably 5% to 90% by mass, whereby a film having any thickness can be formed.

In addition, a resin binder may be blended to the composition for forming an organic layer. In this case, a material for forming a film and a binder resin are dissolved or dispersed in the proper solvent described above to prepare a coating liquid, with which a thin film can be formed by various coating methods. Examples of the resin binder include insulating polymers such as polystyrene, polycarbonate, polyarylate, polyester, polyamide, polyimide, polyurethane, polysiloxane, polysulfone, polymethyl methacrylate, polymethyl acrylate, cellulose, polyethylene, and polypropylene, and copolymers thereof, photoconductive polymers such as polyvinyl carbazole and polysilane, and conductive polymers such as polythiophene, polypyrrole, polyaniline, and polyparaphenylene vinylene. The resin binder may be used alone, or a plurality of kinds thereof may be used in a combination. Considering the mechanical strength of the thin film, a resin binder having a high glass transition temperature is preferable, and considering the charge mobility, a resin binder, which is formed from a photoconductive polymer having a structure that does not contain a polar group or from a conductive polymer, is preferable.

In a case where the resin binder is blended, the blending amount thereof is preferably 0.1% to 30% by mass in the organic layer. One kind of resin binder may be used alone, or a plurality of kinds thereof may be used in combination. In the case of the combination of a plurality of kinds, it is preferable that the total amount thereof is within the above range.

Depending on the use application, the organic layer may be a single or a blended film which consists of a plurality of material kinds and which uses a mixed solution to which various organic materials or additives are added. For example, in a case of producing a photoelectric conversion layer, a mixed solution using a plurality of kinds of semiconductor materials can be used.

In addition, the base material may be heated or cooled at the time of film formation, and it is possible to control the film quality and the packing of molecules in the film by changing the temperature of the base material. The temperature of the base material is not particularly limited; however, it is preferably -200°C to 400°C, more preferably -100°C to 300°C, and still more preferably 0°C to 200°C.

The characteristics of the formed organic layer can be adjusted by post-treatment. For example, in a case where it is subjected to a heating treatment or exposed to a vaporized solvent, the characteristics can be improved by changing the morphology of the film or the packing of molecules in the film. In addition, an oxidation or reduction reaction is caused by exposure to an oxidizing or reducing gas, solvent, substance, or the like, or by using these materials in combination, whereby the carrier density in the film can be adjusted.

[Interlayer]

The interlayer is a layer that dissolves in water or a water-soluble solvent. Specifically, the dissolution rate in water or a water-soluble solvent is preferably 100 nm/s or more, more preferably 120 nm/s or more, and still more preferably 150 nm/s or more. The upper limit of the dissolution rate is not particularly limited and can be set to, for example, 1,000 nm/s or less.

The details of the water-soluble solvent are the same as those of the water-soluble solvent contained in the removal liquid described later.

In addition, in the interlayer, the dissolution rate in water is preferably 100 nm/s or more, more preferably 120 nm/s or more, and still more preferably 150 nm/s or more. The upper limit of the dissolution rate is not particularly limited and can be set to, for example, 1,000 nm/s or less.

The dissolution rate is measured, for example, by the following method.

A resist layer is removed from a laminate to produce a laminate from which the resist layer has been removed.

The removal of the resist layer can be carried out, for example, by removing the resist layer with a developer without carrying out either exposure or heating.

The film thickness (the film thickness A) of the laminate from which the resist layer has been removed is measured.

The laminate from which the resist light layer has been removed is immersed in a removal liquid for 5 seconds and then taken out, and the film thickness (the film thickness B) of the laminate is measured again.

The dissolution rate (nm/s) of the interlayer in the removal liquid is calculated by dividing the difference between the film thickness A and the film thickness B by the immersion time (5 seconds).

In the present specification, the dissolution rate of the interlayer can be measured, for example, by the above-described method.

In addition, the dissolution rate of the resist layer in a certain solvent or composition can be similarly measured by immersing the laminate in the solvent or composition without removing the resist layer.

The thickness of the interlayer is preferably 0.1 μm or more, more preferably 0.5 μm or more, still more preferably 1.0 μm or more, and even still more preferably 2.0 μm or more. The upper limit value of the thickness of the interlayer is preferably 10 μm or less, more preferably 5.0 μm or less, and still more preferably 3.0 μm or less.

In addition, the interlayer in the present invention is preferably a layer having a dissolution rate of 10 nm/s or less and more preferably a layer having a dissolution rate of 1 nm/s or less in a developer at 23°C. The lower limit of the dissolution rate is not particularly limited as long as it exceeds 0 nm/s.

The interlayer in the present invention preferably contains a polymer compound.

The interlayer preferably contains a water-soluble polymer compound and more preferably contains a water-soluble resin.

- Water-soluble resin -

The water-soluble resin refers to a resin, 1 g or more of which dissolves in 100 g of water at 23°C. The water-soluble resin is preferably a resin, 5 g or more of which dissolves in 100 g of water at 23°C, more preferably a resin, 10 g or more of which dissolves therein, and still more preferably a resin, 30 g or more of which dissolves therein. The upper limit of the dissolved amount is not particularly limited, however, it is practically about 100 g.

The water-soluble resin is preferably a resin containing a hydrophilic group, and examples of the hydrophilic group include a hydroxyl group, a carboxy group, a sulfonate group, a phosphate group, an amide group, and an imide group.

Specific examples of the water-soluble resin include polyvinyl pyrrolidone (PVP), polyvinyl alcohol (PVA), water-soluble polysaccharides (water-soluble cellulose (methyl cellulose, carboxymethyl cellulose, hydroxyethyl cellulose, hydroxypropyl cellulose, hydroxyethyl methyl cellulose, hydroxypropyl methyl cellulose, propyl methyl cellulose, and the like), pullulan or a pullulan derivative, starch (hydroxypropyl starch, carboxymethyl starch, and the like), chitosan, and

cyclodextrin), polyethylene oxide, polyethyl oxazoline, methylol melamine, polyacrylamide, a phenolic resin, and a styrene/maleic acid semi-ester. In addition, two or more kinds may be selected from these and used may be used as a copolymer. In the present invention, among these resins, the interlayer preferably contains at least one selected from the group consisting of polyvinyl pyrrolidone, polyvinyl alcohol, water-soluble polysaccharides, pullulan, and a pullulan derivative, and it more preferably contains at least one selected from the group consisting of polyvinyl pyrrolidone, polyvinyl alcohol, and water-soluble polysaccharides. In particular, the water-soluble polysaccharides are preferably cellulose and more preferably hydroxyethyl cellulose.

Among these, it is preferable that the interlayer contains polyvinyl alcohol from the viewpoint that the interlayer insolubilization step can be easily carried out by, for example, a plasma treatment.

Specifically, in the present invention, it is preferable that the water-soluble resin contained in the interlayer is a resin containing a repeating unit represented by any of Formulae (P1-1) to (P4-1).

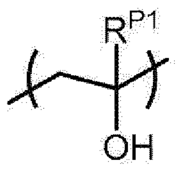

(P1-1)

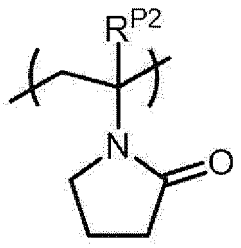

(P2-1)

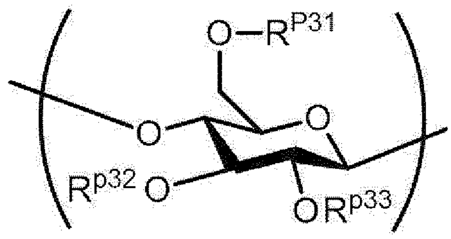

(P3-1)

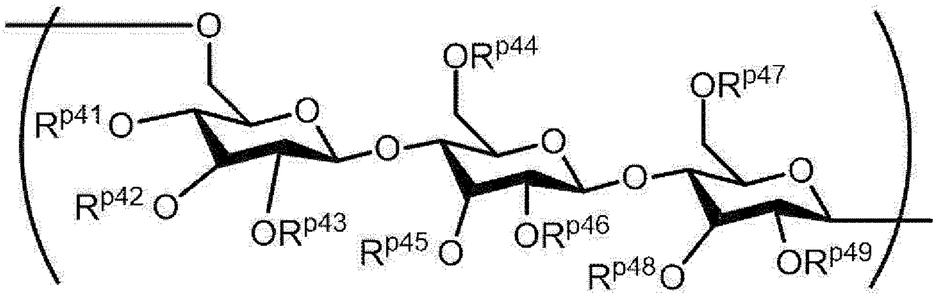

(P4-1)

In Formulae (P1-1) to (P4-1), $R^{P1}$ represents a hydrogen atom or a methyl group, $R^{P2}$ represents a hydrogen atom or a methyl group, $R^{p31}$ to $R^{p33}$ each independently represent a substituent or a hydrogen atom, and $R^{p41}$ to $R^{p49}$ each independently represent a substituent or a hydrogen atom.

<<Resin containing repeating unit represented by Formula (P1-1)>>

In Formula (P1-1), $R^{P1}$ is preferably a hydrogen atom.

The resin containing a repeating unit represented by Formula (P1-1) may further contain a repeating unit different from the repeating unit represented by Formula (P1-1).

The resin containing a repeating unit represented by Formula (P1-1) preferably contains 10% by mole to 100% by mole of the repeating unit represented by Formula (P1-1) and more preferably 30% by mole to 70% by mole thereof with respect to all the repeating units of the resin.

Examples of the resin containing a repeating unit represented by Formula (P1-1) include a resin containing two repeating units represented by Formula (P1-2).

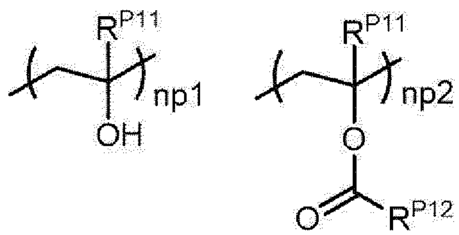

(P1-2)

In Formula (P1-2), $R^{P11}$'s each independently represent a hydrogen atom or a methyl group, $R^{P12}$ represents a substituent, and np1 and np2 represent a composition ratio in the molecule in terms of mass.

In Formula (P1-2), $R^{P11}$ has the same meaning as $R^{P1}$ in Formula (P1-1), and the same applies to the preferred aspect thereof.

In Formula (P1-2), examples of $R^{P12}$ include a group represented by $-L^P-T^P$. $L^P$ is a single bond or a linking group L described later. $T^P$ is a substituent, and examples thereof include the substituent T described later. Among them, $R^{P12}$ is preferably a hydrocarbon group such as an alkyl group (preferably having 1 to 12 carbon atoms, more preferably 1 to 6 carbon atoms, and still more preferably 1 to 3 carbon atoms), an alkenyl group (preferably having 2 to 12 carbon atoms, more preferably 2 to 6 carbon atoms, and still more preferably 2 or 3 carbon atoms), an alkynyl group (preferably having 2 to 12 carbon atoms, more preferably 2 to 6 carbon atoms, and still more preferably 2 or 3 carbon atoms), an aryl group (preferably having 6 to 22 carbon atoms, more preferably 6 to 18 carbon atoms, and still more preferably 6 to 10 carbon atoms), or an arylalkyl group (preferably having 7 to 23 carbon atoms, more preferably 7 to 19 carbon atoms, and still more preferably 7 to 11 carbon atoms). These alkyl group, alkenyl group, alkynyl group, aryl group, and arylalkyl group may further have a group defined by the substituent T as long as the effect of the present invention is exhibited.

In Formula (P1-2), np1 and np2 represent a composition ratio in the molecule in terms of mass and each independently are 10% by mass or more and less than 100% by mass. However, np1 + np2 does not exceed 100% by mass. A case where np1 + np2 is less than 100% by mass means that the copolymer contains another repeating unit.

<<Resin containing repeating unit represented by Formula (P2-1)>>

In Formula (P2-1), $R^{P2}$ is preferably a hydrogen atom.

The resin containing a repeating unit represented by Formula (P2-1) may further contain a repeating unit different from the repeating unit represented by Formula (P2-1).

The resin containing a repeating unit represented by Formula (P2-1) preferably contains 10% by mass to 100% by mass of the repeating unit represented by Formula (P2-1) and more preferably 30% by mass to 70% by mass thereof with respect to the total mass of the resin.

Examples of the resin containing a repeating unit represented by Formula (P2-1) include a resin containing two repeating units represented by Formula (P2-2).

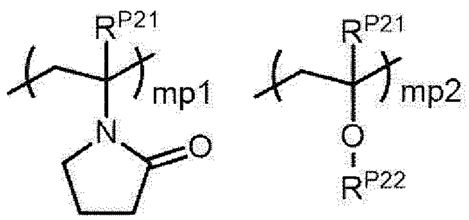

(P2-2)

In Formula (P2-2), $R^{P21}$'s each independently represents a hydrogen atom or a methyl group, $R^{P22}$ represents a substituent, and mp1 and mp2 represent a composition ratio in the molecule in terms of mass.

In Formula (P2-2), $R^{P21}$ has the same meaning as $R^{P2}$ in Formula (P2-1), and the same applies to the preferred aspect thereof.

In Formula (P2-2), examples of $R^{P22}$ include a group represented by $-L^P-T^P$. $L^P$ is a single bond or a linking group L described later. $T^P$ is a substituent, and examples thereof include the substituent T described later. Among them, $R^{P22}$ is preferably a hydrocarbon group such as an alkyl group (preferably having 1 to 12 carbon atoms, more preferably 1 to 6 carbon atoms, and still more preferably 1 to 3 carbon atoms), an alkenyl group (preferably having 2 to 12 carbon atoms, more preferably 2 to 6 carbon atoms, and still more preferably 2 or 3 carbon atoms), an alkynyl group (preferably having 2 to 12 carbon atoms, more preferably 2 to 6 carbon atoms, and still more preferably 2 or 3 carbon atoms), an aryl group (preferably having 6 to 22 carbon atoms, more preferably 6 to 18 carbon atoms, and still more preferably 6 to 10 carbon atoms), or an arylalkyl group (preferably having 7 to 23 carbon atoms, more preferably 7 to 19 carbon atoms, and still more preferably 7 to 11 carbon atoms). These alkyl group, alkenyl group, alkynyl group, aryl group, and arylalkyl group may further have a group defined by the substituent T as long as the effect of the present invention is exhibited.

In Formula (P2-2), mp1 and mp2 represent a composition ratio in the molecule in terms of mass and each independently are 10% by mass or more and less than 100% by mass. However, mp1 + mp2 does not exceed 100% by mass. A case where mp1 + mp2 is less than 100% by mass means that the copolymer contains another repeating unit.

<<Resin containing repeating unit represented by Formula (P3-1)>>

In Formula (P3-1), $R^{p31}$ to $R^{p33}$ each independently represent preferably a hydrocarbon group which may have a substituent, an acyl group, $-(CH_2CH_2O)_{ma}H$, $-CH_2COONa$, or a hydrogen atom, and it is more preferably a hydrocarbon group, a hydrocarbon group having a hydroxy group as a substituent, an acyl group, or a hydrogen atom and still more preferably a hydrogen atom. ma is or 2.

The hydrocarbon group which may have a substituent preferably has 1 to 10 carbon atoms and more preferably 1 to 4 carbon atoms.

The hydrocarbon group having a hydroxy group as a substituent is preferably a hydrocarbon group having one hydroxy group and having 1 to 10 carbon atoms, more preferably a hydrocarbon group having one hydroxy group and having 1 to 4 carbon atoms, and still more preferably $-CH_2(OH)$, $-CH_2CH_2(OH)$, or $-CH_2CH(OH)\ CH_3$.

The acyl group is preferably an alkylcarbonyl group in which the alkyl group has 1 to 4 carbon atoms, and it is more preferably an acetyl group.

The resin containing a repeating unit represented by Formula (P3-1) may further contain a repeating unit different from the repeating unit represented by Formula (P3-1).

The resin containing a repeating unit represented by Formula (P3-1) preferably contains 10% by mass to 100% by mass of the repeating unit represented by Formula (P3-1) and more preferably 30% by mass to 70% by mass thereof with respect to the total mass of the resin.

In addition, the hydroxy group represented by Formula (P3-1) may be appropriately substituted with the substituent T or a group in which the linking group L and the substituent T are combined. In a case where a plurality of the substituents T are present, the substituents T may be bonded to each other or bonded to a ring in the formula through or not through the linking group L to form a ring.

<<Resin containing repeating unit represented by Formula (P4-1)>>

In Formula (P4-1), $R^{P41}$ to $R^{P49}$ each independently represent preferably a hydrocarbon group which may have a substituent, an acyl group, $-(CH_2CH_2O)_{ma}H$, $-CH_2COONa$, or a hydrogen atom, and it is more preferably a hydrocarbon group, a hydrocarbon group having a hydroxy group as a substituent, an acyl group, or a hydrogen atom and still more preferably a hydrogen atom. ma is 1 or 2.

The hydrocarbon group which may have a substituent preferably has 1 to 10 carbon atoms and more preferably 1 to 4 carbon atoms.

The above-described hydrocarbon group having a hydroxy group as a substituent is preferably a hydrocarbon group having one hydroxy group and having 1 to 10 carbon atoms, more preferably a hydrocarbon group having one hydroxy group and having 1 to 4 carbon atoms, and still more preferably $-CH_2(OH)$, $-CH_2CH_2(OH)$, or $-CH_2CH(OH)CH_3$.

The resin containing a repeating unit represented by Formula (P4-1) may further contain a repeating unit different from the repeating unit represented by Formula (P4-1).

The resin containing a repeating unit represented by Formula (P4-1) preferably contains 10% by mass to 100% by mass of the repeating unit represented by Formula (P4-1) and more preferably 30% by mass to 70% by mass thereof with respect to the total mass of the resin.

In addition, the hydroxy group represented by Formula (P4-1) may be appropriately substituted with the substituent T or a group in which the linking group L and the substituent T are combined. In a case where a plurality of the substituents T are present, the substituents T may be bonded to each other or bonded to a ring in the formula through or not through the linking group L to form a ring.

Examples of the substituent T include an alkyl group (preferably having 1 to 24 carbon atoms, more preferably 1 to 12 carbon atoms, and still more preferably 1 to 6 carbon atoms), an arylalkyl group (preferably having 7 to 21 carbon atoms, more preferably 7 to 15 carbon atoms, and still more preferably 7 to 11 carbon atoms), an alkenyl group (preferably having 2 to 24 carbon atoms, more preferably 2 to 12 carbon atoms, and still more preferably 2 to 6 carbon atoms), an alkynyl group (preferably having 2 to 12 carbon atoms, more preferably 2 to 6 carbon atoms, and still more preferably 2 or 3 carbon atoms), a hydroxyl group, an amino group (preferably having 0 to 24 carbon atoms, more preferably 0 to 12 carbon atoms, and still more preferably 0 to 6 carbon atoms), a thiol group, a carboxy group, an aryl group (preferably having 6 to 22 carbon atoms, more preferably 6 to 18 carbon atoms, and still more preferably 6 to 10 carbon atoms), an alkoxyl group (preferably having 1 to 12 carbon atoms, more preferably 1 to 6 carbon atoms, and still more preferably 1 to 3 carbon atoms), an aryloxy group (preferably having 6 to 22 carbon atoms, more preferably 6 to 18 carbon atoms, and still more preferably 6 to 10 carbon atoms), an acyl group (preferably having 2 to 12 carbon atoms, more preferably 2 to 6 carbon atoms, and still more preferably 2 or 3 carbon atoms), an acyloxy group (preferably having 2 to 12 carbon atoms, more preferably 2 to 6 carbon atoms, and still more preferably 2 or 3 carbon atoms), an aryloyl group (preferably having 7 to 23 carbon atoms, more preferably 7 to 19 carbon atoms, and still more preferably 7 to 11 carbon atoms), an aryloyloxy group (preferably having 7 to 23 carbon atoms, more preferably 7 to 19 carbon atoms, and still more

preferably 7 to 11 carbon atoms), a carbamoyl group (preferably having 1 to 12 carbon atoms, more preferably 1 to 6 carbon atoms, and still more preferably 1 to 3 carbon atoms), a sulfamoyl group (preferably having 0 to 12 carbon atoms, more preferably 0 to 6 carbon atoms, and still more preferably 0 to 3 carbon atoms), a sulfo group, an alkylsulfonyl group (preferably having 1 to 12 carbon atoms, more preferably 1 to 6 carbon atoms, and still more preferably 1 to 3 carbon atoms), an arylsulfonyl group (preferably having 6 to 22 carbon atoms, more preferably 6 to 18 carbon atoms, and still more preferably 6 to 10 carbon atoms), a heteroaryl group (preferably having 1 to 12 carbon atoms, more preferably 1 to 8 carbon atoms, and still more preferably 2 to 5 carbon atoms, and preferably having a 5-membered ring or a 6-membered ring), a (meth)acryloyl group, a (meth)acryloyloxy group, a halogen atom (for example, a fluorine atom, a chlorine atom, a bromine atom, and an iodine atom), an oxo group (=O), an imino group (=$NR^N$), and an alkylidene group (=$C(R^N)_2$). The $R^N$ is a hydrogen atom or an alkyl group (preferably having 1 to 12 carbon atoms, more preferably 1 to 6 carbon atoms, and still more preferably 1 to 3 carbon atoms) and more preferably a hydrogen atom, a methyl group, an ethyl group, or a propyl group. The alkyl moiety, the alkenyl moiety, and the alkynyl moiety contained in each substituent may be chain-like or cyclic or may be linear or branched. In a case where the substituent T is a group which can have a substituent, the substituent T may further have a substituent T. For example, the alkyl group may be an halogenated alkyl group, a (meth)acryloyloxyalkyl group, an aminoalkyl group, or a carboxyalkyl group. In a case where the substituent is a group capable of forming a salt of a carboxy group, an amino group, or the like, the group may form a salt.

Examples of the linking group L include an alkylene group (preferably having 1 to 24 carbon atoms, more preferably 1 to 12 carbon atoms, and still more preferably 1 to 6 carbon atoms), an alkenylene group (preferably having 2 to 12 carbon atoms, more preferably 2 to 6 carbon atoms, and still more preferably 2 or 3 carbon atoms), an alkynylene group (preferably having 2 to 12 carbon atoms, more preferably 2 or 3 carbon atoms, and still more preferably 1 to 6 carbon atoms), an (oligo)alkyleneoxy group (an alkylene group in one repeating unitpreferably has 1 to 12 carbon atoms, more preferably 1 to 6 carbon atoms, and still more preferably 1 to 3 carbon atoms; and the number of repetition is preferably 1 to 50, more preferably 1 to 40, and still more preferably 1 to 30), an arylene group (preferably having 6 to 22 carbon atoms, more preferably 6 to 18 carbon atoms, and still more preferably 6 to 10 carbon atoms), an oxygen atom, a sulfur atom, a sulfonyl group, a carbonyl group, a thiocarbonyl group, -$NR^N$-, and a linking group related to a combination thereof. In the present specification, the "(oligo)alkyleneoxy group" means a divalent linking group having one or more "alkyleneoxy" constitutional units. The number of carbon atoms in an alkylene chain in the constitutional unit may be the same or different for every constitutional unit. The alkylene group may have the substituent T. For example, the alkylene group may have a hydroxyl group. The number of atoms contained in the linking group L is preferably 1 to 50, more preferably 1 to 40, and still more preferably 1 to 30 excluding the hydrogen atoms. The number of linking atoms means the number of atoms positioned on the shortest path among the atomic groups involved in the linkage. For example, in a case of -$CH_2$-(C=O)-O-, the number of atoms involved in the linkage is 6, and it is 4 in a case where the hydrogen atoms are excluded. On the other hand, the atoms on the shortest path, involved in the linkage, are -C-C-O-, and thus the number of atoms is three. The number of linking atoms is preferably 1 to 24, more preferably 1 to 12, and still more preferably 1 to 6. It is noted that the alkylene group, the alkenylene group, the alkynylene group, and the (oligo)alkyleneoxy group may be chain-like or cyclic or may be linear or branched. In a case where the linking group is a group capable of forming a salt of -$NR^N$- or the like, the group may form a salt.

In addition, examples of the water-soluble resin include polyethylene oxide, hydroxyethyl cellulose, carboxymethyl cellulose, water-soluble methylol melamine, polyacrylamide, a phenol resin, a styrene/maleic acid semi-ester, and poly-N-vinylacetamide.

In addition, a commercially available product of the water-soluble resin may be used, and examples of the commercially available product thereof include a PITZCOL series (K-30, K-50, K-90, and the like) manufactured by DKS Co., Ltd.), and a LUVITEC series (VA64P, VA6535P, and the like) manufactured by BASF SE, PXP-05, JL-05E, JP-03, JP-04, AMPS (a 2-acrylamide-2-methylpropanesulfonic acid copolymer) manufactured by JAPAN VAM & POVAL Co., Ltd.), and Nanoclay manufactured by Sigma-Aldrich Co., LLC.

Among these, it is preferable to use PITZCOL K-90 or PXP-05.

For the water-soluble resin, the resin described in WO2016/175220A is referred to, the content of which is incorporated in the present specification.

The weight-average molecular weight of the water-soluble resin is appropriately selected depending on the kind of the water-soluble resin. In the present specification, the weight-average molecular weight (Mw) and the number-average molecular weight (Mn) of the water-soluble resin are defined as polyether oxide equivalent values according to the GPC measurement. In particular, in a case where the water-soluble resin is a resin containing a repeating unit represented by Formula (p1-1) (for example, polyvinyl alcohol (PVA)), the weight-average molecular weight is preferably 10,000 to 100,000. The upper limit of this numerical range is preferably 80,000 or less and more preferably 60,000 or less. In addition, the lower limit of this numerical range is preferably 13,000 or more and more preferably 15,000 or more. In a case where the water-soluble resin is a resin represented by Formula (p2-2) (for example, polyvinyl pyrrolidone (PVP)), the weight-average molecular weight is preferably 20,000 to 2,000,000. The upper limit of this numerical range is preferably 1,800,000 or less and more preferably 1,500,000 or less. In addition, the lower limit of this numerical range

is preferably 30,000 or more and more preferably 40,000 or more. In a case where the water-soluble resin is a resin (for example, water-soluble polysaccharides) containing a repeating unit represented by Formula (P3-1) or Formula (p4-1), the weight-average molecular weight is preferably 50,000 to 2,000,000. The upper limit of this numerical range is preferably 1,500,000 or less and more preferably 1,300,000 or less. In addition, the lower limit of this numerical range is preferably 70,000 or more and more preferably 90,000 or more.

The molecular weight dispersion (the weight-average molecular weight/the number-average molecular weight, also simply referred to as the "dispersivity") of the water-soluble resin is preferably 1.0 to 5.0 and more preferably 2.0 to 4.0.

Further, in the present invention, it is also preferable that, as the water-soluble resin, the interlayer contains a high-molecular-weight resin (for example, a water-soluble resin having a weight-average molecular weight of 10,000 or more) and a low-molecular-weight resin having a weight-average molecular weight smaller than the weight-average molecular weight of the high-molecular-weight resin, and the weight-average molecular weight of the low-molecular-weight resin is half or less of the weight-average molecular weight of the high-molecular-weight resin. As a result, the low-molecular-weight resin is rapidly eluted into a removal liquid (particularly water), and the high-molecular-weight resin is also easily removed starting from a portion where the low-molecular-weight resin has been eluted, and thus an effect of further decreasing the residue of the interlayer after the removal of the interlayer is obtained. In addition, it is possible to suppress the occurrence of cracking in the interlayer in a case of forming the interlayer by using the interlayer.

In the present invention, whether or not the interlayer contains the high-molecular-weight resin and the low-molecular-weight resin can be determined, for example, based on where or not two peak tops (maximal values) can be confirmed in a case where the molecular weight distribution of the middle layer or the entire water-soluble resin is measured.

The weight-average molecular weight of the high-molecular-weight resin is preferably 20,000 or more and preferably 45,000 or more. In addition, the weight-average molecular weight of the high-molecular-weight resin is preferably 2,000,000 or less, and it may be 1,500,000 or less. The molecular weight ratio of the low-molecular-weight resin to the high-molecular-weight resin (= the weight-average molecular weight of the low-molecular-weight resin/the weight-average molecular weight of the high-molecular-weight resin) is preferably 0.4 or less. The upper limit of the molecular weight ratio is more preferably 0.3 or less and still more preferably 0.2 or less. The lower limit of the molecular weight ratio is not particularly limited; however, it is preferably 0.001 or more, and it may be 0.01 or more.

In addition, it is also preferable that in the molecular weight distribution of the entire water-soluble resin that is used in the present invention, two or more peak tops are present, and among these two or more peak tops, the molecular weight corresponding to one peak top is half or less of the molecular weight corresponding to the other peak top. As a result, the same effect as in the case where the weight-average molecular weight of the low-molecular-weight resin is half or less of the weight-average molecular weight of the high-molecular-weight resin can be obtained. The water-soluble resin having such a molecular weight distribution as described above is obtained, for example, by mixing the above-described high-molecular-weight resin and the above-described low-molecular-weight resin. In a case where a plurality of peaks are confirmed in the molecular weight distribution, it suffices that regarding at least one set of peak tops in a case where two sets of peak tops are selected from those peak tops, the molecular weight corresponding to one peak top is half or less of the molecular weight corresponding to the other peak top.

The larger molecular weight among the molecular weights corresponding to the peak tops (the peak top molecular weights) is preferably 20,000 or more and preferably 45,000 or more. In addition, the larger peak top molecular weight is preferably 2,000,000 or less, and it may be 1,500,000 or less. The molecular weight ratio (= the smaller peak top molecular weight/the larger peak top molecular weight) of the smaller peak top molecular weight to the larger peak top molecular weight is preferably 0.4 or less. The upper limit of the molecular weight ratio is more preferably 0.3 or less and still more preferably 0.2 or less. The lower limit of the molecular weight ratio is not particularly limited; however, it is preferably 0.001 or more, and it may be 0.01 or more.

The difference between the weight-average molecular weight of the high-molecular-weight resin and the weight-average molecular weight of the low-molecular-weight resin (the molecular weight distance between peaks in a case where the molecular weight distribution of the entire water-soluble resin is taken) is preferably 10,000 to 80,000 and more preferably 20,000 to 60,000 in a case where PVA is contained as the high-molecular-weight resin. In a case where PVP is contained as the high-molecular-weight resin, the above difference is preferably 50,000 to 1,500,000 and more preferably 100,000 to 1,200,000. In a case where water-soluble polysaccharides are contained as the high-molecular-weight resin, the above difference is preferably 50,000 to 1,500,000 and more preferably 100,000 to 1,200,000.

In particular, in the present invention, it is preferable that the water-soluble resin contains PVA having a weight-average molecular weight of 20,000 or more as the high-molecular-weight resin. In this case, the weight-average molecular weight is more preferably 30,000 or more and still more preferably 40,000 or more. In addition, in the present invention, it is also preferable that the water-soluble resin contains PVP having a weight-average molecular weight of 300,000 or more as the high-molecular-weight resin. In this case, the weight-average molecular weight is more preferably 400,000 or more and still more preferably 500,000 or more. Further, in the present invention, it is also preferable that the water-soluble resin contains water-soluble polysaccharides having a weight-average molecular weight of 300,000

or more as the high-molecular-weight resin. In this case, the weight-average molecular weight is more preferably 400,000 or more and still more preferably 500,000 or more.

The preferred combinations of the high-molecular-weight resin and the low-molecular-weight resin are, for example, as follows. The water-soluble resin may satisfy only one requirement of the following combination, or it may have an aspect in which the requirements of two or more combinations are satisfied at the same time.

· A combination of PVA (a high-molecular-weight resin) having a weight-average molecular weight Mw of 30,000 to 100,000 and PVA (a low-molecular-weight resin) having a weight-average molecular weight Mw of 10,000 to 40,000.
· A combination of PVP (a high-molecular-weight resin) having an Mw of 500,000 to 1,500,000 and PVP (a low-molecular-weight resin) having an Mw of 30,000 to 600,000.
· A combination of water-soluble polysaccharides (a high-molecular-weight resin) having an Mw of 500,000 to 1,500,000 and water-soluble polysaccharides (a low-molecular-weight resin) having an Mw of 50,000 to 600,000.
· A combination of PVP (a high-molecular-weight resin) having an Mw of 500,000 to 1,500,000 and PVA (a low-molecular-weight resin) having an Mw of 10,000 to 100,000.
· A combination of water-soluble polysaccharides (a high-molecular-weight resin) having an Mw of 500,000 to 1,500,000 and PVA (a low-molecular-weight resin) having an Mw of 10,000 to 100,000.
· A combination of PVP (a high-molecular-weight resin) having an Mw of 500,000 to 1,500,000 and water-soluble polysaccharides (a low-molecular-weight resin) having an Mw of 50,000 to 600,000.
· A combination of water-soluble polysaccharides (a high-molecular-weight resin) having an Mw of 500,000 to 1,500,000 and PVP (a low-molecular-weight resin) having an Mw of 30,000 to 600,000.

The content of the high-molecular-weight resin is preferably 50% by mass or less with respect to the entire water-soluble resin. The upper limit of this numerical range is more preferably 40% by mass or less and still more preferably 30% by mass or less. In addition, the lower limit of this numerical range is more preferably 5% by mass or more and still more preferably 10% by mass or more.

On the other hand, the water-soluble resin may contain substantially no low-molecular-weight resin. In the present invention, "contains substantially no low-molecular-weight resin" means that the content of the low-molecular-weight resin is 3% by mass or less with respect to the entire water-soluble resin. In this aspect, the content of the low-molecular-weight resin is preferably 1% by mass or less with respect to the entire water-soluble resin.

The content of the polymer compound in the interlayer may be appropriately adjusted as necessary; however, it is preferably 20% by mass or more, more preferably 50% by mass or more, and still more preferably 70% by mass or more, with respect to the total mass of the interlayer. The upper limit of the above content is preferably 100% by mass or less, more preferably 99% by mass or less, and still more preferably 98% by mass or less.

The interlayer may contain only one kind of polymer compound or two or more kinds thereof. In a case where two or more kinds thereof are contained, the total amount thereof is preferably within the above-described range.

- Surfactant containing an acetylene group -

From the viewpoint of being effective in removing the residue, it is preferable that the interlayer contains a surfactant containing an acetylene group.

In a case where the interlayer contains a surfactant containing an acetylene group, it is conceived that the adsorption of the polymer compound to the organic layer is suppressed, which is effective in the removal of the residue of the interlayer after the removal with the removal liquid.

The number of acetylene groups in the molecule in the surfactant containing an acetylene group is not particularly limited; however, it is preferably 1 to 10, more preferably 1 to 5, still more preferably 1 to 3, and even still more preferably 1 or 2.

The molecular weight of the surfactant containing an acetylene group is preferably relatively small, where it is preferably 2,000 or less, more preferably 1,500 or less, and still more preferably 1,000 or less. The lower limit value thereof is not particularly limited; however, it is preferably 200 or more.

<<Compound represented by Formula (9)>>

The surfactant containing an acetylene group is preferably a compound represented by Formula (9) below.

$$R^{91}-C\equiv C-R^{92} \qquad (9)$$

In the formula, $R^{91}$ and $R^{92}$ are each independently an alkyl group having 3 to 15 carbon atoms, an aromatic

hydrocarbon group having 6 to 15 carbon atoms, or an aromatic heterocyclic group having 4 to 15 carbon atoms. The aromatic heterocyclic group preferably has 1 to 12 carbon atoms, more preferably has 2 to 6 carbon atoms, and still more preferably has 2 to 4 carbon atoms. The aromatic heterocyclic ring is preferably a 5-membered ring or a 6-membered ring. The heteroatom contained in the aromatic heterocyclic ring is preferably a nitrogen atom, an oxygen atom, or a sulfur atom.

$R^{91}$ and $R^{92}$ may each independently have a substituent, and examples of the substituent include the above-described substituent T.

- Compound represented by Formula (91) -

The compound represented by Formula (9) is preferably a compound represented by Formula (91) below.

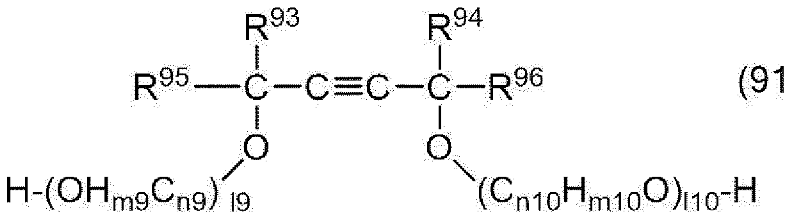

(91)

$R^{93}$ to $R^{96}$ are each independently a hydrocarbon group having 1 to 24 carbon atoms, n9 is an integer of 1 to 6, m9 is an integer that is twice n9, n10 is an integer of 1 to 6, m10 is an integer that is twice n10, and l9 and 110 are each independently a number of 0 or more and 12 or less.

Although being a hydrocarbon group, $R^{93}$ to $R^{96}$ are preferably, among them, an alkyl group (preferably having 1 to 12 carbon atoms, more preferably 1 to 6 carbon atoms, and still more preferably 1 to 3 carbon atoms), an alkenyl group (preferably having 2 to 12 carbon atoms, more preferably 2 to 6 carbon atoms, and still more preferably 2 or 3 carbon atoms), an alkynyl group (preferably having 2 to 12 carbon atoms, more preferably 2 to 6 carbon atoms, and still more preferably 2 or 3 carbon atoms), an aryl group (preferably having 6 to 22 carbon atoms, more preferably 6 to 18 carbon atoms, and still more preferably 6 to 10 carbon atoms), or an arylalkyl group (preferably having 7 to 23 carbon atoms, more preferably 7 to 19 carbon atoms, and still more preferably 7 to 11 carbon atoms). The alkyl group, the alkenyl group, and the alkynyl group may be linear or cyclic or may be linear or branched. $R^{91}$ to $R^{96}$ may have the substituent T as long as the effect of the present invention is exhibited. In addition, $R^{91}$ to $R^{96}$ may be bonded to each other or form a ring through the above-described linking group L. A plurality of the substituents T may be bonded to each other or bonded to a hydrocarbon group in the formula through or not through the linking group L described below to form a ring.

$R^{93}$ and $R^{94}$ are preferably an alkyl group (preferably having 1 to 12 carbon atoms, more preferably 1 to 6 carbon atoms, and still more preferably 1 to 3 carbon atoms). Among them, a methyl group is preferable.

$R^{95}$ and $R^{96}$ are preferably an alkyl group (preferably having 1 to 12 carbon atoms, more preferably 2 to 6 carbon atoms, and still more preferably 3 to 6 carbon atoms). Among them, $-(C_{n11}R^{98}{}_{m11})-R^{97}$ is preferable. In particular, $R^{95}$ and $R^{96}$ are preferably an isobutyl group.

n11 is an integer of 1 to 6, where an integer of 1 to 3 is preferable. m11 is a number that is twice n11.

$R^{97}$ and $R^{98}$ are each independently preferably a hydrogen atom or an alkyl group (preferably having 1 to 12 carbon atoms, more preferably 1 to 6 carbon atoms, and still more preferably 1 to 3 carbon atoms).

n9 is an integer of 1 to 6, where an integer of 1 to 3 is preferable. m9 is an integer that is twice n9.

n10 is an integer of 1 to 6, where an integer of 1 to 3 is preferable. m10 is an integer that is twice n10.

l9 and 110 are each independently a number of 0 to 12. However, l9 + 110 is preferably a number of 0 to 12, more preferably a number of 0 to 8, still more preferably a number of 0 to 6, even still more preferably a number of more than 0 and less than 6, and even further still more preferably a number of more than 0 and 3 or less. It is noted that the compound of Formula (91) may be a mixture of compounds that differ in the numbers of l9 and 110, and in this case, the numbers of l9 and 110, or l9 + 110 may be a number including a part after the decimal point.

- Compound represented by Formula (92) -

The compound represented by Formula (91) is preferably a compound represented by Formula (92).

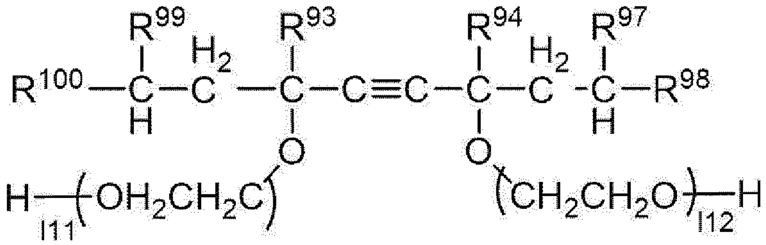 (92)

$R^{93}$, $R^{94}$, and $R^{97}$ to $R^{100}$ are each independently a hydrocarbon group having 1 to 24 carbon atoms, and 111 and 112 are each independently a number of 0 or more and 12 or less.

Among them, $R^{93}$, $R^{94}$, and $R^{97}$ to $R^{100}$ are preferably an alkyl group (preferably having 1 to 12 carbon atoms, more preferably 1 to 6 carbon atoms, and still more preferably 1 to 3 carbon atoms), an alkenyl group (preferably having 2 to 12 carbon atoms, more preferably 2 to 6 carbon atoms, and still more preferably 2 or 3 carbon atoms), an alkynyl group (preferably having 2 to 12 carbon atoms, more preferably 2 to 6 carbon atoms, and still more preferably 2 or 3 carbon atoms), an aryl group (preferably having 6 to 22 carbon atoms, more preferably 6 to 18 carbon atoms, and still more preferably 6 to 10 carbon atoms), or an arylalkyl group (preferably having 7 to 23 carbon atoms, more preferably 7 to 19 carbon atoms, and still more preferably 7 to 11 carbon atoms). The alkyl group, the alkenyl group, and the alkynyl group may be chain-like or cyclic or may be linear or branched. $R^{93}$, $R^{94}$, and $R^{97}$ to $R^{100}$ may have the substituent T as long as the effect of the present invention is exhibited. In addition, $R^{93}$, $R^{94}$, and $R^{97}$ to $R^{100}$ may be bonded to each other or form a ring through the linking group L. A plurality of the substituents T may be bonded to each other or bonded to a hydrocarbon group in the formula through or not through the linking group L to form a ring.

$R^{93}$, $R^{94}$, and $R^{97}$ to $R^{100}$ are each independently preferably an alkyl group (preferably having 1 to 12 carbon atoms, more preferably 1 to 6 carbon atoms, and still more preferably 1 to 3 carbon atoms). Among them, a methyl group is preferable.

l11 + l12 is preferably a number of 0 to 12, more preferably a number of 0 to 8, still more preferably a number of 0 to 6, even more preferably a number of more than 0 and less than 6, even still more preferably a number of more than 0 and 5 or less, and even further still more preferably a number of more than 0 and or 4 or less, and it may be a number of more than 0 and 3 or less and may be a number of more than 0 and 1 or less. It is noted that the compound of Formula (92) may be a mixture of compounds that differ in the numbers of 111 and 112, and in this case, the numbers of l11 and 112, or 111 + 112 may be a number including a part after the decimal point.

Examples of the surfactant containing an acetylene group include a Surfynol 104 series (product name, Nissin Chemical Co., Ltd.), Acetyrenol E00, Acetyrenol E40, Acetyrenol E13T, and Acetyrenol 60 (all of which are product names, manufactured by Kawaken Fine Chemicals Co., Ltd.), among which a Surfynol 104 series, Acetyrenol E00, Acetyrenol E40, or Acetyrenol E13T is preferable, and Acetyrenol E40 or Acetyrenol E13T is more preferable. It is noted that the Surfynol 104 series and the Acetyrenol E00 are surfactants having the same structure.

- Other surfactants -

The interlayer may contain other surfactants other than the above-described surfactant containing an acetylene group, for example, for the intended purpose of improving the coatability of the composition for forming an interlayer, which will be described later.

Any other surfactant such as a nonionic type, an anionic type, or an amphoteric fluorine type may be used as long as it reduces the surface tension.

As the other surfactants, the following surfactants can be used: nonionic surfactants such as polyoxyethylene alkyl ethers such as polyoxyethylene lauryl ether, polyoxyethylene cetyl ether, and polyoxyethylene stearyl ether, polyoxyethylene alkylaryl ethers such as polyoxyethylene octylphenyl ether and polyoxyethylene nonylphenyl ether, polyoxyethylene alkyl esters such as polyoxyethylene stearate, sorbitan alkyl esters such as sorbitan monolaurate, sorbitan monostearate, sorbitan distearate, sorbitan monooleate, sorbitan sesquialeate, and sorbitan trioleate, monoglyceride alkyl esters and the like, such as glycerol monostearate and glycerol monooleate, and oligomers containing fluorine or silicon; anionic surfactants such as alkylbenzene sulfonates such as sodium dodecylbenzene sulfonate, alkylnaphthalene sulfonates such as sodium butylnaphthalene sulfonate, sodium pentylnaphthalene sulfonate, sodium hexylnaphthalene sulfonate, and sodium octylnaphthalene sulfonate, alkyl sulfates such as sodium lauryl sulfate, alkyl sulfonates such as sodium dodecyl sulfonate, and sulfosuccinic acid ester salts such as sodium dilauryl sulfosuccinate; and amphoteric surfactants such as alkyl betaines such as lauryl betaine and stearyl betaine, and amino acids.

In a case where the interlayer contains at least one of a surfactant containing an acetylene group or another surfactant, the adding amount of the surfactant is, in terms of the total amount of the surfactant containing an acetylene group and the other surfactant, preferably 0.05% to 20% by mass, more preferably 0.07% to 15% by mass, and still

more preferably 0.1% to 10% by mass with respect to the total mass of the interlayer. One kind of these surfactants may be used, or a plurality of kinds thereof may be used. In a case where a plurality of kinds thereof are used, the total amount thereof is within the above range.

In addition, in the present invention, it is also possible to adopt a configuration substantially free of other surfactants. "Substantially free" refers to that the content of the other surfactants is 5% by mass or less of the content of the surfactant containing an acetylene group, where 3% by mass or less is preferable, and 1% by mass or less is more preferable.

The surface tension of a 0.1% by mass aqueous solution of the other surfactant at 23°C is preferably 45 mN/m or less, more preferably 40 mN/m or less, and still more preferably 35 mN/m or less. The lower limit thereof is preferably 5 mN/m or more, more preferably 10 mN/m or more, and still more preferably 15 mN/m or more. The surface tension of the surfactant may be appropriately selected depending on the kind of other surfactants to be selected.

- Preservative and antifungal agent (preservative and like) -

A preferred aspect is also such that the interlayer contains a preservative or an antifungal agent.

It is preferable that the preservative and the antifungal agent (hereinafter, the preservative and the like) are an additive having an antibacterial or antifungal action, where they contain at least one selected from organic compounds which are water-soluble or water-dispersible. Examples of the additive having an antibacterial or antifungal action such as the preservative include an organic antibacterial agent or antifungal agent, an inorganic antibacterial agent or antifungal agent, and a natural antibacterial agent or antifungal agent. For example, as the antibacterial or antifungal agent, those described in "Antibacterial/Antifungal Technology" published by Toray Research Center, Inc. can be used.

In the present invention, in a case where the preservative and the like are blended in the interlayer, an effect of suppressing an increase in coating defects due to bacterial proliferation in the inside of a solution after long-term storage at room temperature is exhibited more effectively.

Examples of the preservative and the like include a phenol ether-based compound, an imidazole-based compound, a sulfone-based compound, an N-haloalkylthio compound, an anilide-based compound, a pyrrole-based compound, a quaternary ammonium salt, an arsine-based compound, a pyridine-based compound, a triazine-based compound, a benzisothiazoline-based compound, and an isothiazoline-based compound. Specific examples thereof include 2-(4-thiocyanomethyl)benzimidazole, 1,2-benzothiazolone, 1,2-benzisothiazoline-3-one, N-fluorodichloromethylthiophthalimide, 2,3,5,6-tetrachloroisophthalonitrile, N-trichloromethylthio-4-cyclohexene-1,2-dicarboxyimide, copper 8-quinolinate, bis(tributyltin)oxide, 2-(4-thiazolyl)benzimidazole, methyl 2-benzimidazolecarbamate, 10,10'-oxybisphenoxyarsine, 2,3,5,6-tetrachloro-4-(methylsulfone)pyridine, bis(2-pyridylthio-1-oxide) zinc, N,N-dimethyl-N'-(fluorodichloromethylthio)-N'-phenylsulfamide, poly-(hexamethylenebiguanide)hydroxychloride, dithio-2-2'-bis, 2-methyl-4,5-trimethylene-4-isothiazoline-3-one, 2-bromo-2-nitro-1,3-propanediol, hexahydro-1,3-tris-(2-hydroxyethyl)-S-triazine, p-chloro-m-xylenol, 1,2-benzisothiazoline-3-one, and methylphenol.

The natural antibacterial agent or antifungal agent is chitosan, which is a basic polysaccharide obtained by hydrolyzing chitin contained in the shell of a crab or shrimp. "Product name: Holon Killer Bead Cera" of Nippon Mining Holdings, Inc., which consists of an amino metal in which a metal is compounded on both sides of an amino acid is preferable.

The content of the preservative and the like in the interlayer is preferably 0.005% to 5% by mass, more preferably 0.01% to 3% by mass, still more preferably 0.05% to 2% by mass, and even still more preferably 0.1% to 1% by mass, with respect to the total mass of the interlayer. One kind of the preservative and the like may be used, or a plurality of kinds thereof may be used. In a case where a plurality of kinds thereof are used, the total amount thereof is within the above range.

The evaluation of the antibacterial effect of the preservative and the like can be carried out in accordance with JIS Z 2801 (Antibacterial products - Test for antibacterial activity and efficacy). In addition, the evaluation of the antifungal effect can be carried out in accordance with JIS Z 2911 (Methods of test for fungus resistance).

- Light shielding agent -

The interlayer may contain a light shielding agent. In a case of blending the light shielding agent, the influence of the damage to the organic layer or the like due to light is further suppressed.

As the light shielding agent, a known coloring agent or the like can be used, and examples thereof include organic or inorganic pigments or dyes. Preferred examples thereof include inorganic pigments, and among them, more preferred examples thereof include carbon black, titanium oxide, and titanium nitride.

The content of the light shielding agent is preferably 1% to 50% by mass, more preferably 3% to 40% by mass, and still more preferably 5 to 25% by mass, with respect to the total mass of the interlayer. One kind of the light shielding agent may be used, or a plurality of kinds thereof may be used. In a case where a plurality of kinds thereof are used,

the total amount thereof is within the above range.

- Composition for forming an interlayer -

The composition for forming an interlayer is a composition that is used for forming an interlayer, which is contained in a laminate that is used in the present invention.

It is preferable that the composition for forming an interlayer contains a polymer compound. In addition, the composition for forming an interlayer may contain the above-described surfactant containing an acetylene group, another surfactant, a preservative, an antifungal agent, a light shielding agent, and the like.

Among these, the composition for forming an interlayer preferably contains a water-soluble resin and a surfactant. In addition, the above-described surfactant may be the above-described surfactant containing an acetylene group or the above-described other surfactant; however, it is preferably the surfactant containing an acetylene group.

Regarding the contents of the components contained in the composition for forming an interlayer, it is preferable that the content of each of the above-described components with respect to the total mass of the interlayer may be read as the content with respect to the solid content amount of the composition for forming an interlayer.

In addition, the composition for forming an interlayer preferably contains a solvent described later.

In the laminate that is used in the present invention, the interlayer can be formed, for example, by applying a composition for forming an interlayer onto an organic layer and carrying out drying.

As an application method for the composition for forming an interlayer, coating is preferable. Examples of the application method include a slit coating method, a casting method, a blade coating method, a wire bar coating method, a spray coating method, a dipping (immersion) coating method, a bead coating method, an air knife coating method, a curtain coating method, an ink jet method, a spin coating method, and a Langmuir-Blodgett (LB) method. It is still more preferable to use a casting method, a spin coating method, or an ink jet method. Such a process makes it possible to produce an interlayer having a smooth surface and a large area at a low cost.

In addition, the composition for forming an interlayer can also be formed by a method of transferring a coating film, which is formed in advance on a temporary support by the above-described application method or the like, onto an application target (for example, an organic layer).

Regarding the transfer method, the description in paragraphs 0023 and 0036 to 0051 of JP2006-023696A and paragraphs 0096 to 0108 of JP2006-047592A can be referenced.

Examples of the solvent contained in the composition for forming an interlayer include the above-described aqueous solvent, where water or a mixture of water and a water-soluble solvent is preferable, and water is more preferable.

In a case where the aqueous solvent is a mixed solvent, it is preferably a mixed solvent of an organic solvent having a solubility in water at 23°C of 1 g or more and water. The solubility of the organic solvent in water at 23°C is more preferably 10 g or more and still more preferably 30 g or more.

In addition, in a case where the polymer compound contained in the composition for forming an interlayer is the resin containing a fluorine atom described above or the polymer compound containing a fluorine atom described above, a fluorine-based solvent can also be used as the solvent.

The fluorine-based solvent is an organic solvent containing a fluorine atom.

The fluorine atom content in the fluorine-based solvent that is used in the present invention is preferably 10% to 80%, more preferably 15% to 75%, and still more preferably 20% to 70%. Here, the fluorine atom content is indicated by (the number of fluorine atoms constituting the fluorine-based solvent/the number of all atoms constituting the fluorine solvent) $\times$ 100 (%).

The boiling point of the fluorine-based solvent that is used in the present invention is preferably, at 101,325 Pa, 40°C to 250°C, more preferably 50°C to 200°C, and still more preferably 55°C to 180°C.

The fluorine-based solvent is preferably an alcohol and more preferably an alcohol consisting of an alkyl group and an OH group substituted with at least one fluorine atom. In a case of using an alcohol, it is possible to easily dissolve a resin having polarity and not containing a fluorine atom, such as a resin A1. The alkyl group substituted with at least one fluorine atom preferably has 1 to 18 carbon atoms, more preferably 1 to 12 carbon atoms, and still more preferably 1 to 10 carbon atoms. The alkyl group substituted with at least one fluorine atom preferably has 1 to 30 fluorine atoms, more preferably 3 to 20 fluorine atoms, and still more preferably 4 to 12 fluorine atoms.

Specific examples of the fluorine-based solvent include 2,2,3,3-tetrafluoro-1-propanol, 2,2,3,3,4,4,5,5-octafluoro-1-pentanol, 2,2,3,3,3-pentafluoro-1-propanol, 1,1,1,3,3,3 -hexafluoro-2-propanol, 2,2,3,3,4,4,4-heptafluoro-1-butanol, 1H,1H,7H-dodecafluoro-1-heptanol, nonafluorobutyl ethyl ether, and perfluorotributylamine.

From the viewpoint that it is easy to apply the composition for forming an interlayer to a thickness closer to the uniform at the time of application, the solid content concentration of the composition for forming an interlayer is preferably 0.5% to 30% by mass, more preferably 1.0% to 20% by mass, and still more preferably 2.0% to 14% by mass.

[Resist layer]

The laminate that is used in the present invention includes a resist layer.

In the present invention, the resist layer is a layer that is subjected to development using a developer.

The development is preferably a negative tone development.

As the resist layer, a known resist layer (for example, a photoresist layer) that is used in the present technical field can be appropriately used.

In the laminate that is used in the present invention, the resist layer may be a negative tone resist layer or a positive tone resist layer.

It is preferable that the exposed portion of the resist layer is poorly soluble in a developer containing an organic solvent. "Poorly soluble" means that the exposed portion is hardly soluble in a developer.

It is preferable that the dissolution rate of the resist layer in a developer in the exposed portion is low (poorly soluble) as compared with the dissolution rate of the resist layer in the developer in the unexposed portion.

Specifically, in a case where exposure is carried out with light having at least one wavelength of a wavelength of 365 nm (the i-line), a wavelength of 248 nm (the KrF ray), or a wavelength of 193 nm (the ArF ray) at an irradiation amount of 50 $mJ/cm^2$ or more to change polarity, it is preferable to be poorly soluble in a solvent having an sp value (a solubility parameter) of less than 19.0 $(MPa)^{1/2}$, it is more preferable to be poorly soluble in a solvent having an sp value of 18.5 $(MPa)^{1/2}$ or less, and it is still more preferable to be poorly soluble in a solvent having an sp value of 18.0 $(MPa)^{1/2}$ or less.

In the present invention, the solubility parameter (the sp value) is a value [unit: $(MPa)^{1/2}$] determined according to the Okitsu method. The Okitsu method is one of the well-known methods of calculating the sp value in the related art, which is a method described in detail, for example, in the Journal of the Adhesion Society of Japan, Vol, 29, No. 6 (1993), pages 249 to 259.

Further, in a case where exposure is carried out with light having at least one wavelength of a wavelength of 365 nm (the i-line), a wavelength of 248 nm (the KrF ray), or a wavelength of 193 nm (the ArF ray) at an irradiation amount of 50 to 250 $mJ/cm^2$, it is more preferable that the polarity changes as described above.

The resist layer preferably has a photosensitive activity to the i-line irradiation.

The photosensitive activity refers to that the dissolution rate in an organic solvent (preferably, butyl acetate) changes upon irradiation with at least one of the actinic ray or the radiation (the irradiation with the i-line in a case where the photosensitive activity is obtained with respect to the i-line irradiation).

Examples of the resist layer include a resist layer including a resin (hereinafter, also referred to as a "specific resin for a resist layer") of which the dissolution rate in a developer changes by the action of an acid.

The change in the dissolution rate in the specific resin for a resist layer is preferably a decrease in the dissolution rate.

The dissolution rate of the specific resin for a resist layer in an organic solvent having an sp value of 18.0 $(MPa)^{1/2}$ or less before the dissolution rate changes is more preferably 40 nm/sec or more.

The dissolution rate of the specific resin for a resist layer in an organic solvent having an sp value of 18.0 $(MPa)^{1/2}$ or less after the dissolution rate has changed is more preferably less than 1 nm/sec.

In addition, the specific resin for a resist layer is preferably such a resin that is soluble in an organic solvent having an sp value (a solubility parameter) of 18.0 $(MPa)^{1/2}$ or less before the dissolution rate changes and is poorly soluble in an organic solvent having an sp value of 18.0 $(MPa)^{1/2}$ or less after the dissolution rate has changed.

Here, "soluble in an organic solvent having an sp value (a solubility parameter) of 18.0 $(MPa)^{1/2}$ or less" refers to that a dissolution rate of a coating film (thickness: 1 $\mu$m) of a compound (a resin) formed by applying a solution of the compound (the resin) onto a base material and carrying out heating at 100°C for 1 minute in a case of being immersed in a developer at 23°C is 20 nm/sec or more, and "poorly soluble in an organic solvent having an sp value of 18.0 $(MPa)^{1/2}$ or less" refers to that a dissolution rate of a coating film (thickness: 1 $\mu$m) of a compound (a resin) formed by applying a solution of the compound (the resin) onto a base material and carrying out heating at 100°C for 1 minute, in a developer at 23°C, is less than 10 nm/sec.

Examples of the resist layer include a resist layer containing the specific resin for a resist layer and a photoacid generator and a resist layer containing a polymerizable compound, a photopolymerization initiator, and the like.

In addition, from the viewpoint of achieving both high storage stability and fine pattern formation properties, the resist layer is preferably a chemical amplification type resist layer.

Hereinafter, an example of the resist layer containing the specific resin for a resist layer and a photoacid generator will be described.

- Specific resin for resist layer -

The resist layer in the present invention preferably contains the specific resin for a resist layer.

The specific resin for a resist layer is preferably an acrylic polymer.

The "acrylic polymer" is an addition polymerization type resin and is a polymer containing a repeating unit derived from (meth)acrylic acid or an ester thereof, and it may contain a repeating unit other than the repeating unit derived from (meth)acrylic acid or an ester thereof, for example, a repeating unit derived from styrene or a repeating unit derived from a vinyl compound. The acrylic polymer preferably contains 50% by mole or more of a repeating unit derived from (meth)acrylic acid or an ester thereof and more preferably 80% by mole or more of thereof with respect to all the repeating units in the polymer, and it is particularly preferably a polymer consisting of only a repeating unit derived from (meth)acrylic acid or an ester thereof.

Preferred examples of the specific resin for a resist layer include a resin having a repeating unit having a structure in which an acid group is protected by an acid-decomposable group.

Examples of the structure in which the acid group is protected by an acid-decomposable group include a structure in which a carboxy group is protected by an acid-decomposable group and a structure in which a phenolic hydroxy group is protected by an acid-decomposable group.

In addition, examples of the repeating unit having a structure in which the acid group is protected by an acid-decomposable group include a repeating unit having a structure in which a carboxy group in a monomer unit derived from (meth)acrylic acid is protected by an acid-decomposable group and a repeating unit having a structure in which a phenolic hydroxy group in a monomer unit derived from hydroxystyrenes such as p-hydroxystyrene and α-methyl-p-hydroxystyrene is protected by an acid-decomposable group.

Examples of the repeating unit having a structure in which the acid group is protected by an acid-decomposable group include a repeating unit including an acetal structure, where a repeating unit including a cyclic ether ester structure in the side chain is preferable. In the cyclic ether ester structure, it is preferable that the oxygen atom in the cyclic ether structure and the oxygen atom in the ester bond are bonded to the same carbon atom to form an acetal structure.

In addition, the repeating unit having a structure in which the acid group is protected by an acid-decomposable group is preferably a repeating unit represented by Formula (1).

Hereinafter, the "repeating unit represented by Formula (1)" or the like is also referred to as the "repeating unit (1)".

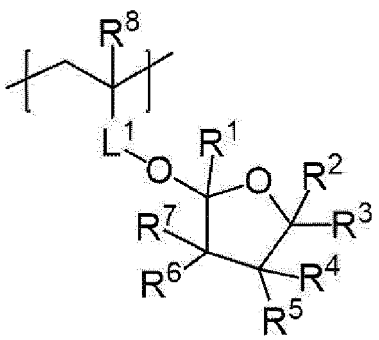

(1)

In Formula (1), $R^8$ represents a hydrogen atom or an alkyl group (preferably having 1 to 12 carbon atoms, more preferably 1 to 6 carbon atoms, and still more preferably 1 to 3 carbon atoms), $L^1$ represents a carbonyl group or a phenylene group, and $R^1$ to $R^7$ each independently represent a hydrogen atom or an alkyl group.

In Formula (1), $R^8$ is preferably a hydrogen atom or a methyl group and more preferably a methyl group.

In Formula (1), $L^1$ represents a carbonyl group or a phenylene group, and it is preferably a carbonyl group.

In Formula (1), $R^1$ to $R^7$ each independently represent a hydrogen atom or an alkyl group. The alkyl groups in $R^1$ to $R^7$ have the same meaning as $R^8$, and the same applies to the preferred aspects thereof. In addition, it is preferable that one or more of $R^1$ to $R^7$ are a hydrogen atom, and it is more preferable that all of $R^1$ to $R^7$ are a hydrogen atom.

The repeating unit (1) is preferably a repeating unit represented by Formula (1-A) or a repeating unit represented by Formula (1-B).

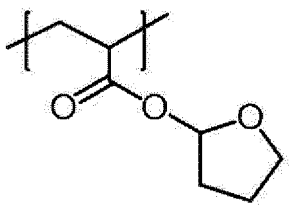

( 1−A)

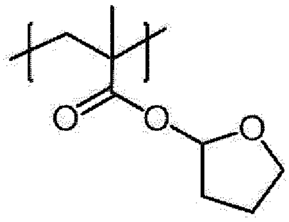

( 1−B)

As the radically polymerizable monomer that is used for forming the repeating unit (1), a commercially available one may be used, or one synthesized by a known method may be used. For example, it can be synthesized by reacting (meth)acrylic acid with a dihydrofuran compound in the presence of an acid catalyst. Alternatively, it can also be formed by reacting a carboxy group or a phenolic hydroxy group with a dihydrofuran compound after polymerization with a precursor monomer.

In addition, preferred examples of the repeating unit having a structure in which the acid group is protected by an acid-decomposable group also include a repeating unit represented by Formula (2).

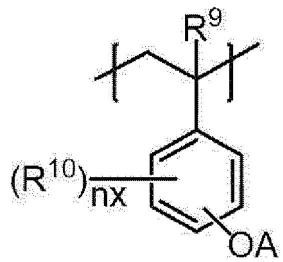

( 2)

In Formula (2), A represents a group that is eliminated by the action of a hydrogen atom or an acid. Among them, the group eliminated by the action of an acid is preferably an alkyl group (preferably having 1 to 12 carbon atoms, more preferably 1 to 6 carbon atoms, and still more preferably 1 to 3 carbon atoms), an alkoxyalkyl group (preferably having 2 to 12 carbon atoms, more preferably 2 to 6 carbon atoms, and still more preferably 2 or 3 carbon atoms), an aryloxyalkyl group (preferably having 7 to 40 carbon atoms, more preferably 7 to 30 carbon atoms, and still more preferably 7 to 20 carbon atoms in terms of the total number of carbon atoms), an alkoxycarbonyl group (preferably having 2 to 12 carbon atoms, more preferably 2 to 6 carbon atoms, and still more preferably 2 or 3 carbon atoms), or an aryloxycarbonyl group (preferably having 7 to 23 carbon atoms, more preferably 7 to 19 carbon atoms, and still more preferably 7 to 11 carbon atoms). A may further have a substituent, and examples of the substituent T include the examples of the substituent.

In Formula (2), $R^{10}$ represents a substituent, and examples thereof include the examples of the substituent T. $R^9$ represents a group having the same meaning as $R^8$ in Formula (1).

In Formula (2), nx represents an integer of 0 to 3.

The group that is eliminated by the action of an acid is also preferably a repeating unit containing a group that is eliminated by an acid, among the compounds described in paragraph numbers 0039 to 0049 of JP2008-197480A, and also preferably the compounds described in paragraph numbers 0052 to 0056 of JP2012-159830A (JP5191567B), the contents of which are incorporated in the present specification.

Specific examples of the repeating unit (2) are shown below; however, the present invention is not construed as being limited thereto.

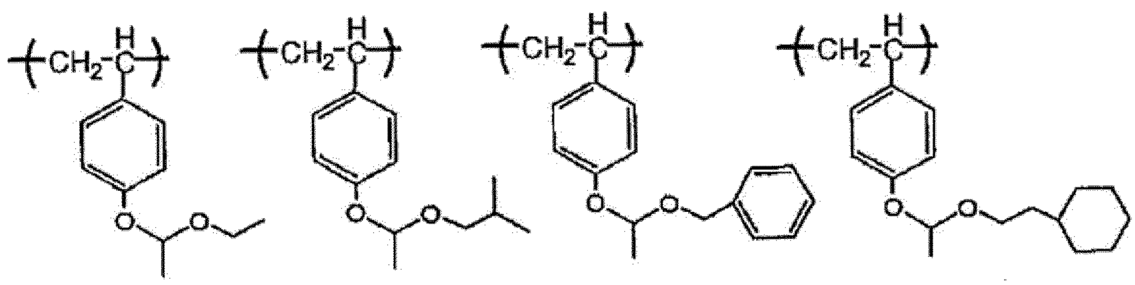

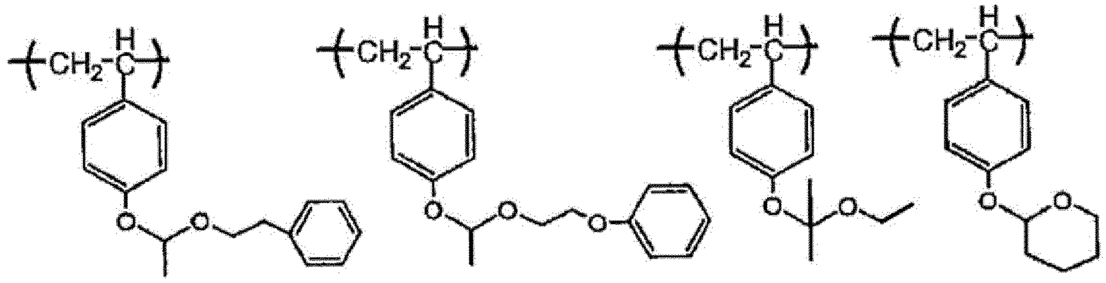

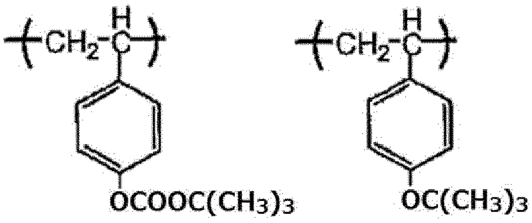

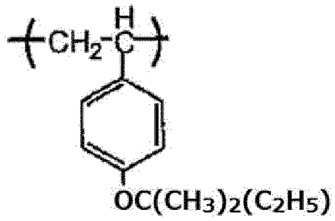

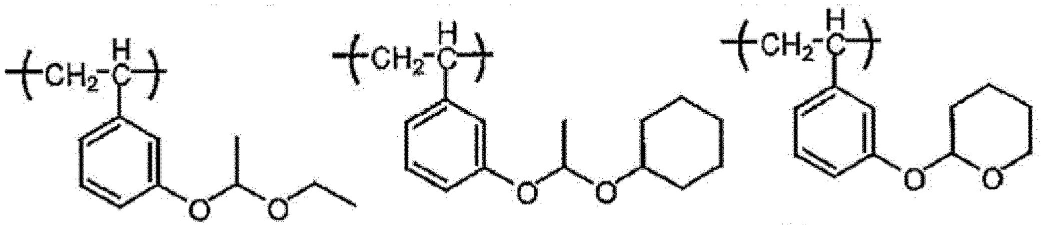

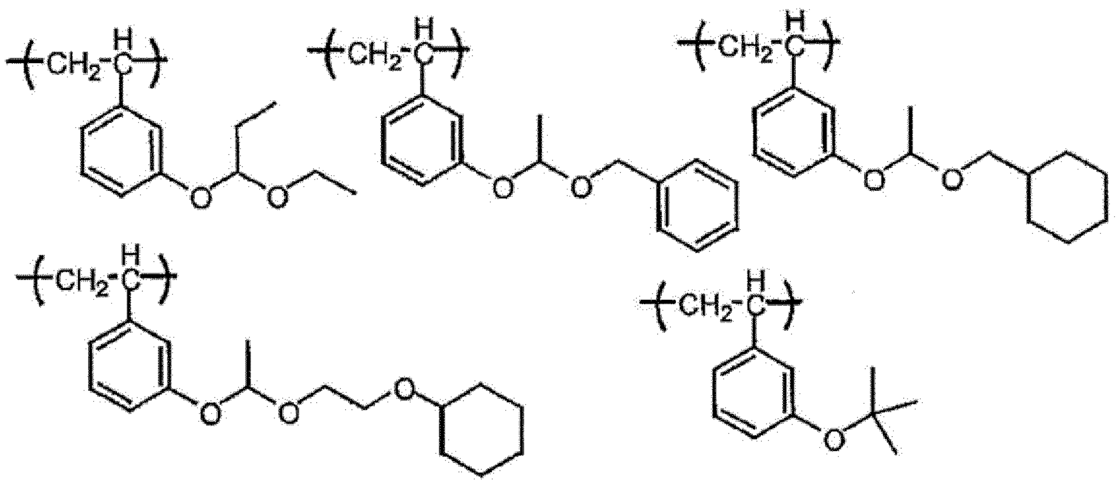

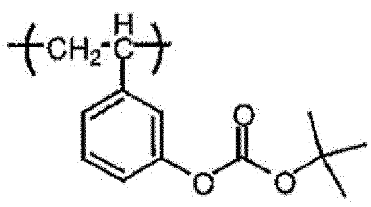

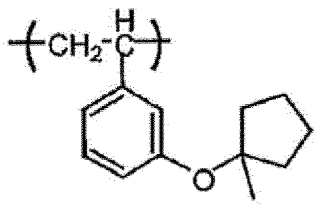

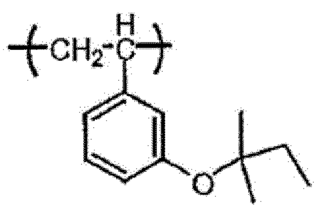

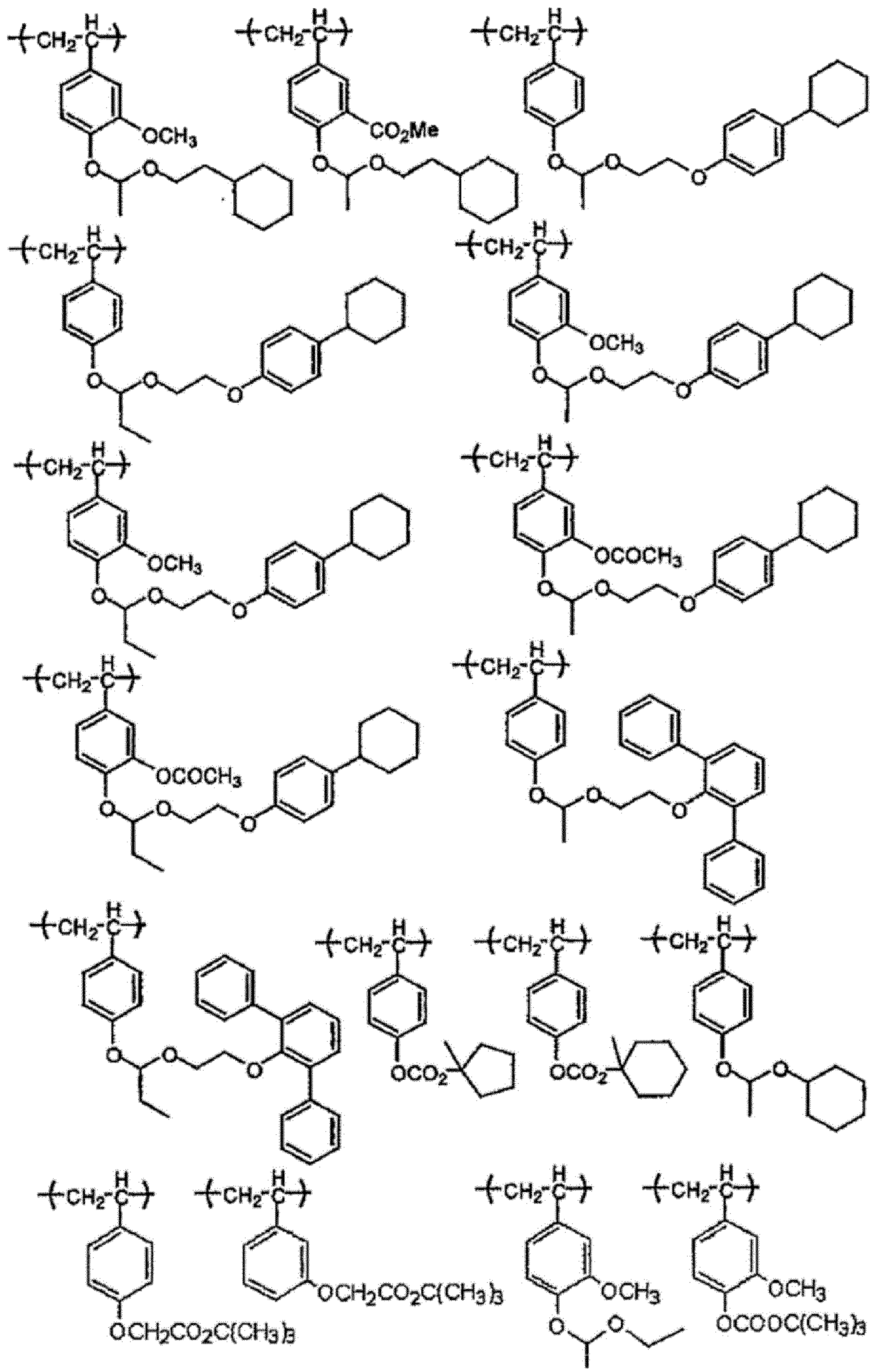

The content of the repeating unit (preferably, the repeating unit (1) or the repeating unit (2)) having a structure

in which the acid group is protected by an acid-decomposable group, which is contained in the specific resin for a resist layer, is preferably 5% to 80% by mole, more preferably 10% to 70% by mole, and still more preferably 10% to 60% by mole. The acrylic polymer may contain only one kind of the repeating unit (1) or repeating unit (2) or may contain two or more kinds of thereof. In a case where two or more kinds thereof are used, the total amount is preferably within the above-described range.

The specific resin for a resist layer may contain a repeating unit containing a crosslinkable group. For details of the crosslinkable group, the description in paragraph numbers 0032 to 0046 of JP2011-209692A can be referred to, the content of which is incorporated in the present specification.

Although the specific resin for a resist layer preferably has an aspect in which a repeating unit (a repeating unit (3)) containing a crosslinkable group is contained, a configuration substantially free of the repeating unit (3) containing a crosslinkable group is preferably adopted. With such a configuration, the resist layer can be removed more effectively after the patterning. Here, "substantially free" refers to, for example, 3% by mole or less of all the repeating units of the specific resin for a resist layer, and preferably refers to 1% by mole or less thereof.

The specific resin for a resist layer may contain another repeating unit (a repeating unit (4)). Examples of the radically polymerizable monomer that is used for forming the repeating unit (4) include the compounds described in paragraph numbers 0021 to 0024 of JP2004-264623A. Preferred examples of the repeating unit (4) include a repeating unit derived from at least one selected from the group consisting of a hydroxy group-containing unsaturated carboxylic acid ester, an alicyclic structure-containing unsaturated carboxylic acid ester, styrene, and an N-substituted maleimide. Among these, alicyclic structure-containing (meth)acrylic acid esters such as benzyl (meth)acrylate, tricyclo[5.2.1.$0^{2,6}$]decane-8-yl (meth)acrylate, tricyclo[5.2.1.$0^{2,6}$]decane-8-yl-oxyethyl (meth)acrylate, isobornyl (meth)acrylate, cyclohexyl (meth)acrylate, and 2-methylcyclohexyl (meth)acrylate, or a hydrophobic monomer such as styrene is preferable.

One kind of the repeating unit (4) can be used, or two or more kinds thereof can be used in combination. In a case where the repeating unit (4) is contained, the content of the monomer unit that forms the repeating unit (4) is preferably 1% to 60% by mole, more preferably 5% to 50% by mole, and still more preferably 5% to 40% by mole, in all the monomer units constituting the specific resin for a resist layer. In a case where two or more kinds thereof are used, the total amount is preferably within the above-described range.

Various methods are known for the method of synthesizing the specific resin for a resist layer, which can be synthesized, for example, by polymerizing a radically polymerizable monomer mixture containing a radically polymerizable monomer that is used for forming at least the repeating unit (1), the repeating unit (2), and the like, in an organic solvent by using a radical polymerization initiator.

The specific resin for a resist layer is also preferably a copolymer which is obtained by adding 2,3-dihydrofuran to an acid anhydride group in a precursor copolymer copolymerized with unsaturated polyvalent carboxylic acid anhydrides at a temperature of room temperature (25°C) to about 100°C in the absence of an acid catalyst.

Preferred examples of the specific resin for a resist layer also include the following resins.

BzMA/THFMA/t-BuMA (molar ratio: 20 to 60:35 to 65:5 to 30)
BzMA/THFAA/t-BuMA (molar ratio: 20 to 60:35 to 65:5 to 30)
BzMA/THPMA/t-BuMA (molar ratio: 20 to 60:35 to 65:5 to 30)
BzMA/PEES/t-BuMA (molar ratio: 20 to 60:35 to 65:5 to 30)
BzMAis benzyl methacrylate, THFMA is tetrahydrofuran-2-yl methacrylate, t-BuMA is t-butyl methacrylate, THFAA is tetrahydrofuran-2-yl acrylate, THPMA is tetrahydro-2H-pyran-2-yl methacrylate, and PEES is p-ethoxyethoxystyrene.

In addition, examples of the specific resin for a resist layer that is used in the positive tone development include those described in JP2013-011678A, the content of which is incorporated in the present specification.

From the viewpoint of improving the pattern formation properties at the time of development, the content of the specific resin for a resist layer is preferably 20% to 99% by mass, more preferably 40% to 99% by mass, and still more preferably 70% to 99% by mass, with respect to the total mass of the resist layer. Only one kind or two or more kinds of the specific resin for a resist layer may be contained. In a case where two or more kinds thereof are used, the total amount is preferably within the above-described range.

In addition, the content of the specific resin for a resist layer is preferably 10% by mass or more, more preferably 50% by mass or more, and still more preferably 90% by mass or more, with respect to the total mass of the resin components contained in the resist layer.

The weight-average molecular weight of the specific resin for a resist layer is preferably 10,000 or more, more preferably 20,000 or more, and still more preferably 35,000 or more. The upper limit value thereof is not particularly limited; however, it is preferably 100,000 or less, and it may be set to 70,000 or less or may be set to 50,000 or less.

In addition, the amount of the component having a weight-average molecular weight of 1,000 or less, which is contained in the specific resin for a resist layer, is preferably 10% by mass or less and more preferably 5% by mass or

less with respect to the total mass of the specific resin for a resist layer.

The molecular weight dispersion (the weight-average molecular weight/the number-average molecular weight) of the specific resin for a resist layer is preferably 1.0 to 4.0 and more preferably 1.1 to 2.5.

- Photoacid generator -

The resist layer preferably further contains a photoacid generator.

The photoacid generator is preferably a photoacid generator that decomposes by 80% by mole or more at a wavelength of 365 nm in a case where the resist layer is exposed at an exposure amount of 100 mJ/cm$^2$.

The degree of decomposition of the photoacid generator can be determined according to the following method. The details of the following composition for forming a resist layer will be described later.

Using the composition for forming a resist layer, a film of a resist layer is formed on a silicon wafer substrate, heated at 100°C for 1 minute, and then after the heating, the resist layer is exposed using light having a wavelength of 365 nm at an exposure amount of 100 mJ/cm$^2$. The thickness of the resist layer after the heating is set to 700 nm. Then, the silicon wafer substrate on which the resist layer has been formed is immersed in a solution of methanol/tetrahydrofuran (THF) = 50/50 (mass ratio) for 10 minutes while applying an ultrasonic wave. After the immersion, an extract extracted into the above solution is analyzed by using high performance liquid chromatography (HPLC), and then the decomposition rate of the photoacid generator is calculated according to the following expression.

$$\text{Decomposition rate (\%)} = \text{amount of decomposition product (mol)/amount of photoacid generator contained in resist layer before exposure (mol)} \times 100$$

It is preferable that the photoacid generator decomposes by 85% by mole or more at a wavelength of 365 nm in a case where the resist layer is exposed at an exposure amount of 100 mJ/cm$^2$.

- Oxime sulfonate compound -

The photoacid generator is preferably a compound containing an oxime sulfonate group (hereinafter, also simply referred to as an "oxime sulfonate compound").

The oxime sulfonate compound is not particularly limited as long as it has an oxime sulfonate group; however, it is preferably an oxime sulfonate compound represented by Formula (OS-1) below, Formula (OS-103), Formula (OS-104), or Formula (OS-105) described later.

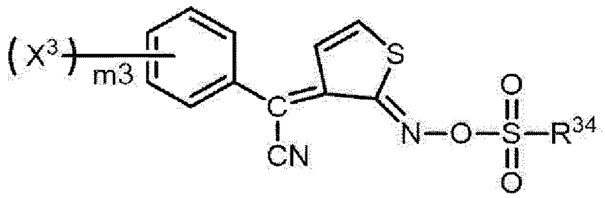
(OS-1)

In Formula (OS-1), X$^3$ represents an alkyl group, an alkoxyl group, or a halogen atom. In a case where a plurality of X$^3$'s are present, they may be the same or different from each other. The alkyl group and the alkoxyl group as X$^3$ may have a substituent. The alkyl group as X$^3$ is preferably a linear or branched alkyl group having 1 to 4 carbon atoms. The alkoxyl group as X$^3$ is preferably a linear or branched alkoxyl group having 1 to 4 carbon atoms. The halogen atom as X$^3$ is preferably a chlorine atom or a fluorine atom.

In Formula (OS-1), m3 represents an integer of 0 to 3, and it is preferably 0 or 1. In a case where m3 is 2 or 3, the plurality of X$^3$'s may be the same or different from each other.

In Formula (OS-1), R$^{34}$ represents an alkyl group or an aryl group, and it is preferably an alkyl group having 1 to 10 carbon atoms, an alkoxyl group having 1 to 10 carbon atoms, a halogenated alkyl group having 1 to 5 carbon atoms, a halogenated alkoxyl group having 1 to 5 carbon atoms, a phenyl group which may be substituted with W, a naphthyl group which may be substituted with W, or an anthranyl group which may be substituted with W. W represents a halogen atom, a cyano group, a nitro group, an alkyl group having 1 to 10 carbon atoms, an alkoxyl group having 1 to 10 carbon atoms, a halogenated alkyl group having 1 to 5 carbon atoms or a halogenated alkoxyl group having 1 to 5 carbon atoms, an aryl group having 6 to 20 carbon atoms, or a halogenated aryl group having 6 to 20 carbon atoms.

A compound represented by Formula (OS-1), in which m3 is 3, X$^3$ is a methyl group, the substitution position

of $X^3$ is the ortho position, and $R^{34}$ is a linear alkyl group having 1 to 10 carbon atoms, a 7,7-dimethyl-2-oxonorbornylmethyl group, or a p-tolyl group is particularly preferable.

Specific examples of the oxime sulfonate compound represented by Formula (OS-1) include the following compounds described in paragraph numbers 0064 to 0068 of JP2011-209692A and paragraph numbers 0158 to 0167 of JP2015-194674A, the contents of which are incorporated in the present specification.

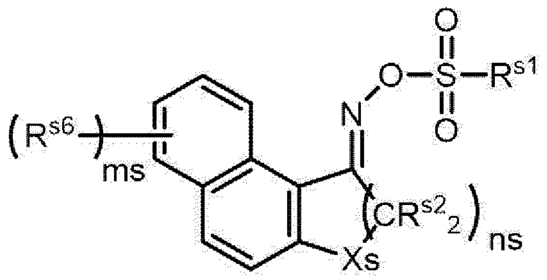

(OS-103)

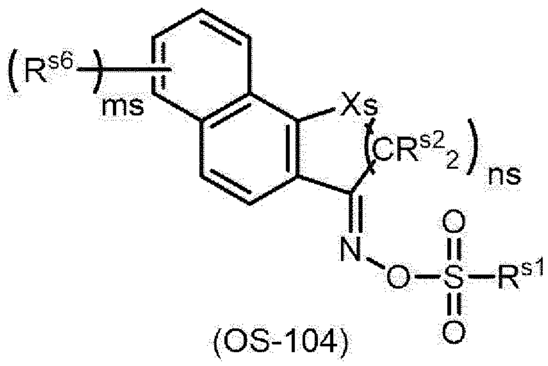

(OS-104)

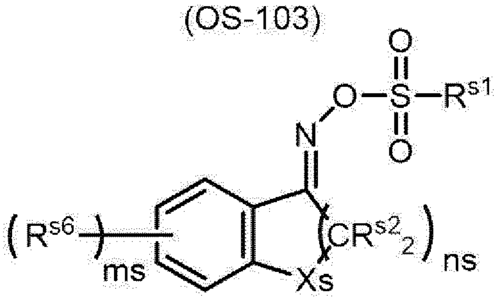

(OS-105)

In Formulae (OS-103) to (OS-105), $R^{s1}$ represents an alkyl group, an aryl group, or a heteroaryl group, $R^{s2}$'s in a case of being present in plurality each independently represent a hydrogen atom, an alkyl group, an aryl group, or a halogen atom, $R^{s6}$'s in a case of being present in plurality each independently represent a halogen atom, an alkyl group, an alkyloxy group, a sulfonate group, an aminosulfonyl group, or an alkoxysulfonyl group, Xs represents O or S, ns represents 1 or 2, and ms represents an integer of 0 to 6.

In Formulae (OS-103) to (OS-105), an alkyl group (preferably having 1 to 30 carbon atoms) represented by $R^{s1}$, an aryl group (preferably having 6 to 30 carbon atoms), or a heteroaryl group (preferably having 4 to 30 carbon atoms) may have a substituent T.

In Formulae (OS-103) to (OS-105), $R^{s2}$ is preferably a hydrogen atom, an alkyl group (preferably having 1 to 12 carbon atoms), or an aryl group (preferably having 6 to 30 carbon atoms), and more preferably a hydrogen atom or an alkyl group. Among $R^{s2}$'s in a case where two or more thereof are present in the compound, it is preferable that one or two thereof are an alkyl group, an aryl group, or a halogen atom, it is more preferable that one thereof is an alkyl group, an aryl group, or a halogen atom, and it is particularly preferable that one thereof is an alkyl group and the rest thereof is a hydrogen atom. The alkyl group or aryl group represented by $R^{s2}$ may have the substituent T.

In Formula (OS-103), Formula (OS-104), or Formula (OS-105), Xs represents O or S, and it is preferably O. In Formulae (OS-103) to (OS-105), the ring containing Xs as a ring member is a 5-membered ring or a 6-membered ring.

In Formulae (OS-103) to (OS-105), ns represents 1 or 2, and in a case where Xs is O, ns is preferably 1, and in a case where Xs is S, ns is preferably 2.

In Formulae (OS-103) to (OS-105), the alkyl group (preferably having 1 to 30 carbon atoms) and the alkyloxy group (preferably having 1 to 30 carbon atoms), which are represented by $R^{s6}$, may have a substituent.

In the Formulae (OS-103) to (OS-105), ms represents an integer of 0 to 6, and it is preferably an integer of 0 to 2, more preferably 0 or 1, and particularly preferably 0.

In addition, the compound represented by Formula (OS-103) is particularly preferably a compound represented by Formula (OS-106), Formula (OS-110), or Formula (OS-111), the compound represented by Formula (OS-104) is particularly preferably a compound represented by Formula (OS-107), and the compound represented by Formula (OS-105) is particularly preferably a compound represented by Formula (OS-108) or Formula (OS-109).

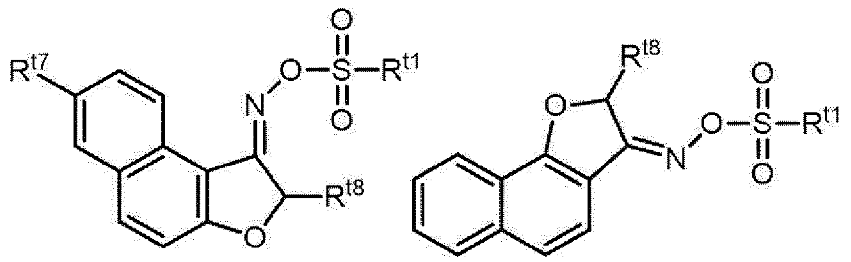

( OS-106) ( OS-107)

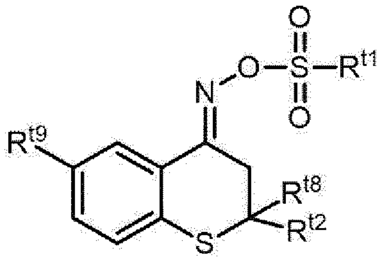

( OS-108)

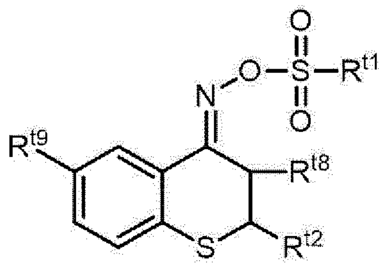

( OS-109)

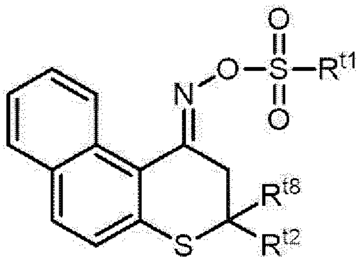

( OS-110)

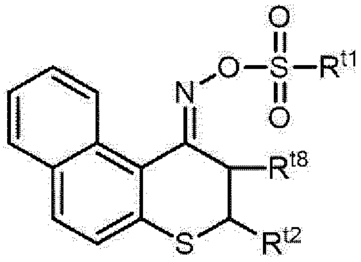

( OS-111)

In Formulae (OS-106) to (OS-111), $R^{t1}$ represents an alkyl group, an aryl group, or a heteroaryl group, $R^{t7}$ represents a hydrogen atom or a bromine atom, $R^{t8}$ represents a hydrogen atom, an alkyl group having 1 to 8 carbon atoms, a halogen atom, a chloromethyl group, a bromomethyl group, a bromoethyl group, a methoxymethyl group, a phenyl group, or a chlorophenyl group, $R^{t9}$ represents a hydrogen atom, a halogen atom, a methyl group, or a methoxy group, and $R^{t2}$ represents a hydrogen atom or a methyl group.

In Formulae (OS-106) to (OS-111), $R^{t7}$ represents a hydrogen atom or a bromine atom, and it is preferably a hydrogen atom.

In Formulae (OS-106) to (OS-111), $R^{t8}$ represents a hydrogen atom, an alkyl group having 1 to 8 carbon atoms, a halogen atom, a chloromethyl group, a bromomethyl group, a bromoethyl group, a methoxymethyl group, a phenyl group, or a chlorophenyl group, and it is preferably an alkyl group having 1 to 8 carbon atoms, a halogen atom or a phenyl group, more preferably an alkyl group having 1 to 8 carbon atoms, still more preferably an alkyl group having 1 to 6 carbon atoms, and particularly preferably a methyl group.

In Formulae (OS-106) to (OS-111), $R^{t9}$ represents a hydrogen atom, a halogen atom, a methyl group, or a methoxy group, and it is preferably a hydrogen atom.

$R^{t2}$ represents a hydrogen atom or a methyl group, and it is preferably a hydrogen atom.

In addition, in the above-described oxime sulfonate compound, the three-dimensional structure (E, Z) of the oxime may be any one or a mixture of E and Z.

Specific examples of the oxime sulfonate compounds represented by Formulae (OS-103) to (OS-105) include the compounds described in paragraph numbers 0088 to 0095 of JP2011-209692A and paragraph numbers 0168 to 0194 of JP2015-194674A, the contents of which are incorporated in the present specification.

Examples of suitable another aspect of the oxime sulfonate compound containing at least one oxime sulfonate group include compounds represented by Formulae (OS-101) and (OS-102).

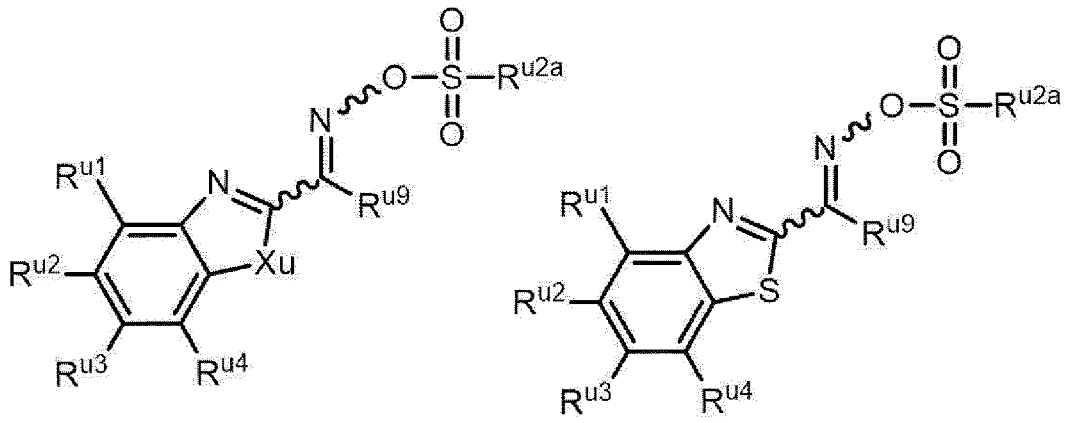

( OS-101) ( OS-102)

In Formula (OS-101) or Formula (OS-102), $R^{u9}$ represents a hydrogen atom, an alkyl group, an alkenyl group, an alkoxyl group, an alkoxycarbonyl group, an acyl group, a carbamoyl group, a sulfamoyl group, a sulfo group, a cyano group, an aryl group, or a heteroaryl group. An aspect in which $R^{u9}$ is a cyano group or an aryl group is more preferable, and an aspect in which $R^{u9}$ is a cyano group, a phenyl group, or a naphthyl group is still more preferable.

In Formula (OS-101) or Formula (OS-102), $R^{u2a}$ represents an alkyl group or an aryl group.

In Formula (OS-101) or Formula (OS-102), Xu represents -O-, -S-, -NH-, $-NR^{u5}-$, $-CH_2$ -, $-CR^{u6}H-$, or $CR^{u6}R^{u7}-$, and $R^{u5}$ to $R^{u7}$ each independently represent an alkyl group or an aryl group.

In Formula (OS-101) or Formula (OS-102), $R^{u1}$ to $R^{u4}$ each independently represent a hydrogen atom, a halogen atom, an alkyl group, an alkenyl group, an alkoxyl group, an amino group, an alkoxycarbonyl group, an alkylcarbonyl group, an arylcarbonyl group, an amide group, a sulfo group, a cyano group, or an aryl group. Two of $R^{u1}$ to $R^{u4}$ may be bonded to each other to form a ring. In this case, the ring may be fused to form a fused ring together with the benzene ring. $R^{u1}$ to $R^{u4}$ are preferably a hydrogen atom, a halogen atom, or an alkyl group, and an aspect in which at least two of $R^{u1}$ to $R^{u4}$ are bonded to each other to form an aryl group is also preferable. Among the above, an aspect in which all of $R^{u1}$ to $R^{u4}$ are a hydrogen atom is more preferable. Any one of the above-described substituents may further have a substituent.

The compound represented by Formula (OS-101) is more preferably a compound represented by Formula (OS-102).

In addition, in the above-described oxime sulfonate compound, the three-dimensional structure (E, Z, or the like) of the oxime or the benzothiazole ring may be each any one or a mixture of E, Z.

Specific examples of the compound represented by Formula (OS-101) include the compounds described in paragraph numbers 0102 to 0106 of JP2011-209692A and paragraph numbers 0195 to 0207 of JP2015-194674A, the contents of which are incorporated in the present specification.

Among the above compounds, b-9, b-16, b-31, or b-33 is preferable.

Examples of the commercially available product thereof include WPAG-336 (manufactured by FUJIFII,M Wako Pure Chemical Corporation), WPAG-443 (manufactured by FUJIFII,M Wako Pure Chemical Corporation), and MBZ-101 (manufactured by Midori Kagaku Co., Ltd.).

It is preferable that the photoacid generator that sensitively responds to the actinic ray does not contain the 1,2-quinonediazide compound. This is due to the reason that although the 1,2-quinonediazide compound generates a carboxy group by a sequential photochemical reaction, the quantum yield thereof is 1 or less, and the sensitivity is low as compared with the oxime sulfonate compound.

On the other hand, in the oxime sulfonate compound, since an acid generated in a sensitive response to the actinic ray acts as a catalyst for the deprotection of the protected acid group, it is presumed that the acid generated by the action of one photon contributes to a large number of deprotection reactions, the quantum yield exceeds 1 and becomes, for example, a large value such as some power of ten, and high sensitivity is obtained as a result of so-called chemical amplification.

In addition, due to having a broad $\pi$-conjugated system, the oxime sulfonate compound has absorption up to the long wavelength side and thus exhibits high sensitivity not only in the far ultraviolet ray (DUV), the ArF ray, the KrF ray, and the i-line, but also in the g-line.

In a case of using a tetrahydrofuranyl group as the acid-decomposable group in the resist layer, it is possible to obtain acid-decomposability which is comparable to or equal to or higher than that of an acetal or a ketal. This makes it possible to reliably consume the acid-decomposable group in the post-baking in a shorter time. Furthermore, in a case

of using an oxime sulfonate compound in combination which is a photoacid generator, the generation rate of the sulfonic acid is increased, and thus the generation of the acid is promoted and the decomposition of the acid-decomposable group of the resin is promoted. In addition, since the acid obtained by the decomposition of the oxime sulfonate compound is a sulfonic acid having a small molecule, it has high diffusibility in a cured film and can be made more sensitive.

Regarding the amount of the photoacid generator with respect to the total mass of the resist layer, 0.1% to 20% by mass is preferably used, 0.5% to 18% by mass is more preferably used, 0.5% to 10% by mass is still more preferably used, 0.5% to 3% by mass is even still more preferably used, and 0.5 to 1.2% by mass is even further still more preferably used.

One kind of photoacid generator may be used alone, or two or more kinds thereof may be used in combination. In a case where two or more kinds thereof are used, the total amount is preferably within the above-described range.

- Basic compound -

The resist layer preferably contains a basic compound from the viewpoint of the liquid storage stability of the composition for forming a resist layer described later.

As the basic compound, any known basic compound can be selected and used among those that are used in the chemically amplified resist. Examples thereof include an aliphatic amine, an aromatic amine, a heterocyclic amine, a quaternary ammonium hydroxide, and a quaternary ammonium salt of a carboxylic acid.

Examples of the aliphatic amine include trimethylamine, diethylamine, triethylamine, di-n-propylamine, tri-n-propylamine, di-n-pentylamine, tri-n-pentylamine, diethanolamine, triethanolamine, dicyclohexylamine, and dicyclohexylmethylamine.

Examples of the aromatic amine include aniline, benzylamine, N,N-dimethylaniline, and diphenylamine.

Examples of the heterocyclic amine include pyridine, 2-methylpyridine, 4-methylpyridine, 2-ethylpyridine, 4-ethylpyridine, 2-phenylpyridine, 4-phenylpyridine, N-methyl-4-phenylpyridine, 4-dimethylaminopyridine, imidazole, benzimidazole, 4-methylimidazole, 2-phenylbenzimidazole, 2,4,5-triphenylimidazole, nicotine, nicotinic acid, a nicotinic acid amide, quinoline, 8-oxyquinoline, pyrazine, pyrazole, pyridazine, purine, pyrrolidine, piperidine, cyclohexylmorpholinoethyl thiourea, piperazine, morpholine, 4-methylmorpholine, 1,5-diazabicyclo[4.3.0]-5-nonene, and 1,8-diazabicyclo[5.3.0]-7-undecene.

Examples of the quaternary ammonium hydroxide include tetramethylammonium hydroxide, tetraethylammonium hydroxide, tetra-n-butylammonium hydroxide, and tetra-n-hexylammonium hydroxide.

Examples of the quaternary ammonium salt of the carboxylic acid include tetramethylammonium acetate, tetramethylammonium benzoate, tetra-n-butylammonium acetate, and tetra-n-butylammonium benzoate.

In a case where the resist layer contains a basic compound, the content of the basic compound is preferably 0.001 to 1 part by mass and more preferably 0.002 to 0.5 parts by mass with respect to 100 parts by mass of the specific resin for a resist layer.

One kind of basic compound may be used alone, or two or more kinds thereof may be used in combination; however, it is preferable that two or more kinds thereof are used in combination, it is more preferable that two kinds thereof are used in combination, and it is still more preferable that two kinds of heterocyclic amines are used in combination. In a case where two or more kinds thereof are used, the total amount is preferably within the above-described range.

- Surfactant -

The resist layer preferably contains a surfactant from the viewpoint of improving the coatability of the composition for forming a resist layer described later.

As the surfactant, any one of an anionic, a cationic, a nonionic, or an amphoteric surfactant can be used; however, the preferred surfactant is a nonionic surfactant.

Examples of the nonionic surfactant include polyoxyethylene higher alkyl ethers, polyoxyethylene higher alkyl phenyl ethers, polyoxyethylene glycol higher fatty acid diesters, fluorine-based surfactants, and silicone-based surfactants.

The surfactant more preferably includes a fluorine-based surfactant or a silicone-based surfactant.

Examples of the fluorine-based surfactant or the silicone-based surfactant include the surfactants described in JP1987-036663A (JP-S62-036663A), JP1986-226746A (JP-S61-226746A), JP1986-226745A (JP-S61-226745A), JP1987-170950A (JP-S62-170950A), JP1988-034540A (JP-S63-034540A), JP1995-230165A (JP-H07-230165A), JP1996-062834A (JP-H08-062834A), JP1997-054432A (JP-H09-054432A), JP1997-005988A (JP-H09-005988A), and JP2001-330953A, respectively, and a commercially available surfactant can also be used.

Examples of the commercially available surfactant that can be used include fluorine-based surfactants or silicone-based surfactants, such as F-top EF301 and EF303 (all, manufactured by Shin-Akita Kasei Co., Ltd.), Florard FC430 and 431 (all, manufactured by Sumitomo 3M Limited), MEGAFACE F171, F173, F176, F189, and R08 (all,

manufactured by DIC Corporation), Surflon S-382, SC101, 102, 103, 104, 105, and 106 (all, manufactured by AGC SEIMI CHEMICAL Co., Ltd.), and a PolyFox series such as PF-6320 (manufactured by OMNOVA Solutions Inc.). In addition, a polysiloxane polymer KP-341 (manufactured by Shin-Etsu Chemical Co., Ltd.) can also be used as the silicone-based surfactant.

Further, preferred examples of the surfactant include a copolymer containing a repeating unit A and a repeating unit B represented by Formula (41) and having a polystyrene-equivalent weight-average molecular weight (Mw) of 1,000 or more and 10,000 or less, which is measured by gel permeation chromatography using tetrahydrofuran (THF) as a solvent.

Repeating unit A Repeating unit B

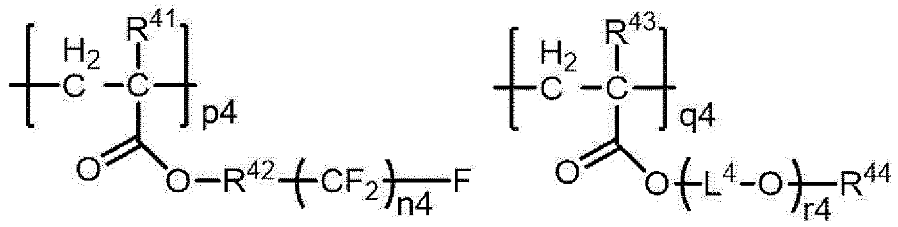

(41)

In Formula (41), $R^{41}$ and $R^{43}$ each independently represent a hydrogen atom or a methyl group, $R^{42}$ represents a linear alkylene group having 1 or more and 4 or fewer carbon atoms, $R^{44}$ represents a hydrogen atom or an alkyl group having 1 or more and 4 or fewer carbon atoms, $L^4$ represents an alkylene group having 3 or more and 6 or fewer carbon atoms, p4 and q4 each are a mass percentage representing a polymerization ratio, where p4 represents a numerical value of 10% by mass or more and 80% by mass or less and q4 represents a numerical value of 20% by mass or more and 90% by mass or less, r4 represents an integer of 1 or more and 18 or less, n4 represents an integer of 1 or more and 10 or less.

In Formula (41), $L^4$ is preferably a branched alkylene group represented by Formula (42). $R^{45}$ in Formula (42) represents an alkyl group having 1 or more and 4 or fewer carbon atoms, is preferably an alkyl group having 1 or more and 3 or fewer carbon atoms, and is more preferably an alkyl group having 2 or 3 carbon atoms, in terms of the wettability to the surface to be coated.

$$-CH_2-CH\ (R^{45})- \qquad (42)$$

The weight-average molecular weight of the copolymer is more preferably 1,500 or more and 5,000 or less.

In a case where the resist layer contains a surfactant, the adding amount of the surfactant is preferably 10 parts by mass or less, more preferably 0.01 to 10 parts by mass , and still more preferably 0.01 to 1 part by mass, with respect to 100 parts by mass of the specific resin for a resist layer.

One kind of surfactant can be used alone, or two or more kinds thereof can be mixed and used. In a case where two or more kinds thereof are used, the total amount is preferably within the above-described range.

- Other components -

One or two or more kinds of known additives such as an antioxidant, a plasticizer, a thermal radical generator, a thermal acid generator, an acid proliferation agent, an ultraviolet absorbing agent, a thickener, and an organic or inorganic precipitation inhibitor can be further added to the resist layer, as necessary. For details thereof, the description in paragraph numbers 0143 to 0148 of JP2011-209692A can be referred to, the content of which is incorporated in the present specification.

- Thickness -

From the viewpoint of improving resolving power, the thickness (film thickness) of the resist layer in the present invention is preferably 0.1 μm or more, more preferably 0.5 μm or more, still more preferably 0.75 μm or more, and particularly preferably 0.8 μm or more. The upper limit of the thickness of the resist layer is preferably 10 μm or less, more preferably 5.0 μm or less, and still more preferably 2.0 μm or less.

The total thickness of the resist layer and the interlayer is preferably 0.2 μm or more, more preferably 1.0 μm or more, and still more preferably 2.0 μm or more. The upper limit value thereof is preferably 20.0 μm or less, more preferably 10.0 μm or less, and still more preferably 5.0 μm or less.

- Developer -

The resist layer in the present invention is preferably subjected to development using a developer.

The developer is preferably a developer containing an organic solvent.

The content of the organic solvent with respect to the total mass of the developer is preferably 90% to 100% by mass and more preferably 95% to 100% by mass. In addition, the developer may be a developer consisting of only an organic solvent.

A development method for a resist layer using a developer will be described later.

<<Organic solvent>>

The sp value of the organic solvent contained in a developer is preferably less than 19 $MPa^{1/2}$ and more preferably 18 $MPa^{1/2}$ or less.

Examples of the organic solvent contained in a developer include polar solvents such as a ketone-based solvent, an ester-based solvent, an amide-based solvent, and a hydrocarbon-based solvent.

Examples of the ketone-based solvent include 1-octanone, 2-octanone, 1-nonanone, 2-nonanone, 2-heptanone (methyl amyl ketone), 4-heptanone, 1-hexanone, 2-hexanone, diisobutyl ketone, cyclohexanone, methyl cyclohexanone, phenyl acetone, methyl ethyl ketone, methyl isobutyl ketone, acetyl acetone, acetonyl acetone, ionone, diacetonyl alcohol, acetyl carbinol, acetophenone, methyl naphthyl ketone, isophorone, and propylene carbonate.

Examples of the ester-based solvent include methyl acetate, butyl acetate, ethyl acetate, isopropyl acetate, pentyl acetate, isopentyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxypropionate, 3-methoxybutyl acetate, 3-methyl-3-methoxybutyl acetate, methyl formate, ethyl formate, butyl formate, propyl formate, ethyl lactate, butyl lactate, and propyl lactate.

As the amide-based solvent, it is possible to use, for example, N-methyl-2-pyrrolidone, N,N-dimethylacetamide, N,N-dimethylformamide, hexamethylphosphoric triamide, or 1,3-dimethyl-2-imidazolidinone.

Examples of the hydrocarbon-based solvent include aromatic hydrocarbon-based solvents such as toluene and xylene, and aliphatic hydrocarbon-based solvents such as pentane, hexane, octane, and decane.

Only one kind of the organic solvent may be used, or two or more kinds thereof may be used. In addition, it may be used by being mixed with an organic solvent other than those above-described. However, it is preferable that the content of water with respect to the total mass of the developer is less than 10% by mass, and it is more preferable that water is substantially not contained. Here, "water is substantially not contained" refers to that, for example, the content of water with respect to the total mass of the developer is 3% by mass or less and more preferably equal to or lower than the measurement limit.

That is, the using amount of the organic solvent with respect to the organic developer is preferably 90% by mass or more and 100% by mass or less, and more preferably 95% by mass or more and 100% by mass or less, with respect to the total amount of the developer.

In particular, the organic developer preferably contains at least one organic solvent selected from the group consisting of a ketone-based solvent, an ester-based solvent, and an amide-based solvent.

In addition, the organic developer may contain a proper amount of a basic compound, as necessary. Examples of the basic compound include those described in the section of the basic compound described above.

The vapor pressure of the organic developer at 23°C is preferably 5 kPa or less, more preferably 3 kPa or less, and still more preferably 2 kPa or less. In a case of reducing the vapor pressure of the organic developer to 5 kPa or less, the vaporization of the developer on the resist layer or in the development cup is suppressed, and the in-plane temperature uniformity of the resist layer is improved, which results in the improvement of the dimensional uniformity of the developed resist layer.

Specific examples of the solvent having a vapor pressure of 5 kPa or less include ketone-based solvents such as 1-octanone, 2-octanone, 1-nonanone, 2-nonanone, 2-heptanone (methyl amyl ketone), 4-heptanone, 2-hexanone, diisobutyl ketone, cyclohexanone, methyl cyclohexanone, phenyl acetone, and methyl isobutyl ketone, ester-based solvents such as butyl acetate, pentyl acetate, isopentyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxypropionate, 3-methoxybutyl acetate, 3-methyl-3-methoxybutyl acetate, butyl formate, propyl formate, ethyl lactate, butyl lactate, and propyl lactate, amide-based solvents such as N-methyl-2-pyrrolidone, N,N-dimethylacetamide, and N,N-dimethylformamide, aromatic hydrocarbon-based solvents such as toluene and xylene, and aliphatic hydrocarbon-based solvents such as octane and decane.

Specific examples of the solvent having a vapor pressure of 2 kPa or less, which is a particularly preferred range, include ketone-based solvents such as 1-octanone, 2-octanone, 1-nonanone, 2-nonanone, 4-heptanone, 2-hexanone, diisobutyl ketone, cyclohexanone, methyl cyclohexanone, and phenyl acetone, ester-based solvents such

as butyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxypropionate, 3-methoxybutyl acetate, 3-methyl-3-methoxybutyl acetate, ethyl lactate, butyl lactate, and propyl lactate, amide-based solvents such as N-methyl-2-pyrrolidone, N,N-dimethylacetamide, and N,N-dimethylformamide, aromatic hydrocarbon-based solvents such as xylene, and aliphatic hydrocarbon-based solvents such as octane and decane.

<<Surfactant>>

The developer may contain a surfactant.

The surfactant is not particularly limited, and for example, the surfactant described in the section of the interlayer is preferably used.

In a case where a surfactant is blended in a developer, the blending amount thereof is generally 0.001% to 5% by mass, preferably 0.005% to 2% by mass, and more preferably 0.01% to 0.5% by mass, with respect to the total amount of the developer.

- Composition for forming a resist layer -

The composition for forming a resist layer is a composition that is used for forming a resist layer included in the laminate that is used in the present invention.

In the laminate that is used in the present invention, the resist layer can be formed, for example, by applying a composition for forming a resist layer onto an interlayer and carrying out drying. As the application method, for example, the description of the application method for the composition for forming an interlayer in the interlayer can be referenced.

The composition for forming a resist layer preferably contains the above-described components contained in the resist layer (for example, the specific resin for a resist layer, the photoacid generator, the basic compound, the surfactant, and other components), and a solvent. These components contained in the resist layer are preferably dissolved or dispersed in a solvent and more preferably dissolved therein.

Regarding the contents of the components contained in the composition for forming a resist layer, it is preferable that the content of each of the above-described components with respect to the total mass of the resist layer may be read as the content with respect to the solid content amount of the composition for forming a resist layer.

<<Organic solvent>>

A known organic solvent can be used as the organic solvent that is used in the composition for forming a resist layer, and examples thereof include ethylene glycol monoalkyl ethers, ethylene glycol dialkyl ethers, ethylene glycol monoalkyl ether acetates, propylene glycol monoalkyl ethers, propylene glycol dialkyl ethers, propylene glycol monoalkyl ether acetates, diethylene glycol dialkyl ethers, diethylene glycol monoalkyl ether acetates, dipropylene glycol monoalkyl ethers, dipropylene glycol dialkyl ethers, dipropylene glycol monoalkyl ether acetates, esters, ketones, amides, and lactones.

Examples of the organic solvent include the following organic solvents:

(1) ethylene glycol monoalkyl ethers such as ethylene glycol monomethyl ether, ethylene glycol monoethyl ether, ethylene glycol monopropyl ether, and ethylene glycol monobutyl ether;
(2) ethylene glycol dialkyl ethers such as ethylene glycol dimethyl ether, ethylene glycol diethyl ether, and ethylene glycol dipropyl ether;
(3) ethylene glycol monoalkyl ether acetates such as ethylene glycol monomethyl ether acetate, ethylene glycol monoethyl ether acetate, ethylene glycol monopropyl ether acetate, and ethylene glycol monobutyl ether acetate;
(4) propylene glycol monoalkyl ethers such as propylene glycol monomethyl ether, propylene glycol monoethyl ether, propylene glycol monopropyl ether, and propylene glycol monobutyl ether;
(5) propylene glycol dialkyl ethers such as propylene glycol dimethyl ether and propylene glycol diethyl ether;
(6) propylene glycol monoalkyl ether acetates such as propylene glycol monomethyl ether acetate, propylene glycol monoethyl ether acetate, propylene glycol monopropyl ether acetate, and propylene glycol monobutyl ether acetate;
(7) diethylene glycol dialkyl ethers such as diethylene glycol dimethyl ether, diethylene glycol diethyl ether, and diethylene glycol ethyl methyl ether;
(8) diethylene glycol monoalkyl ether acetates such as diethylene glycol monomethyl ether acetate, diethylene glycol monoethyl ether acetate, diethylene glycol monopropyl ether acetate, and diethylene glycol monobutyl ether acetate;
(9) dipropylene glycol monoalkyl ethers such as dipropylene glycol monomethyl ether, dipropylene glycol monoethyl ether, dipropylene glycol monopropyl ether, and dipropylene glycol monobutyl ether;
(10) dipropylene glycol dialkyl ethers such as dipropylene glycol dimethyl ether, dipropylene glycol diethyl ether,

and dipropylene glycol ethyl methyl ether;

(11) dipropylene glycol monoalkyl ether acetates such as dipropylene glycol monomethyl ether acetate, dipropylene glycol monoethyl ether acetate, dipropylene glycol monopropyl ether acetate, and dipropylene glycol monobutyl ether acetate;

(12) lactic acid esters such as methyl lactate, ethyl lactate, n-propyl lactate, isopropyl lactate, n-butyl lactate, isobutyl lactate, n-amyl lactate, and isoamyl lactate;

(13) aliphatic carboxylic acid esters such as n-butyl acetate, isobutyl acetate, n-amyl acetate, isoamyl acetate, n-hexyl acetate, 2-ethylhexyl acetate, ethyl propionate, n-propyl propionate, isopropyl propionate, n-butyl propionate, isobutyl propionate, methyl butyrate, ethyl butyrate, n-propyl butyrate, isopropyl butyrate, n-butyl butyrate, and isobutyl butyrate;

(14) other esters such as ethyl hydroxyacetate, ethyl 2-hydroxy-2-methylpropionate, ethyl 2-hydroxy-3-methylbutyrate, ethyl methoxyacetate, ethyl ethoxy acetate, methyl 3-methoxypropionate, ethyl 3-methoxypropionate, methyl 3-ethoxypropionate, ethyl 3-ethoxypropionate, 3-methoxybutyl acetate, 3-methyl-3-methoxybutyl acetate, 3-methyl-3-methoxybutyl propionate, 3-methyl-3-methoxybutyl butyrate, methyl acetoacetate, ethyl acetoacetate, methyl pyruvate, and ethyl pyruvate;

(15) ketones such as methyl ethyl ketone, methyl propyl ketone, methyl-n-butyl ketone, methyl isobutyl ketone, 2-heptanone, 3-heptanone, 4-heptanone, and cyclohexanone;

(16) amides such as N-methylformamide, N,N-dimethylformamide, N-methylacetamide, N,N-dimethylacetamide, and N-methylpyrrolidone; and

(17) lactones such as $\gamma$-butyrolactone.

In addition, as necessary, the following organic solvents can be added to these organic solvents; benzyl ethyl ether, dihexyl ether, ethylene glycol monophenyl ether acetate, diethylene glycol monomethyl ether, diethylene glycol monoethyl ether, isophorone, caproic acid, caprylic acid, 1-octanol, 1-nonanol, benzyl alcohol, anisole, benzyl acetate, ethyl benzoate, diethyl oxalate, diethyl maleate, ethylene carbonate, and propylene carbonate.

Among the above-described organic solvents, propylene glycol monoalkyl ether acetates or diethylene glycol dialkyl ethers are preferable, and diethylene glycol ethyl methyl ether or propylene glycol monomethyl ether acetate is particularly preferable.

In a case where the composition for forming a resist layer contains an organic solvent, the content of the organic solvent is preferably 1 to 3,000 parts by mass, more preferably 5 to 2,000 parts by mass, and still more preferably 10 to 1,500 parts by mass per 100 parts by mass of the specific resin for a resist layer.

One kind of these organic solvents can be used alone, or two or more kinds thereof can be mixed and used.

In a case where two or more kinds thereof are used, the total amount is preferably within the above-described range.

[Base material]

The laminate that is used in the present invention may contain a base material.

In the laminate, the base material is located on a side opposite to the interlayer of the organic layer.

Examples of the base material which may be contained in the laminate include base materials formed from various materials such as silicon, quartz, ceramic, glass, a polyester film such as polyethylene naphthalate (PEN) or polyethylene terephthalate (PET), and a polyimide film, where any base material may be selected depending on the use application. For example, in a case of being used in a flexible element, a base material formed from a flexible material can be used. In addition, the base material may be a composite base material formed from a plurality of materials or a laminated base material in which a plurality of materials are laminated. In addition, the shape of the base material is not particularly limited and may be selected depending on the use application. For, example, a plate-shaped base material (a substrate) is mentioned. The thickness of the substrate and the like are not particularly limited either.

[Manufacturing method for laminate]

The laminate may be obtained by means such as a purchase or may be obtained by manufacturing by a manufacturing method for an organic layer pattern.

Hereinafter, a case of manufacturing the laminate will be described in detail.

In a case of manufacturing a laminate, it is preferable that the following steps (1) and (2) are included in the step of obtaining the laminate.

(1) The step of forming an interlayer on an organic layer.

(2) The step of forming a resist layer on the interlayer.

- (1) Step of forming interlayer on organic layer -

It is preferable that the manufacturing method for an organic layer pattern according to the embodiment of the present invention includes a step of forming an interlayer on an organic layer. For example, the present step is carried out after forming an organic layer on a base material. In this case, the interlayer is formed on a surface opposite to the surface of the organic layer on the base material side. The interlayer is preferably formed to be in direct contact with the organic layer; however, another layer may be provided therebetween without departing from the gist of the present invention. Examples of the other layer include a fluorine-based undercoat layer. In addition, only one interlayer may be provided, or two or more interlayers may be provided. The interlayer is preferably formed using a composition for forming an interlayer. For details of the forming method, the application method for a composition for forming an interlayer can be referenced.

- (2) Step of forming resist layer on interlayer -

After the step (1), it is preferable to form a resist layer on a side (preferably on a surface) opposite to the surface of the interlayer on the organic layer side. The resist layer is preferably formed using a composition for forming a resist layer. For details of the forming method, the application method for a composition for forming a resist layer can be referenced.

<Resist pattern producing step>

The manufacturing method for an organic layer pattern according to the embodiment of the present invention includes a step of producing a pattern of the resist layer (also referred to as a "resist pattern producing step").

The resist pattern producing step is not particularly limited; however, it preferably includes the following steps (3) and (4).

(3) The step of exposing the resist layer.
(4) The step of developing the resist layer using a developer containing an organic solvent to produce a pattern (a mask pattern) of the resist layer.

[(3) Step of exposing resist layer]

It is preferable that the resist pattern producing step includes a step of exposing the resist layer. Specifically, for example, at least a part of the resist layer is irradiated (exposed) with an actinic ray.

It is preferable that the exposure is carried out so that a predetermined pattern is obtained. In addition, the exposure may be carried out through a photo mask, or a predetermined pattern may be directly drawn.

Regarding the wavelength of the actinic ray at the time of exposure, an actinic ray, which has a wavelength of preferably 180 nm or more and 450 nm or less and more preferably a wavelength of 365 nm (the i-line), 248 nm (the KrF ray), or 193 nm (the ArF ray), can be used.

As the light source of the actinic ray, a low-pressure mercury lamp, a high-pressure mercury lamp, an ultra-high-pressure mercury lamp, a chemical lamp, a laser generating device, a light emitting diode (LED) light source, or the like can be used.

In a case where a mercury lamp is used as the light source, it is possible to preferably use an actinic ray having a wavelength such as the g-line (436 nm), the i-line (365 nm), or the h-line (405 nm), and it is more preferable to use the i-line.

In a case where a laser generating device is used as the light source, an actinic ray having a wavelength of 343 nm and 355 nm is suitably used in a solid state (YAG) laser, an actinic ray having a wavelength of 193 nm (the ArF ray), 248 nm (the KrF ray), or 351 nm (the Xe ray) is suitably used in an excimer laser, and an actinic ray having a wavelength of 375 nm or 405 nm is suitably used in a semiconductor laser. Among these, from the viewpoint of stability, cost, and the like, an actinic ray having a wavelength of 355 nm or 405 nm is more preferable. The laser can be applied to the resist layer once or a plurality of times.

The exposure amount is preferably 40 to 120 mJ and more preferably 60 to 100 mJ.

The energy density per pulse of the laser is preferably 0.1 $mJ/cm^2$ or more and 10,000 $mJ/cm^2$ or less. In order to sufficiently cure a coating film, 0.3 $mJ/cm^2$ or more is more preferable, and 0.5 $mJ/cm^2$ or more is still more preferable. From the viewpoint of suppressing decomposition of the resist layer and the like due to the ablation phenomenon, the exposure amount is preferably 1,000 $mJ/cm^2$ or less and more preferably 100 $mJ/cm^2$ or less.

In addition, the pulse width is preferably 0.1 nanoseconds (hereinafter, referred to as "ns") or more and 30,000 ns or less. In order to prevent the resist layer from being decomposed by the ablation phenomenon, 0.5 ns or more is

more preferable and 1 ns or more is more preferable. In order to improve the alignment accuracy during scan exposure, 1,000 ns or less is more preferable, and 50 ns or less is still more preferable.

In a case where a laser generating device is used as the light source, the frequency of the laser is preferably 1 Hz or more and 50,000 Hz or less and more preferably 10 Hz or more and 1,000 Hz or less.

Further, in order to shorten the exposure treatment time, the frequency of the laser is more preferably 10 Hz or more, and more preferably 100 Hz or more, and in order to improve the alignment accuracy at the time of scan exposure, the frequency of the laser is more preferably 10,000 Hz or less and still more preferably 1,000 Hz or less.

The laser is preferable in that it is easy to carry out focusing as compared with a mercury lamp, and it is possible to omit the use of a photo mask in pattern formation in the exposure step.

The exposure device is not particularly limited; however, a commercially available exposure device such as Callisto (manufactured by V Technology Co., Ltd.), AEGIS (manufactured by V Technology Co., Ltd.), or DF2200G (Dainippon Screen Mfg. Co., Ltd.) can be used. In addition, a device other than those described above is also suitably used.

In addition, the amount of irradiation light can be adjusted as necessary through a spectral filter such as a long wavelength cut filter, a short wavelength cut filter, or a bandpass filter.

In addition, after the exposure, a post-exposure heating step (PEB) may be carried out as necessary.

[(4) Step of developing resist layer using developer containing organic solvent to produce pattern (mask pattern) of resist layer]

After the resist layer has been exposed through a photo mask in the step (3), it is preferable that the resist layer is developed using a developer.

Negative tone development is preferable. Details of the developer are as described in the description of the resist layer.

The following development method can be applied: for example, a method of immersing a laminate in a bath filled with a developer for a certain period of time (a dipping method), a method of raising a developer on a surface of a laminate by surface tension and allowing the laminate to stand for a certain period of time to carry out development (a puddle method), a method of spraying a developer onto a surface of a laminate (a spray method), or a method of continuously ejecting a developer onto a laminate with a developer ejection nozzle while scanning the laminate that rotates at a constant speed (a dynamic dispensing method).

In a case where the above-described various development methods include a step of ejecting a developer toward a resist layer from a development nozzle of a development device, the ejection pressure (the flow rate per unit area of the developer to be ejected) of the developer to be ejected is preferably 2 mL/sec/mm$^2$ or less, more preferably 1.5 mL/sec/mm$^2$ or less, and still more preferably 1 mL/sec/mm$^2$ or less. The lower limit of the ejection pressure is not particularly limited; however, it is preferably 0.2 mL/sec/mm$^2$ or more in consideration of the throughput. In a case of setting the ejection pressure of the developer to be ejected in the above-described range, defects of the pattern derived from the resist residue after the development can be remarkably reduced.

Although the details of this mechanism are not clear, it is presumed to be because, probably, the pressure applied to the resist layer by the developer is reduced by setting the ejection pressure within the above range, and thus the inadvertent scraping or collapse of the resist pattern on the resist layer is suppressed. The ejection pressure (mL/sec/mm$^2$) of the developer is a value at the outlet of the development nozzle in the development device.

Examples of the method of adjusting the ejection pressure of the developer include a method of adjusting the ejection pressure with a pump or the like and a method of adjusting the pressure by the supply from a pressurizing tank.

In addition, after the step of carrying development using a developer containing an organic solvent, a step of stopping the development while substituting the organic solvent with another organic solvent may be carried out.

<Organic layer etching step>

The manufacturing method for an organic layer pattern according to the embodiment of the present invention includes a step of carrying out etching of the organic layer using the pattern of the resist layer as a mask (also referred to as an "organic layer etching step").

The organic layer etching step preferably includes the step shown in (5) below.

(5) The step of removing the interlayer and the organic layer of the non-masked portion

[(5) Step of removing interlayer and organic layer of non-masked portion]

It is preferable to remove at least the interlayer and the organic layer in the non-masked portion by an etching treatment using the pattern of the resist layer as a mask. The non-masked portion refers to a region (a region from which the resist layer has been removed by the development) that is not masked by a pattern (a mask pattern) of the resist layer, the pattern being formed by developing the resist layer.

In addition, in the etching treatment, it is preferable that in the masked portion, the interlayer is exposed after

etching.

In a case of exposing the interlayer by the etching treatment, it is possible to easily carry out the subsequent interlayer insolubilization step.

In addition, after removing the organic layer and the interlayer of the non-masked portion by the etching treatment, the resist layer (the pattern of the resist layer) of the masked portion may be removed by wet etching, dry etching, or the like to expose the interlayer.

The etching treatment may be carried out devidedly in a plurality of stages. For example, the interlayer and the organic layer may be removed by a single etching treatment, or after at least a part of the interlayer is removed by an etching treatment, the organic layer (and the remainder of the interlayer as necessary) may be removed by an etching treatment.

In addition, the etching treatment may be a dry etching treatment or may be a wet etching treatment, and it may have an aspect in which the etching is divided into a plurality of times of etching and then the dry etching treatment and the wet etching treatment are carried out. For example, the removal of the interlayer may be carried out by dry etching or wet etching.

Examples of the method of removing the interlayer and the organic layer include a method A in which the interlayer and the organic layer are removed by a single dry etching treatment and a method B in which at least a part of the interlayer is removed by a wet etching treatment, and then, the organic layer (and the remainder of the interlayer as necessary) is removed by dry etching.

The dry etching treatment in the method A, the wet etching treatment and the dry etching treatment in the method B, and the like can be carried out according to known etching treatment methods.

Hereinafter, the details of one aspect of the method A will be described. As a specific example of the method B, the description or the like of JP2014-098889A can be referenced.

In the above method A, specifically, in a case of carrying out dry etching using a resist pattern as an etching mask (a mask pattern), the interlayer and the organic layer of the non-masked portion can be removed. Representative examples of the dry etching are the methods described in JP1984-126506A (JP-S59-126506A), JP1984-046628A (JP-S59-046628A), JP1983-009108A (JP-S58-009108A), JP1983-002809A (JP-S58-002809A), JP1982-148706A (JP-S57-148706A), and JP1986-041102A (JP-S61-041102A).

From the viewpoint of forming the cross section of the pattern of the formed organic layer closer to a rectangle and from the viewpoint of further reducing the damage to the organic layer, the dry etching can also be carried out in the following forms.

A preferred form includes a first-stage etching in which a mixed gas of a fluorine-based gas and an oxygen gas ($O_2$) is used to carry out etching up to a region (a depth) where the organic layer is not exposed, a second-stage etching in which after the first-stage etching, a mixed gas of a nitrogen gas ($N_2$) and an oxygen gas ($O_2$) is used to carry out etching preferably up to the vicinity of a region (a depth) where the organic layer is exposed, and an over-etching that is carried out after the organic layer is exposed. Hereinafter, the specific method of dry etching, the first-stage etching, the second-stage etching, and the over-etching will be described.

In addition, it is also possible to carry out only the second-stage etching by using, for example, a mixed gas of a nitrogen gas ($N_2$) and an oxygen gas ($O_2$) without carrying out the first-stage etching.

The etching conditions in the dry etching are preferably achieved while calculating the etching time according to the following method.

(A) The etching rate (nm/min) in the first-stage etching and the etching rate (nm/min) in the second-stage etching are calculated, respectively.
(B) The time taken for etching to a desired thickness in the first-stage etching and the time taken for etching to a desired thickness in the second-stage etching are calculated, respectively.
(C) The first-stage etching is carried out according to the etching time calculated in (B) above.
(D) The second-stage etching is carried out according to the etching time calculated in (B) above. Alternatively, the etching time may be determined by the endpoint detection, and the second-stage etching may be carried out according to the determined etching time.
(E) The over-etching time is calculated with respect to the total time of (C) and (D), and the over-etching is carried out.

From the viewpoint of processing the organic material, which is a film to be etched, into a rectangular shape, it is preferable that the mixed gas that is used in the first-stage etching includes a fluorine-based gas and an oxygen gas ($O_2$). In addition, in the first-stage etching, the laminate is etched up to a region where the organic layer is not exposed. Therefore, at this stage, it is conceived that the organic layer is not damaged or the damage is slight.

In addition, in the second-stage etching and the over-etching, it is preferable to carry out the etching treatment using a mixed gas of a nitrogen gas and an oxygen gas from the viewpoint of avoiding the damage to the organic layer.

It is important that the ratio of the etching amount in the first-stage etching to the etching amount in the second-stage etching is determined such that the rectangularity in the cross section of the pattern of the organic layer in the first-stage etching is excellent.

The ratio of the etching amount in the second-stage etching in the total etching amount (the sum of the etching amount in the first-stage etching and the etching amount in the second-stage etching) is preferably more than 0% and 50% or less, and more preferably 10% to 20%. The etching amount refers to an amount calculated from the difference between the residual film thickness of the film to be etched and the film thickness before etching.

In addition, it is preferable that the etching includes an over-etching treatment. It is preferable that the over-etching treatment is carried out by setting an over-etching ratio. The over-etching ratio can be set freely; however, it is preferably 30% or less of the total etching treatment time in the etching step, more preferably 5% to 25% thereof, and particularly preferably 10% to 15% thereof, from the viewpoint of maintaining the etching resistance of the photoresist and the rectangularity of the pattern (the organic layer) to be etched.

<Interlayer insolubilization step>

The manufacturing method for an organic layer pattern according to the embodiment of the present invention includes a step of carrying out insolubilization of a surface of the interlayer with respect to water or a water-soluble solvent (also referred to as an "interlayer insolubilization step"), after the etching.

In the step of carrying out insolubilization of the surface of the interlayer, it suffices that the surface of the interlayer is insolubilized with respect to water or a water-soluble solvent, which is used in the laminate washing step described later.

Here, it suffices that "carrying out insolubilization of the surface of the interlayer" is "making the surface of the interlayer not be dissolved in the laminate washing step", and for example, the property of the interlayer surface itself may be changed and insolubilized, or another layer may be further formed on the surface of the interlayer to insolubilize the interlayer.

Specifically, the dissolution rate of the surface of the interlayer obtained after the interlayer insolubilization step, in water or a water-soluble solvent, which is used in the laminate washing step, is preferably 10 nm/s or less at 23°C and is more preferably 5 nm/s or less. The lower limit of the dissolution rate is not particularly limited and may be 0 nm/s.

The surface of the interlayer refers to a surface of the interlayer opposite to the side where the organic layer is present.

In the interlayer insolubilization step, it suffices that at least a part of the region from the surface of the interlayer is insolubilized. Although the entire interlayer may be insolubilized, it is preferable that a part of the region from the surface of the interlayer is insolubilized. The thickness of the insolubilized region that is formed on the surface of the interlayer is, for example, preferably 0.2 to 100 nm.

[Plasma treatment]

The interlayer insolubilization step is preferably a step of subjecting the surface of the interlayer to a plasma treatment.

By the above-described plasma treatment, for example, the resin contained in the interlayer forms crosslinks, whereby the interlayer is insolubilized in water or a water-soluble solvent, which is used in the laminate washing step.

The plasma treatment is not particularly limited; however, it is preferably carried out with a gas containing an inert gas, and more preferably with a gas containing Ar.

The gas containing Ar may further contain $N_2$ or a rare gas other than Ar, such as He or Ne, and it preferably contains Ar and $N_2$.

The partial pressure of $N_2$ in the gas containing Ar and $N_2$ is preferably 10% to 50% and more preferably 20% to 50% with respect to the total pressure of the gas.

The partial pressure can be adjusted, for example, as a ratio of the gas flow rate at the time of the plasma treatment.

In addition, it is also one of the preferred aspects of the present invention to carry out the plasma treatment with a gas containing only Ar and $N_2$.

Within the above range, the interlayer may be effectively insolubilized and the step of removing the surface of the interlayer, which will be described later, may be facilitated.

In addition to the above, the conditions and the like of the plasma treatment may be determined in consideration of the kind of resin, the kind of etching gas, and the like with reference to known surface treatment methods.

[Layer formation treatment]

The interlayer insolubilization step may be carried out by forming a layer having a low solubility in water or a

water-soluble solvent, which is used in the laminate washing step, on the surface of the interlayer.

For example, a method of forming a resin layer containing a resin such as parylene on the surface of the interlayer according to a method such as vapor deposition, or the like can be mentioned.

[Other treatments]

In addition, the interlayer insolubilization step can also be carried out by a method, for example, by allowing the interlayer to contain a curable compound and then curing the surface. Examples thereof include a method of allowing the interlayer to contain a polymerizable compound and a photopolymerization initiator and then exposing the surface at a low exposure amount.

<Laminate washing step>

The manufacturing method for an organic layer pattern according to the embodiment of the present invention includes a step of carrying out washing of the laminate after the interlayer insolubilization step with water or a water-soluble solvent (also referred to as a "laminate washing step").

The laminate washing step removes an etching residue (for example, a particulate residue).

In addition, since the interlayer is insolubilized by the interlayer insolubilization step, it is conceived that the interlayer is difficult to be removed even after the laminate washing step and the interlayer remains after the laminate washing step.

Examples of the water or the water-soluble solvent, (also referred to as the "washing liquid") which is used in the laminate washing step, include water, alcohols (for example, methanol, ethanol, propanol, isopropanol, n-butanol, isobutanol, sec-butanol, t-butanol, pentanol, hexanol, cyclohexanol, and benzyl alcohol), ethylene glycol, diethylene glycol, triethylene glycol, polyethylene glycol, propylene glycol, dipropylene glycol, polypropylene glycol, butylene glycol, hexanediol, pentanediol, glycerin, hexanetriol, and thiodiglycol, dithiodiglycol, 2-methyl-1,3-propanediol, 1,2,6-hexanetriol, an acetylene glycol derivative, and trimethylolpropane), ethers or esters (for example, ethylene glycol monomethyl ether, ethylene glycol monoethyl ether, ethylene glycol monobutyl ether, diethylene glycol monomethyl ether, diethylene glycol monobutyl ether, propylene glycol monomethyl ether, propylene glycol monobutyl ether, dipropylene glycol monomethyl ether, triethylene glycol monomethyl ether, ethylene glycol diacetate, ethylene glycol monomethyl ether acetate, triethylene glycol monomethyl ether, triethylene glycol monoethyl ether, and ethylene glycol monophenyl ether), amines (for example, ethanolamine, diethanolamine, triethanolamine, N-methyldiethanolamine, N-ethyldiethanolamine, morpholine, N-ethylmorpholine, ethylenediamine, diethylenetriamine, triethylenetetramine, polyethyleneimine, and tetramethylpropylenediamine), and other polar solvents (for example, formamide, N,N-dimethylformamide, N,N-dimethylacetamide, dimethyl sulfoxide, sulfolane, 2-pyrrolidone, N-methyl-2-pyrrolidone, N-vinyl-2-pyrrolidone, 2-oxazolidone, 1,3-dimethyl-2-imidazolidinone, acetonitrile, and acetone), and mixtures thereof, where water, alcohol, or a mixture thereof is preferable, and water, methanol, isopropanol, or diethylene glycol is more preferable.

The washing method is not particularly limited, and a known washing method can be used.

Examples thereof include a rotary ejection method, a dipping method, a spray method, and a method using a combination thereof.

In addition, the temperature at the time of washing is not particularly limited and can be set to 15°C to 40°C or the like.

<Water solubility recovery step>

It is preferable that the manufacturing method for an organic layer pattern according to the embodiment of the present invention further includes a step of increasing the solubility of the surface of the interlayer in water or a water-soluble solvent (also referred to as a "water solubility recovery step").

The water solubility recovery step is preferably carried out after the laminate washing step, and it is more preferably carried out after the laminate washing step and before the interlayer removing step.

It is preferable that the water solubility recovery step improves the solubility of the interlayer in the removal liquid that is used in the interlayer removing step described later.

Specifically, in the interlayer after the water solubility recovery step, the dissolution rate in a removal liquid is preferably 100 nm/s or more, more preferably 120 nm/s or more, and still more preferably 150 nm/s or more. The upper limit of the dissolution rate is not particularly limited and can be set to, for example, 1,000 nm/s or less.

The water solubility recovery step is preferably a step of removing the surface of the interlayer which has been insolubilized in the interlayer insolubilization step (also referred to as an "interlayer surface removing step").

By the above removal, the surface of the insolubilized interlayer is removed, and the interlayer becomes soluble in the removal liquid.

In the interlayer surface removing step, it is preferable that at least the insolubilized surface of the interlayer is removed. In addition, the non-insolubilized region of the interlayer may be further removed.
The interlayer surface removing step is preferably a step of carrying out dry etching, and it is more preferably a step of carrying out dry etching with an etching gas having an oxygen partial pressure of 50% to 100% with respect to the total pressure.
Examples of the gas other than the oxygen, which is contained in the etching gas, include an $N_2$ gas, a $CF_4$ gas, and an Ar gas.
The surface of the insolubilized interlayer is removed by the dry etching.
Dry etching conditions for known methods can be employed for the detailed conditions of the dry etching. In addition, the conditions can also be determined with reference to the description of the dry etching of the resist layer described above.

<Interlayer removing step>

It is preferable that the manufacturing method for an organic layer pattern according to the embodiment of the present invention includes a step of removing the interlayer (an interlayer removing step).
The interlayer removing step is preferably carried out after the laminate washing step, and it is more preferably carried out after the water solubility recovery step.
The interlayer removing step is preferably a step of removing the interlayer with a removal liquid.
In addition, in a case where the insolubilized region remains on the surface of the interlayer (for example, in a case where the water solubility recovery step is not carried out), the interlayer can be removed by dry etching or the like.
Examples of the removal liquid include a removal liquid containing water or a water-soluble solvent.
In a case where the removal liquid contains water, the content of water with respect to the total mass of the removal liquid is preferably 70% by mass or more, more preferably 80% by mass or more, and still more preferably 90% by mass or more. The upper limit of the above content is not particularly limited; however, it can be set to 99.95% by mass or less.
In addition, in a case where the removal liquid contains water, the content of water with respect to the total mass of the water and the water-soluble solvent is preferably 70% by mass or more, more preferably 80% by mass or more, and still more preferably 90% by mass or more. The upper limit of the content is not particularly limited; however, it can be set to 100% by mass or less.
In addition, the removal liquid may contain a water-soluble solvent.
In particular, in an aspect in which the removal liquid contains water, the removal liquid may further contain a water-soluble solvent.
In the present specification, water, a mixture of water and a water-soluble solvent, and a water-soluble solvent may be collectively referred to as an aqueous solvent.
The water-soluble solvent is preferably an organic solvent having a solubility in water at 23°C of 1 g or more, more preferably an organic solvent having a solubility in water at 23°C of 10 g or more, and still more preferably an organic solvent having a solubility in water at 23°C of 30 g or more.
Examples of the water-soluble solvent include alcohol-based solvents such as methanol, ethanol, propanol, ethylene glycol, and glycerin; ketone-based solvents such as acetone; and amide-based solvents such as formamide.
In addition, it is also preferable that the removal liquid contains a surfactant.
Examples of the surfactant include the surfactant containing an acetylene group in the above-described interlayer, and the same components as other surfactants.
The removal liquid can also have an aspect in which components other than the solvent and the surfactant are substantially not contained. In the above aspect, the total content of the solvent and the surfactant is preferably 98% by mass or more, more preferably 99% by mass or more, still more preferably 99.9% by mass or more, with respect to the total mass of the removal liquid. The upper limit of the above content is not particularly limited and can be set to 100% by mass.
In addition, an aspect in which the removal liquid contains water may have an aspect in which components other than the water and the surfactant are substantially not contained can also be adopted. In the above aspect, the total content of the water and the surfactant is preferably 98% by mass or more, more preferably 99% by mass or more, and still more preferably 99.9% by mass or more, with respect to the total mass of the removal liquid. The upper limit of the above content is not particularly limited and can be set to 100% by mass.
In the present invention, the viscosity of the removal liquid is preferably 1.0 mPa s or less, more preferably 0.8 mPa s or less, and still more preferably 0.75 mPa s or less, and the viscosity thereof is particularly preferably 0.72 mPa s or less. The lower limit of the viscosity is not particularly limited and can be set to, for example, 0.10 mPa·s or more.
The viscosity can be measured by a known method, and it is measured, for example, with a RE-80L type rotational viscometer manufactured by TOKI SANGYO Co., Ltd. The rotation speed may be set appropriately; however,

it can be set to, for example, 100 rpm.

The viscosity of the removal liquid is adjusted, for example, by the structure of the compound contained in the removal liquid, the temperature of the removal liquid, the mixing ratio of the solvent contained in the removal liquid, or the like.

The temperature of the removal liquid may be adjusted for the purpose of setting the viscosity of the removal liquid in the above-described range. For example, the temperature of the removal liquid is preferably set to 20°C or higher, more preferably set to 30°C or higher, still more preferably set to 40°C or higher, and particularly preferably set to 50°C or higher. The upper limit of the temperature can be set to, for example, 100°C or lower, and it is preferably 90°C or lower and more preferably 80°C or lower.

Examples of the method of removing the interlayer with the removal liquid include a method of injecting the removal liquid from a spray-type or shower-type jet nozzle to remove the interlayer. In addition, examples of the jet nozzle include a jet nozzle of which the jetting range includes the entire surface of the laminate, and a movable jet nozzle of which the movable range includes the entire surface of the laminate. Examples of another aspect include an aspect in which the interlayer is removed mechanically, and then the residue of the interlayer remaining on the organic layer is dissolved and removed.

In a case where the jet nozzle is movable, the resist pattern can be removed more effectively by moving the jet nozzle from the central part of the laminate to the end part of the laminate two or more times and jetting the removal liquid during the step of removing the interlayer.

It is also preferable to carry out a step such as drying after removing the interlayer. The drying temperature is preferably 80°C to 120°C. In addition, a step of carrying out rinsing with pure water or the like after removing the interlayer may be included.

<Step of forming organic layer pattern plurality of times>

The manufacturing method for an organic layer pattern according to the embodiment of the present invention may include a step of forming the organic layer pattern a plurality of times.

Specifically, the manufacturing method for an organic layer pattern according to the embodiment of the present invention preferably includes a step of further forming a second organic layer, after the step of carrying out the washing; a step of forming a second interlayer that dissolves in water or a water-soluble solvent and a second resist layer in this order on the second organic layer to obtain a laminate (a step of obtaining a second laminate); a step of forming a second pattern of the second resist layer (a second resist pattern producing step); a step of carrying out etching of the second organic layer using the second pattern as a mask (a second organic layer etching step); a step of carrying out insolubilization of a surface of the second interlayer with respect to water or a water-soluble solvent, after the etching (a second interlayer insolubilization step); and a step of washing the laminate after the insolubilization, with water or a water-soluble solvent (a second laminate washing step).

In the step of obtaining the second laminate, for example, a second organic layer or the like is formed on a base material including the organic layer pattern obtained by the manufacturing method for an organic layer pattern according to the embodiment of the present invention.

In addition, the step of obtaining a second laminate, the second resist pattern producing step, the second organic layer etching step, the second interlayer insolubilization step, and the second laminate washing step can be carried out according to the methods respectively described in the step of obtaining a laminate, the resist pattern producing step, the organic layer etching step, the interlayer insolubilization step, and the laminate washing step, which are described above.

In addition, in the manufacturing method for an organic layer pattern according to the embodiment of the present invention, for example, an aspect in which after carrying out the following steps (A) to (F), the steps (A) to (F) are repeated again, and the step (G) is finally carried out can be mentioned in a case where the organic layer pattern has formed a plurality of times. Each step can be carried out according to the above description. In addition, the respective steps to be carried out a plurality of times may be the same step or steps different from each other. For example, such an aspect in which an organic layer formed in the step (A) of the first steps of (A) to (F), and an organic layer formed in the step (A) of the second steps of (A) to (F) are respectively organic layers containing different kinds of organic substances can be mentioned.

(A) The step of obtaining a laminate
(B) The resist pattern producing step
(C) The organic layer etching step
(D) The interlayer insolubilization step
(E) The laminate washing step
(F) The water solubility recovery step

(G) The interlayer removing step

Figs. 1A to 1F are schematic cross-sectional views illustrating an example of a manufacturing method for an organic layer pattern according to the embodiment of the present invention.
Regarding the laminate, an organic layer 3 (for example, an organic semiconductor layer) is disposed on a base material 4 as in an example illustrated in Fig. 1A. Further, an interlayer 2 that protects the organic layer 3 is disposed on the surface of the organic layer 3 to be in contact with the organic layer 3. Another layer may be provided between the organic layer 3 and the interlayer 2; however, from the viewpoint of properly protecting the organic layer, it is preferable that the organic layer 3 and the interlayer 2 are in direct contact with each other. In addition, a resist layer 1 that functions as a photoresist is disposed on the interlayer. The resist layer 1 and the interlayer 2 may be in direct contact with each other, or another layer may be provided between the resist layer 1 and the interlayer 2. However, from the viewpoint of suppressing pattern peeling, it is preferable that the resist layer 1 and the interlayer 2 are in direct contact with each other.
Fig. 1B illustrates an example of a state in which a part of the resist layer 1 is exposed and developed. For example, the resist layer 1 is partially exposed by such a method using a predetermined mask or the like and developed, after the exposure, using a developer such as an organic solvent, whereby the resist layer 1 in a removal part 5 is removed and resist layer 1a that has undergone the exposure and the development is formed.
For example, in a case where the resist layer 1 is a resist layer in which an acid is generated upon exposure, at the time of exposure, the solubility of the exposed portion with respect to a developer changes, for example, due to the generation of the acid in the exposed portion of the resist layer 1, and the resist layer 1 can be developed.
In addition, in the above-described development, the interlayer 2 remains due to being difficult to be removed by the developer, and the organic layer 3 is protected from damage by the developer, due to the remaining interlayer 2.
In addition, the resist layer 1a may be further heated or exposed after the development.
Fig. 1C illustrates an example of a state in which a part of each of the interlayer 2 and the organic layer 3 is removed. For example, by removing the interlayer 2 and the organic layer 3 in the removal part 5 without having the developed resist layer (the resist) 1a by a dry etching treatment or the like, a removal part 5a is formed in the interlayer 2 and the organic layer 3. In this way, the organic layer 3 can be removed in the removal part 5a. That is, the organic layer 3 can be patterned.
Here, an etching residue 6 is generated in the removal part 5a. Although the etching residue 6 is described as assumable spherical particles, the shape thereof is not particularly limited.
Although Figs. 1A to 1F illustrates an assumable aspect in which even the resist layer 1a is removed by a dry etching treatment or the like, the resist layer 1a may remain.
Fig. 1D illustrates an example of a state in which the surface of the interlayer 2 is insolubilized.
In Fig. 1D, 2a indicates an insolubilized surface of the interlayer. In addition, although the upper part is illustrated as an assumable insolubilized state in the figure, in reality, the side surface of the interlayer 2 may be further insolubilized.
Fig. 1E illustrates an example of a state after the laminate washing step.
The etching residue 6 is removed by the laminate washing step.
In addition, since the interlayer is insolubilized, the interlayer 2 is difficult to be removed in the laminate washing step and remains, and thus the damage to the organic layer 3 is suppressed.
Fig. 1F illustrates an example of a state after the water solubility recovery step.
An insolubilized surface 2a of the interlayer is removed by the water solubility recovery step.
Thereafter, by repeating the above process and removing the interlayer, it is possible to form a base material having an organic layer pattern of the first organic layer, the second organic layer, and the third organic layer, as illustrated in Fig. 2.
Fig. 2 is a schematic cross-sectional view illustrating an example of a base material on which an organic layer pattern of each of a first organic layer, a second organic layer, and a third organic layer is formed.
As described above, according to the manufacturing method for an organic layer pattern according to the embodiment of the present invention, it is possible to manufacture a base material having, for example, three different organic layer patterns.
Examples thereof include an aspect in which the organic layer 3 is a red material for organic electro-luminescence (EL), the second organic layer 7 is a green material therefor, and the third organic layer 11 is a blue material therefor.

(Manufacturing method for semiconductor device)

A manufacturing method for a semiconductor device according to the embodiment of the present invention includes the manufacturing method for an organic layer pattern according to the embodiment of the present invention.
It is preferable that a semiconductor device obtained by the manufacturing method for a semiconductor device according to the embodiment of the present invention includes an organic layer pattern obtained by the manufacturing method for an organic layer pattern according to the embodiment of the present invention.

It is preferable that the semiconductor device according to the embodiment of the present invention includes a pattern obtained by removing the interlayer from the organic layer pattern with a removal liquid.

That is, in a semiconductor device obtained by the manufacturing method for a semiconductor device, the interlayer may be removed by a removal liquid, and thus the interlayer may not remain in the semiconductor device.

Here, the semiconductor device is a device that contains a semiconductor and has two or more electrodes, where a current that flows between the electrodes or a generated voltage is controlled by electricity, light, magnetism, a chemical substance, or the like, or a device that generates light, an electric field, a magnetic field, or the like by an applied voltage or current.

Examples thereof include an organic photoelectric conversion element, an organic electric field effect transistor, an organic electric field light emitting element, a gas sensor, an organic rectifying element, an organic inverter, and an information recording element. The organic photoelectric conversion element can be used in any use application of a use application for an optical sensor or a use application for energy conversion (a solar cell). Among these, an organic electric field effect transistor, an organic photoelectric conversion element, or an organic electric field light emitting element is preferable, an organic electric field effect transistor or an organic photoelectric conversion element is more preferable, and an organic electric field effect transistor is particularly preferable.

## Examples

Hereinafter, the present invention will be described more specifically with reference to Examples. The materials, used amounts, proportions, treatment contents, treatment procedures, and the like shown Examples can be appropriately changed without departing from the gist of the present invention. Accordingly, the scope of the present invention is not limited to the specific examples shown below. In Examples, unless otherwise specified, "parts" and "%" are in terms of mass, and an environmental temperature (room temperature) in each step is 23°C.

The weight-average molecular weight (Mw) of the resin in the resin composition for forming a resist layer was calculated as a polystyrene-equivalent value according to the GPC measurement. HLC-8220 (manufactured by Tosoh Corporation) was used, and TSKgel Super AWM-H (manufactured by Tosoh Corporation, 6.0 mm ID × 15.0 cm) was used as a column.

### (Example 1)

<Production of organic semiconductor substrate>

A 5 cm square glass substrate was spin-coated with an organic semiconductor coating liquid having the following composition and dried at 130°C for 10 minutes to form an organic semiconductor film (an organic layer). The film thickness of the organic semiconductor film obtained after drying was 150 nm.

[Composition of organic semiconductor coating liquid]

- P3HT (manufactured by Sigma-Aldrich Japan), 10% by mass
- PCBM (manufactured by Sigma-Aldrich Japan), 10% by mass
- Chloroform (manufactured by FUJIFILM Wako Pure Chemical Corporation) 80% by mass

<Preparation of composition for forming interlayer>

Each raw material was mixed so that the blending ratio (parts by mass) shown in the column of "Composition for forming interlayer" in the table below was obtained.

After the mixing, a stirrer (a hot magnet stirrer, C-MAG HS4, manufactured by IKA) was used under the following stirring conditions to stir each of the compositions for forming an interlayer. After the stirring was completed, a vinylidene fluoride (PVDF) membrane filter (Durapore, manufactured by Merck KGaA) having a pore diameter of 5 μm was placed in a stainless pressure filter holder (manufactured by Sartorius AG), which was subsequently used to filter each composition while pressurizing it at 2 MPa.

[Stirring conditions]

- Atmosphere: atmospheric air
- Stirring time: 240 minutes
- Stirring temperature: 50°C
- Rotation speed of stirring member: 500 revolutions per minute (rpm)

<Step of forming interlayer on organic layer>

The organic semiconductor film formed on the glass substrate was spin-coated with the composition for forming an interlayer and dried at 100°C for 1 minute to form a water-soluble resin film (an interlayer). The film thickness of the interlayer after the film formation was 2.0 μm.

<Preparation of composition for forming resist layer (chemical amplification type photosensitive resin composition)>

The following components were mixed to prepare a composition for forming a resist layer.

· Resin A-1: 30.09 parts by mass
· Photoacid generator (a compound X (having the structure below), $R^{11}$ represents a tolyl group, and $R^{18}$ represents a methyl group, manufactured by DAITO CHEMIX Co., Ltd.): 0.26 parts by mass

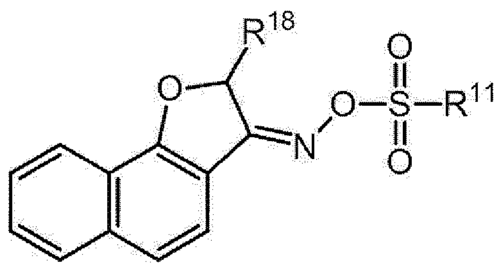

· Basic compound (a compound Y (having the structure below), manufactured by DSP GOKYO FOOD & CHEMICAL Co., Ltd.): 0.08 parts by mass

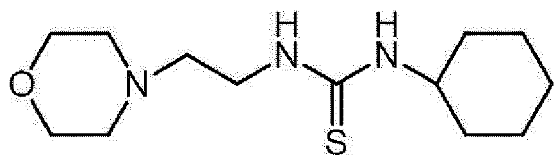

· Surfactant (manufactured by OMNOVA Solutions Inc., PF-6320): 0.08 parts by mass
· Propylene glycol monomethyl ether acetate (PGMEA): 69.5 parts by mass

[Synthesis of resin A-1]

A PGMEA solution was prepared by dissolving BzMA (benzyl methacrylate, 16.65 g), THFAA (tetrahydrofurfuryl acrylate, 19.19 g), t-BuMA (5.76 g), and V-601 (0.4663 g) in PGMEA (32.62 g). Next, PGMEA (32.62 g) was placed in a three-neck flask equipped with a nitrogen introduction pipe and a cooling pipe, the temperature was raised to 86°C, and the PGMEA solution was added dropwise thereto over 2 hours to prepare a reaction solution. Next, the reaction solution was stirred for 2 hours, and then the reaction was terminated. The solution after the completion of the reaction was injected into heptane to re-precipitate the polymer component, and the resultant white powder was recovered by filtration. As a result, a resin having a weight-average molecular weight (Mw) of 45,000 was obtained.

<Step of forming resist layer on interlayer>

The formed water-soluble resin film (the interlayer) was spin-coated with a composition for forming a resist layer (a chemical amplification type photosensitive resin composition) having the composition shown above and dried at 100°C for 1 minute. The film thickness after drying was 1,700 nm.

<Step of producing resin mask pattern (pattern of resist layer) on interlayer>

Using an i-line parallel exposure machine, the resist layer was exposed at an exposure amount of 60 $mJ/cm^2$ through a binary mask on which a 1:1 line-and-space pattern having a line width of 20 μm was formed. Then, heating was carried out at 100°C for 1 minute, and development was carried out with butyl acetate to obtain a mask pattern.

<Step of carrying out etching of organic layer using pattern of resist layer mask>

The dry etching of the substrate was carried out under the following conditions to remove the water-soluble resin film (the interlayer) in the non-masked pattern portion and the organic semiconductor film in the non-masked pattern portion. In addition, the resist layer was also removed in the mask pattern portion, and the interlayer was exposed.

Gas: $N_2$ (flow rate: 25 ml/min), $O_2$ (flow rate: 500 ml/min)
Source power: 800 W
Wafer bias: 0 W
Antenna bias: 100 W
Electrostatic chuck (ESC) voltage: 400 V
Time: 300 seconds (sec)

<Step of carrying out insolubilization of surface of interlayer with water or water-soluble solvent (plasma treatment 1)>

A plasma treatment was carried out under the following conditions, and a step of imparting solvent resistance to the interlayer was carried out.

Gas: Ar (flow rate: 400 ml/min), $N_2$ (flow rate: 100 ml/min)
Source power: 800 W
Wafer bias: 0 W
Antenna bias: 100 W
ESC voltage: 400 V
Time: 1 sec

<Step of washing laminate after step of carrying out insolubilization, with water or water-soluble solvent>

Pure water was used as the washing liquid, and a small developer AD-1200 (manufactured by Mikasa Co., Ltd.) was used to eject pure water using a spray nozzle, thereby carrying out substrate washing for 60 seconds.

A case where the interlayer remained on the entire surface after the washing was denoted as A, and a case where the interlayer was removed at least partially and the organic layer was exposed is denoted as B, and the evaluation results described in the column of "Residual of interlayer after washing".

<Particle examination (checking of number of particles)>

Using an optical microscope, the entire substrate was observed at a magnification of 100 times, and the number of foreign substances was counted as the number of particles. The evaluation results (the number of observed particles) are described in the column of "Number of particles" in the table.

<Water solubility recovery step (etching 2)>

The washed substrate was subjected to dry etching under the following conditions, and the water solubility recovery step of the interlayer was carried out.

Gas: $N_2$ (flow rate: 25 ml/min), $O_2$ (flow rate: 500 ml/min)
Source power: 800 W
Wafer bias: 0 W
Antenna bias: 100 W
ESC voltage: 400 V
Time: 2 sec

<Removal of interlayer>

The substrate after the water solubility recovery step was immersed in a 5% by mass aqueous solution (the removal liquid) of EMALEX710 (manufactured by Nihon Emulsion Co., Ltd.), taken out after 30 minutes, washed with pure water, and dried to obtain a substrate from which the interlayer was removed.

In addition, at this time, the water solubility of the interlayer was measured, and a case where the solubility of 100 g of the interlayer in water at 25°C was 100 nm/s or more was evaluated as A, and a case where the solubility thereof was less than 100 nm/s was evaluated as B. The evaluation results are described in the column of "Water solubility after etching 2" in the table.

<Evaluation of light emitting device>

A light emitting device was produced using the substrate obtained above, and it was confirmed that the light emitting device is operated without any problem.

(Examples 2 to 11, 13, and 14, and Comparative Example 1)

"Production of organic semiconductor substrate" to "Evaluation of light emitting device" were carried out according to the same methods as in Example 1, except that the composition of the composition for forming an interlayer, the conditions of each plasma treatment (the plasma treatment 1 and the etching 2), and the washing liquid and the washing liquid outlet in the step of washing the laminate after the step of carrying out the insolubilization with water or a water-soluble solvent were changed as shown in the table. The light emitting device was operated without problems.

(Example 12)

In Example 1, instead of the plasma treatment 1, polyparaxylene was subjected to vapor deposition through a metal mask to have a film thickness of 10 nm, only on the interlayer formed on the organic semiconductor layer. The subsequent step of washing the laminate after the step of carrying out the insolubilization with water or a water-soluble solvent was carried out using pure water by the same method as in Example 1. Then, instead of the water solubility recovery step, the removal of the parylene was carried out by a plasma treatment (10 seconds) under the conditions of an $O_2$ flow rate of 500 ml/min, an $N_2$ flow rate of 25 ml/min, and a source power of 800 W.

Other steps and evaluations were carried out in the same manner as in Example 1. The evaluation results are shown in the table.

(Comparative Example 2)

Using the composition for forming an interlayer, which has the compositions shown in the table below, the steps up to the step of carrying out etching of the organic layer using the pattern of the resist layer as a mask were carried out in the same manner as in Example 1. The treatment was stopped at a point where the step of carrying out the etching of the organic layer was completed, the number of particles was counted, and as a result, 74 particles were confirmed.

[Table 1]

| | Composition for forming interlayer | | | | | | Plasmat treatment 1 | | | | Etching 2 | | | | Washing liquid | Washing liquid outlet | Washing time (s) | Residual of interlayer after washing | Number of particles | Water solubility after etching 2 |
|---|---|---|---|---|---|---|---|---|---|---|---|---|---|---|---|---|---|---|---|---|
| | Resin | | Surfactant | | Solvent | | Ar (ml/min) | $N_2$ (ml/min) | $O_2$ (ml/min) | $CF_4$ (ml/min) | Ar (ml/min) | $N_2$ (ml/min) | $O_2$ (ml/min) | $CF_4$ (ml/min) | | | | | | |
| Example 1 | T-1 | 15 | S-1 | 0.1 | Water | 84.9 | 400 | 100 | 0 | 0 | 0 | 25 | 500 | 0 | W-1 | A | 150 | A | 0 | A |
| Example 2 | T-1 | 15 | S-1 | 0.1 | Water | 84.9 | 300 | 200 | 0 | 0 | 0 | 25 | 500 | 0 | W-1 | A | 150 | A | 1 | A |
| Example 3 | T-1 | 15 | S-1 | 0.1 | Water | 84.9 | 250 | 250 | 0 | 0 | 0 | 25 | 500 | 0 | W-1 | A | 150 | A | 3 | A |
| Example 4 | T-1 | 15 | S-1 | 0.1 | Water | 84.9 | 500 | 0 | 0 | 0 | 0 | 25 | 500 | 0 | W-1 | A | 150 | A | 6 | B |
| Example 5 | T-1 | 15 | S-1 | 0.1 | Water | 84.9 | 500 | 0 | 0 | 0 | 800<br>0 | 0<br>25 | 50<br>500 | 200<br>0 | W-1<br>W-1 | A | 150<br>150 | A | 6 | A |
| Example 6 | T-2 | 10 | S-2 | 0.1 | Water | 89.9 | 400 | 100 | 0 | 0 | 0 | 25 | 500 | 0 | W-1 | A | 150 | A | 3 | A |
| Example 7 | T-3 | 7 | S-1 | 0.1 | Water | 92.9 | 400 | 100 | 0 | 0 | 0 | 25 | 500 | 0 | W-1 | A | 150 | A | 1 | A |
| Example 8 | T-1 | 15 | S-1 | 0.1 | Water | 84.9 | 400 | 100 | 0 | 0 | 0 | 25 | 500 | 0 | W-2 | A | 150 | A | 1 | A |
| Example 9 | T-1 | 15 | S-1 | 0.1 | Water | 84.9 | 400 | 100 | 0 | 0 | 0 | 25 | 500 | 0 | W-3 | A | 150 | A | 2 | A |
| Example 10 | T-1 | 15 | S-1 | 0.1 | Water | 84.9 | 400 | 100 | 0 | 0 | 0 | 25 | 500 | 0 | W-4 | A | 150 | A | 3 | A |
| Example 11 | T-1 | 15 | S-1 | 0.1 | Water | 84.9 | 400 | 100 | 0 | 0 | 0 | 25 | 500 | 0 | W-5 | A | 150 | A | 5 | A |
| Example 12 | T-1 | 15 | S-1 | 0.1 | Water | 84.9 | Parylene vapor diposition | | | | 0 | 25 | 500 | 0 | W-1 | A | 150 | A | 2 | A |
| Example 13 | T-1 | 15 | S-1 | 0.1 | Water | 84.9 | 400 | 100 | 0 | 0 | 0 | 25 | 500 | 0 | W-1 | B | 150 | A | 2 | A |
| Example 14 | T-1 | 15 | S-1 | 0.1 | Water | 84.9 | 400 | 100 | 0 | 0 | 0 | 25 | 500 | 0 | W-1 | A | 100 | A | 3 | A |
| Comparative Example 1 | T-4 | 15 | S-1 | 0.1 | Water | 84.9 | 0 | 500 | 0 | 0 | Not carried out | | | | W-1 | A | 150 | B | - | - |
| Comparative Example 2 | T-4 | 15 | S-1 | 0.1 | Water | 84.9 | Not carried out | | | | Not carried out | | | | - | - | - | - | 74 | - |

Details of the abbreviations described in Table 1 are as follows.

[Resin]

- T-1: PXP-05, manufactured by JAPAN VAM & POVAL Co., Ltd.
- T-2: PITZCOL K-90, manufactured by DKS Co., Ltd.
- T-3: 2-hydroxyethyl cellulose
- T-4: Kuraray Poval 5-88, manufactured by KURARAY Co., Ltd.

[Surfactant]

- S-1: Acetyrenol E00 (manufactured by Kawaken Fine Chemicals Co., Ltd.)
- S-2: EMALEX 710 (manufactured by Nippon Emulsion Co., Ltd.)

[Washing liquid]

- W-1: pure water
- W-2: methanol
- W-3: ethanol
- W-4: isopropanol
- W-5: diethylene glycol

[Washing liquid outlet]

- A: spray nozzle
- B: straight nozzle

From the results shown in Table 1, it can be seen that according to the manufacturing method for an organic layer pattern according to the embodiment of the present invention, the generation of particles (the etching residues) is suppressed.

In the manufacturing method for an organic layer pattern described in Comparative Example 1, the water solubility recovery step (the etching 2) has not been carried out. Therefore, it can be seen that the interlayer has remained.

In the manufacturing method for an organic layer pattern described in Comparative Example 2, the laminate has not been washed. Therefore, it can be seen that a large number of particles have been generated.

Explanation of References

1: resist layer
1a: resist layer after exposure and development
2: interlayer
2a: insolubilized surface of interlayer
3: organic layer
4: base material
5: removal part of resist layer after development
5a: removal part of laminate after etching
6: etching residue
7: second organic layer
11: third organic layer

## Claims

1. A manufacturing method for an organic layer pattern, comprising:

    a step of forming an interlayer that dissolves in water or a water-soluble solvent and a resist layer in this order on an organic layer to obtain a laminate;
    a step of producing a pattern of the resist layer;
    a step of carrying out etching of the organic layer using the pattern of the resist layer as a mask;
    a step of carrying out insolubilization of a surface of the interlayer with respect to water or a water-soluble solvent, after the etching; and
    a step of carrying out washing of the laminate after the step of carrying out the insolubilization, with water or a water-soluble solvent.

2. The manufacturing method for an organic layer pattern according to claim 1, further comprising:
a step of removing the surface of the interlayer, which is insolubilized in the step of carrying out the insolubilization.

3. The manufacturing method for an organic layer pattern according to claim 2,
wherein the step of removing the surface of the interlayer is a step of carrying out dry etching with an etching gas having an oxygen partial pressure of 50% to 100% with respect to a total pressure.

4. The manufacturing method for an organic layer pattern according to any one of claims 1 to 3,
wherein the interlayer contains polyvinyl alcohol.

5. The manufacturing method for an organic layer pattern according to any one of claims 1 to 4,
wherein the step of carrying out the insolubilization is a step of subjecting the surface of the interlayer to a plasma treatment.

6. The manufacturing method for an organic layer pattern according to claim 5,
wherein the plasma treatment is carried out with a gas containing Ar.

7. The manufacturing method for an organic layer pattern according to claim 6,
wherein the plasma treatment is carried out with a gas containing Ar and $N_2$.

8. The manufacturing method for an organic layer pattern according to claim 7,
wherein a partial pressure of $N_2$ in the gas containing Ar and $N_2$ is 10% to 50% with respect to a total pressure of the gas.

9. The manufacturing method for an organic layer pattern according to claim 8, further comprising:
a step of removing the interlayer.

10. The manufacturing method for an organic layer pattern according to any one of claims 1 to 9, further comprising:

    a step of further forming a second organic layer, after the step of carrying out the washing;
    a step of forming a second interlayer that dissolves in water or a water-soluble solvent and a second resist layer in this order on the second organic layer to obtain a laminate;
    a step of forming a second pattern of the second resist layer;
    a step of carrying out etching of the second organic layer using the second pattern as a mask;
    a step of carrying out insolubilization of a surface of the second interlayer with respect to water or a water-soluble solvent, after the etching; and
    a step of washing the laminate after the insolubilization, with water or a water-soluble solvent.

11. A manufacturing method for a semiconductor device, comprising:
the manufacturing method for an organic layer pattern according to any one of claims 1 to 10.

FIG. 1A

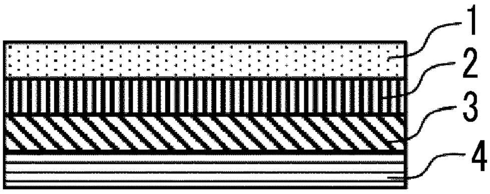


FIG. 1D

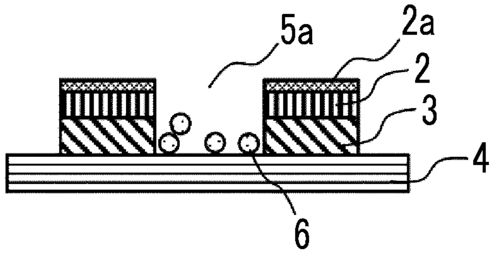


FIG. 1B

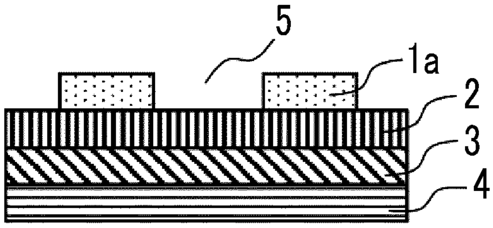


FIG. 1E

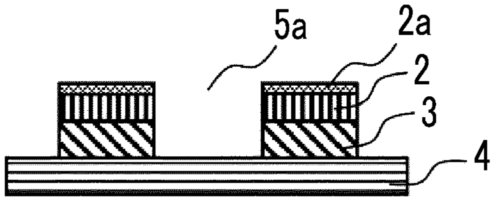


FIG. 1C

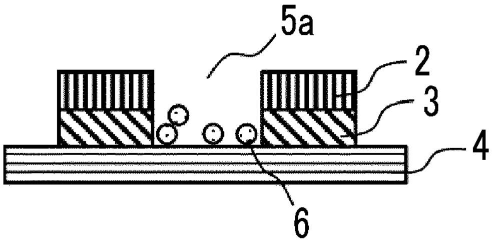


FIG. 1F

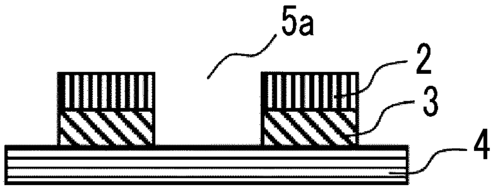


FIG. 2

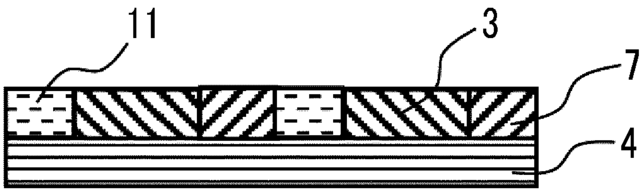

## INTERNATIONAL SEARCH REPORT

International application No.
**PCT/JP2021/032133**

**A. CLASSIFICATION OF SUBJECT MATTER**

***H01L 21/3065***(2006.01)i; ***G03F 7/11***(2006.01)i; ***G03F 7/40***(2006.01)i; ***H01L 21/304***(2006.01)i; ***H01L 51/48***(2006.01)i; ***H01L 51/50***(2006.01)i; ***H05B 33/10***(2006.01)i
FI: H01L21/302 104H; G03F7/11 503; G03F7/40 521; H01L21/302 105A; H01L21/304 647A; H01L21/304 647Z; H01L31/04 188; H05B33/10; H05B33/14 A

According to International Patent Classification (IPC) or to both national classification and IPC

**B. FIELDS SEARCHED**

Minimum documentation searched (classification system followed by classification symbols)

H01L21/3065; G03F7/11; G03F7/40; H01L21/304; H01L51/48; H01L51/50; H05B33/10

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2018/203478 A1 (TOKYO ELECTRON LTD.) 08 November 2018 (2018-11-08) | 1-11 |
| A | JP 2000-58506 A (MITSUBISHI ELECTRIC CORP.) 25 February 2000 (2000-02-25) | 1-11 |
| A | JP 2017-510951 A (IMEC VZW) 13 April 2017 (2017-04-13) | 1-11 |
| A | JP 2016-35562 A (MITSUBISHI CHEMICALS CORP.) 17 March 2016 (2016-03-17) | 1-11 |

☐ Further documents are listed in the continuation of Box C.   ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **09 November 2021** | **16 November 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2021/032133**

| Patent document cited in search report | Publication date (day/month/year) | Patent family member(s) | Publication date (day/month/year) |
|---|---|---|---|
| WO 2018/203478 A1 | 08 November 2018 | CN 110574495 A | |
| | | KR 10-2020-0002948 A | |
| | | TW 201904103 A | |
| JP 2000-58506 A | 25 February 2000 | US 6566040 B1 | |
| | | DE 19915899 A1 | |
| | | TW 414963 B | |
| | | KR 10-2000-0016843 A | |
| | | CN 1244723 A | |
| JP 2017-510951 A | 13 April 2017 | WO 2015/144930 A1 | |
| | | TW 201537639 A | |
| | | CN 106133935 A | |
| | | KR 10-2016-0138966 A | |
| JP 2016-35562 A | 17 March 2016 | WO 2016/017782 A1 | |
| | | KR 10-2017-0040207 A | |
| | | CN 106662694 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2015144930 A
- JP 6179930 B
- WO 2016175220 A
- JP 2006023696 A
- JP 2006047592 A
- JP 2008197480 A
- JP 2012159830 A
- JP 5191567 B
- JP 2011209692 A
- JP 2004264623 A
- JP 2013011678 A
- JP 2015194674 A
- JP 62036663 A
- JP 61226746 A
- JP 61226745 A
- JP S61226745 A
- JP 62170950 A
- JP 63034540 A
- JP 7230165 A
- JP H07230165 A
- JP 8062834 A
- JP H08062834 A
- JP 9054432 A
- JP H09054432 A
- JP 9005988 A
- JP H09005988 A
- JP 2001330953 A
- JP 2014098889 A
- JP 59126506 A
- JP S59126506 A
- JP 59046628 A
- JP S59046628 A
- JP 58009108 A
- JP S58009108 A
- JP 58002809 A
- JP S58002809 A
- JP 57148706 A
- JP S57148706 A
- JP 61041102 A
- JP S61041102 A


### Non-patent literature cited in the description


- *Journal of the Adhesion Society of Japan,* 1993, vol. 29 (6), 249-259